# EUROPÄISCHE PATENTSCHRIFT

(11) **EP 2 007 781 B1**
(45) Veröffentlichungstag und Bekanntmachung des Hinweises auf die Patenterteilung: **12.09.2012**
(21) Anmeldenummer: 07727733.3
(22) Anmeldetag: 03.04.2007
(51) Int. Cl.: C09K 11/00, H05B 33/00, C09K 11/06, C07F 15/00, H05B 33/14, H01L 51/00

(54) **ÜBERGANGSMETALLKOMPLEXE, ENTHALTEND EINEN NICHT-CARBEN- UND EIN ODER ZWEI CARBENLIGANDEN UND DEREN VERWENDUNG IN OLEDS**
TRANSITION METAL COMPLEXES COMPRISING ONE NONCARBENE LIGAND AND ONE OR TWO CARBENE LIGANDS AND THEIR USE IN OLEDS
COMPLEXES DE METAUX DE TRANSITION CONTENANT UN LIGAND NON CARBENE ET UN OU DEUX LIGANDS CARBENE ET LEUR UTILISATION DANS DES OLED

(30) Priorität: 04.04.2006 EP 06112198
(43) Veröffentlichungstag der Anmeldung: 31.12.2008
(73) Patentinhaber: BASF SE, 67056 Ludwigshafen (DE)
(72) Erfinder: MOLT, Oliver, 69493 Hirschberg (DE); FUCHS, Evelyn, 68199 Mannheim (DE); LENNARTZ, Christian, 67105 Schifferstadt (DE); KAHLE, Klaus, 67069 Ludwigshafen (DE); LANGER, Nicolle, 68163 Mannheim (DE); SCHILDKNECHT, Christian, 67125 Dannstadt-schauernheim (DE); RUDOLPH, Jens, 67547 Worms (DE)
(86) Internationale Anmeldenummer: PCT/EP2007/053262
(87) Internationale Veröffentlichungsnummer: WO 2007/115981

(56) Entgegenhaltungen:
- WO-A-2006/018292

## Beschreibung

Die vorliegende Erfindung betrifft heteroleptische Carbenkomplexe enthaltend sowohl Carbenliganden als auch heterocyclische Nicht-Carbenliganden, ein Verfahren zur Herstellung der heteroleptischen Carbenkomplexe, die Verwendung der heteroleptischen Carbenkomplexe in organischen Leuchtdioden, organische Leuchtdioden enthaltend mindestens einen erfindungsgemäßen heteroleptischen Carbenkomplex, eine Licht-emittierende Schicht, enthaltend mindestens einen erfindungsgemäßen heteroleptischen Carbenkomplex, organische Leuchtdioden, enthaltend mindestens eine erfindungsgemäße Licht-emittierende Schicht sowie Vorrichtungen, die mindestens eine erfindungsgemäße organische Leuchtdiode enthalten.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigen Stromverbrauchs eignen sich die Vorrichtungen enthaltend OLEDs insbesondere für mobile Anwendungen, zum Beispiel für Anwendungen in Handys, Laptops usw.

Die Grundprinzipien der Funktionsweise von OLEDs sowie geeignete Aufbauten (Schichten) von OLEDs sind zum Beispiel in WO 2005/113704 und der darin zitierten Literatur genannt.

Im Stand der Technik wurden bereits zahlreiche Materialien vorgeschlagen, die bei der Anregung durch elektrischen Strom Licht emittieren.

In WO 2005/019373 ist erstmals die Verwendung von neutralen Übergangsmetallkomplexen, die mindestens einen Carbenliganden enthalten, in OLEDs offenbart. Diese Übergangsmetallkomplexe können gemäß WO 2005/019373 in jeder Schicht eines OLEDs eingesetzt werden, wobei das Ligandgerüst oder Zentralmetall zur Anpassung an gewünschte Eigenschaften der Übergangsmetallkomplexe variiert werden kann. Beispielsweise ist der Einsatz der Übergangsmetallkomplexe in einer Blockschicht für Elektronen, einer Blockschicht für Excitonen, einer Blockschicht für Löcher oder der Licht-emittierenden Schicht des OLEDs möglich, wobei die Übergangsmetallkomplexe bevorzugt als Emittermoleküle in OLEDs eingesetzt werden.

WO 2005/113704 betrifft lumineszierende Verbindungen, die Carbenliganden tragen. Gemäß WO 2005/113704 sind zahlreiche Übergangsmetallkomplexe mit verschiedenen Carbenliganden genannt, wobei die Übergangsmetallkomplexe bevorzugt als phosphoreszierendes Licht-emittierendes Material, besonders bevorzugt als Dotiersubstanz, eingesetzt werden.

Das Dokument WO 2006/018292 offenbart (die Verweise in Klammern beziehen sich auf dieses Dokument) bereits heteroleptische Carbenkomplexe der Formel M¹[carben]ₙ [het]ₘ in denen "carben" die allgemeine Formel (II) erfüllt. In dieser Formel kann Y³ gleich oder verschieden sein und die Bedeutungen annehmen, wie sie auch in der vorliegenden Anmeldung in Anspruch 1 definiert sind (Seite 19 letzter Absatz bis Seite 20, Zeile 9). [het] entspricht dem Liganden K der D1 (Anspruch 1, Seite 3, Zeile 16, Seite 5, Zeilen 25-26). Unterschied ist nur, daß K anmeldungsgemäss eine bestimmte Bedeutung, nämlich diejenige der Formel (III) annehmen muss.

Obwohl bereits Verbindungen bekannt sind, die zum Einsatz in OLEDs, insbesondere als Licht-emittierende Substanzen, geeignet sind, ist die Bereitstellung von effizienteren Verbindungen, die technisch einsetzbar sind, wünschenswert. Im Sinne der vorliegenden Anmeldung ist unter Elektrolumineszenz sowohl Elektrofluoreszenz als auch Elektrophosphoreszenz zu verstehen.

Aufgabe der vorliegenden Anmeldung ist daher die Bereitstellung von neuartigen Carbenkomplexen, die zum Einsatz in OLEDs geeignet sind. Insbesondere ist die Bereitstellung von Übergangsmetallkomplexen wünschenswert, die ein gegenüber bekannten Übergangsmetallkomplexen verbessertes Eigenschaftsspektrum zeigen, z.B. verbesserte Effizienzen und/oder eine verbesserte Lebensdauer.

Diese Aufgabe wird durch die Bereitstellung von heteroleptischen Carbenkomplexen der allgemeinen Formel (1) gelöst

M¹[carben]ₙ[het]ₘ (I)

enthaltend sowohl Carbenliganden als auch heterocyclische Nicht-Carbenliganden,
worin die Symbole die folgenden Bedeutungen aufweisen:
- M¹: Metallatom ausgewählt aus der Gruppe bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, ganz besonders bevorzugt Ir, in jeder für das entsprechende Metallatom möglichen Oxidationsstufe;
- n: Zahl der Carbenliganden, wobei n in dem Fall, dass die Summe (n + m) = 2 ist, 1 bedeutet, und in dem Fall, dass die Summe (n + m) ≥ 3 ist, mindestens 2 bedeutet, wobei die Carbenliganden in dem Fall, wenn n mindestens 2 bedeutet, gleich oder verschieden sein können;
- m: Zahl der heterocyclischen Nicht-Carbenliganden, wobei m ≥ 1 ist, wobei die heterocyclischen Nicht-Carbenliganden in dem Fall, wenn m > 1 ist, gleich oder verschieden sein können;
wobei n und m von der Oxidationsstufe und Koordinationszahl des eingesetzten Metallatoms und von der Ladung der Liganden carben und het abhängig sind;
carben Carbenligand der allgemeinen Formel (II) 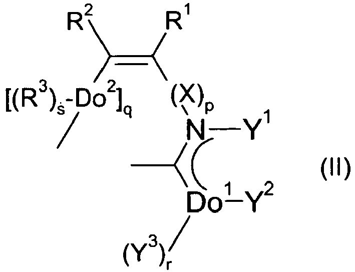 wobei die Symbole in dem Carbenliganden der allgemeinen Formel II die folgenden Bedeutungen aufweisen:
- Do¹: Donoratom ausgewählt aus der Gruppe bestehend aus C, P, N, O, S und Si, bevorzugt P, N, O und S;
- Do²: Donoratom ausgewählt aus der Gruppe bestehend aus C, N, P, O und S;
- r: 2, wenn Do¹ C oder Si ist, 1, wenn Do¹ N oder P ist und 0, wenn Do¹ O oder S ist;
- s: 2, wenn Do² C ist, 1, wenn Do² N oder P ist und 0, wenn Do² O oder S ist;
- X: Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
- w: 2 bis 10;
- R¹³, R¹⁴ , R¹⁵, R¹⁶, R¹⁷: H, Alkyl, Aryl, Heteroaryl, Alkenyl, Alkinyl;
- p: 0 oder 1;
- q: 0 oder 1;
- Y¹, Y²: jeweils unabhängig voneinander Wasserstoff oder eine kohlenstoffhaltige Gruppe ausgewählt aus der Gruppe bestehend aus Alkyl-, Aryl-, Heteroaryl-, Alkinyl - und Alkenylgruppen; oder
- Y¹ und Y²: bilden gemeinsam eine Brücke zwischen dem Donoratom Do¹ und dem Stickstoffatom N die mindestens zwei Atome aufweist, wovon mindestens eines ein Kohlenstoffatom ist,
- R¹, R²: unabhängig voneinander Wasserstoff, Alkyl-, Aryl-, Heteroaryl-, Alkinyl- oder Alkenylreste,
oder
R¹ und R² bilden gemeinsam eine Brücke mit insgesamt drei bis fünf Atomen, wovon 1 bis 5 Atome Heteroatome sein können und die restlichen Atome Kohlenstoffatome sind, so dass die Gruppe 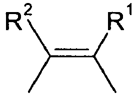 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann, und der fünf- bis siebengliedrige Ring gegebenenfalls mit einem oder mehreren weiteren Ringen anelliert sein kann;
weiterhin können Y¹ und R¹ über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰), O, S, SO, SO₂, SiR³⁰R³¹, CO, CO-O, O-CO ersetzt sein können, wobei
   - x: 2 bis 10;
   und R¹⁸, R¹⁹, R²⁰, R²¹, R²², R³⁰, R³¹
   H, Alkyl, Aryl, Heteroaryl, Alkenyl, Alkinyl
   bedeuten;
   - R³: Wasserstoff, ein Alkyl-, Aryl-, Heteroaryl-, Alkinyl- oder Alkenylrest;
   - Y³: Wasserstoff, ein Alkyl-, Alkinyl- oder Alkenylrest,
   oder 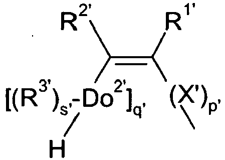 wobei Do^{2'}, q^{'}, s^{'}, R^{3'}, R^{1'}, R^{2'}, X^{'} und p^{'} unabhängig die gleichen Bedeutungen wie Do², q, s, R³, R¹, R², X und p aufweisen;
weiterhin können Y³ und Y² in jedem der n Carbenliganden über eine Brücke miteinander verknüpft sein, wobei die Brücke die folgenden Bedeutungen aufweisen kann:
Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
   - y: 2 bis 10;
   und
   - R²⁵, R²⁶, R²⁷, R²⁸, R²⁹, R³², R³³: H, Alkyl, Aryl, Heteroaryl, Alkenyl, Alkinyl bedeuten;
   und
   - het: heterocyclischer Nicht-Carbenligand der allgemeinen Formel (III) 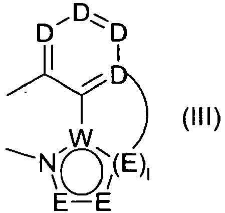 worin die Symbole in dem Liganden het der allgemeinen Formel III die folgenden Bedeutungen aufweisen:
   D unabhängig voneinander CR³⁴ oder N;
   W C, N, P;
   E unabhängig voneinander CR³⁵, N, NR³⁶, S, O, P oder PR³⁷;
   I 1 oder 2;
   R³⁴, R³⁵, R³⁶, R³⁷ unabhängig voneinander H, ein Alkyl-, Aryl-, Heteroaryl-, Alkinyl- oder Alkenylrest, oder jeweils 2 Reste R³⁴, R³⁵, R³⁶ oder R³⁷ bilden gemeinsam einen anellierten Ring, der gegebenenfalls mindestens ein Heteroatom enthalten kann, oder R³⁴, R³⁵, R³⁶ oder R³⁷ bedeutet einen Rest mit Donor - oder Akzeptorwirkung;
wobei die gestrichelte Linie eine optionale Verbrückung zwischen einer der Gruppen D und einer der Gruppen E bedeutet; wobei die Verbrückung die folgenden Bedeutungen aufweisen kann:
Alkylen, Arylen, Heteroarylen, Alkinylen, Alkenylen, NR³⁸, PR³⁹, BR⁴⁰, O, S, SO, SO₂, SiR⁴¹R⁴², CO, CO-O, O-CO und (CR⁴³R⁴⁴)ᵥ, wobei eine oder mehrere nicht benachbarte Gruppen (CR⁴³R⁴⁴) durch NR³⁸, PR³⁹, BR⁴⁰, O, S, SO, SO₂, SiR⁴¹R⁴², CO, CO-O, O-CO ersetzt sein können, wobei
   - v: 2 bis 10;
   und
   - R³⁸, R³⁹, R⁴⁰, R⁴¹, R⁴², R⁴³, R⁴⁴: H, Alkyl, Aryl, Heteroaryl, Alkenyl, Alkinyl
bedeuten.

Die erfindungsgemäßen heteroleptischen Carbenkomplexe der Formel I zeichnen sich somit dadurch aus, dass sie mindestens einen Carbenliganden der allgemeinen Formel II und mindestens einen heterocyclischen Nicht-Carbenliganden der allgemeinen Formel III aufweisen. In Abhängigkeit von der Oxidationsstufe und Koordinationszahl des eingesetzten Metallatoms M¹ sowie von der Ladung der Liganden können neben dem mindestens einen Carbenliganden der allgemeinen Formel II und dem mindestens einen heterocyclischen Nicht-Carbenliganden der allgemeinen Formel III in dem erfindungsgemäßen heteroleptischen Carbenkomplex weitere Carbenliganden der allgemeinen Formel II vorliegen, wobei die Substitutionsmuster der einzelnen Carbenliganden der allgemeinen Formel II gleich oder unterschiedlich sein können. In dem Fall, wenn M¹ ein Metall mit einer Koordinationszahl von 4 ist (z.B. Pt(II) oder Pd(II), Ir(I), Rh(I)), weisen die erfindungsgemäßen heteroleptischen Carbenkomplexe einen Carbenliganden der allgemeinen Formel II und einen heterocyclischen Nicht-Carbenliganden der allgemeinen Formel III auf. In dem Fall, wenn M¹ ein Metall mit einer Koordinationszahl von 6 ist (z.B. Ir(III), Co(II), Co(III), Rh(III), Os(II), Pt(IV)), weisen die erfindungsgemäßen heteroleptischen Carbenkomplexe zwei Carbenliganden der allgemeinen Formel II, die gleich oder verschieden sein können, und einen heterocyclischen Nicht-Carbenliganden der allgemeinen Formel III auf. Weist das Metallatom M¹ eine Koordinationszahl von 8 oder mehr auf, können die heteroleptischen Carbenkomplexe der allgemeinen Formel I neben zwei Carbenliganden der allgemeinen Formel II und einem heterocyclischen Nicht-Carbenliganden der allgemeinen Formel III entweder einen oder mehrere weitere Carbenliganden der allgemeinen Formel II und/oder einen oder mehrere heterocyclische Nicht-Carbenliganden der allgemeinen Formel III aufweisen. In einer bevorzugten Ausführungsform betrifft die vorliegende Erfindung heteroleptische Carbenkomplexe der allgemeinen Formel I, die ein Metall M¹ mit einer Koordinationszahl von 6, zwei Carbenliganden der allgemeinen Formel II und einen heterocyclischen Nicht-Carbenliganden der allgemeinen Formel III aufweisen.

Es wurde gefunden, dass sich die erfindungsgemäßen heteroleptischen Carbenkomplexe, die mindestens einen Carbenliganden der allgemeinen Formel II und mindestens einen heterocyclischen Nicht-Carbenliganden enthalten, insbesondere die erfindungsgemäßen heteroleptischen Carbenkomplexe, die mehrere Carbenliganden der allgemeinen Formel II aufweisen, bei ihrem Einsatz in organischen Leuchtdioden (OLED) dadurch auszeichnen, dass sie überraschend hohe Quantenausbeuten zeigen. Mit Hilfe der speziellen Ligandkombination der erfindungsgemäßen heteroleptischen Carbenkomplexe kann des Weiteren eine Rotverschiebung in der Emission gegenüber reinen Carbenkomplexen erzielt werden. Somit können die erfindungsgemäßen heteroleptischen Carbenkomplexe in OLEDs für eine gezielte Farbeinstellung bei hoher Quantenausbeute eingesetzt werden.

In Abhängigkeit von der Koordinationszahl des eingesetzten Metalls M¹ und der Zahl der eingesetzten Carbenliganden und Nicht-Carbenliganden können verschiedene Isomere der entsprechenden Metallkomplexe bei gleichem Metall M¹ und gleicher Natur der eingesetzten Carbenliganden und Nicht-Carbenliganden vorliegen. Zum Beispiel sind bei Komplexen mit einem Metall M¹ mit der Koordinationszahl 6 (also oktaedrischen Komplexen), zum Beispiel Ir(III)-Komplexen, "fac-mer-Isomere" (facial/meridional-Isomere) möglich, wenn es sich um Komplexe der allgemeinen Zusammensetzung M(AB)₂(CD), wobei AB und CD bidentate Liganden sind, handelt. Dabei sind im Sinne der vorliegenden Anmeldung unter "fac-mer-Isomeren" die im Folgenden dargestellten Isomere zu verstehen:

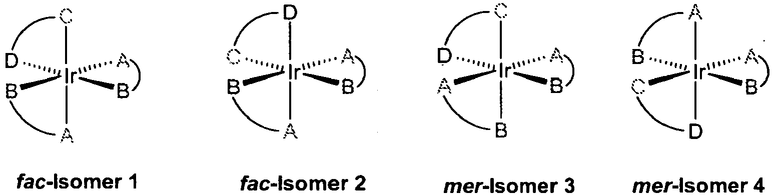

Bei quadratisch planaren Komplexen mit einem Metall M¹ mit der Koordinationszahl 4, zum Beispiel Pt(II)-Komplexen, sind "Isomere" möglich, wenn es sich um Komplexe der allgemeinen Zusammmensetzung M(AB)(CD), wobei AB und CD bidentate Liganden sind, handelt. Dabei sind im Sinne der vorliegenden Anmeldung unter "Isomeren" die im Folgenden dargestellten Isomere zu verstehen:

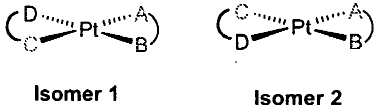

Bei den Symbolen A und B sowie C und D handelt es sich jeweils um eine Bindungsstelle eines Liganden, wobei nur bidentate Liganden vorliegen. Ein bidentater Ligand weist gemäß der vorstehend erwähnten allgemeinen Zusammensetzung eine Gruppe A und eine Gruppe B bzw. eine Gruppe C und eine Gruppe D auf.

Dem Fachmann ist grundsätzlich bekannt, was unter cis/trans- bzw. fac-mer-Isomeren zu verstehen ist. Bei Komplexen der Zusammensetzung MA₃B₃ können drei Gruppen der gleichen Art entweder die Ecken einer Oktaederfläche besetzen (faciales Isomer) oder einen Meridian, das heißt zwei der drei Ligandenbindungsstellen sind zueinander trans-ständig (meridionales Isomer). Bezüglich der Definition von cis/trans-Isomeren bzw. fac-mer-Isomeren in oktaedrischen Metallkomplexen siehe zum Beispiel J. Huheey, E. Keiter, R. Keiter, Anorganische Chemie: Prinzipien von Struktur und Reaktivität, 2., neu bearbeitete Auflage, übersetzt und erweitert von Ralf Steudel, Berlin; New York: de Gruyter, 1995, Seiten 575, 576.

Bei quadratisch planaren Komplexen bedeutet cis-Isomerie, dass bei Komplexen der Zusammensetzung MA₂B₂ sowohl die beiden Gruppen A als auch die beiden Gruppen B benachbarte Ecken eines Quadrats belegen, während sowohl die beiden Gruppen A als auch die beiden Gruppen B bei der trans-Isomerie jeweils die beiden einander diagonal gegenüber liegenden Ecken eines Quadrats belegen. Bezüglich der Definition von cis/trans-Isomeren in quadratisch planaren Metallkomplexen siehe zum Beispiel J. Huheey, E. Keiter, R, Keiter, Anorganische Chemie: Prinzipien von Struktur und Reaktivität, 2., neu bearbeitete Auflage, übersetzt und erweitert von Ralf Stendel, Berlin; New York: de Gruyter, 1995, Seiten 557 bis 559.

Im Allgemeinen können die verschiedenen Isomere der Metallkomplexe der Formel I nach dem Fachmann bekannten Verfahren, zum Beispiel durch Chromatographie, Sublimation oder Kristallisation, getrennt werden.

Die vorliegende Erfindung betrifft somit sowohl jeweils die einzelnen Isomere der Carbenkomplexe der Formel I als auch Gemische verschiedener Isomere in jedem beliebigen Mischungsverhältnis.

Besonders bevorzugt weisen die erfindungsgemäßen heteroleptischen Carbenkomplexe der allgemeinen Formel I ein Metallatom M¹ ausgewählt aus der Gruppe bestehend aus Ir, Os, Rh und Pt auf, wobei Os(II), Rh(III), Ir(III) und Pt(II) ganz besonders bevorzugt sind. Insbesondere ganz besonders bevorzugt ist Ir(III).

Die Zahl n der Carbenliganden der allgemeinen Formel II beträgt in den erfindungsgemäßen heteroleptischen Carbenkomplexen der Formel I, worin das Übergangsmetallatom M¹ eine Koordinationszahl von 6 aufweist, wobei Ir(III) besonders bevorzugt ist, 2 und die Zahl m der heterocyclischen Nicht-Carbenliganden der allgemeinen Formel III beträgt in diesen Komplexen 1.

Die Zahl n der Carbenliganden der allgemeinen Formel II beträgt in Übergangsmetallkomplexen, worin das Übergangsmetallatom M¹ eine Koordinationszahl von 4 aufweist, wobei Pt(II) besonders bevorzugt ist, 1 und die Zahl m der heterocyclischen Nicht-Carbenliganden der allgemeinen Formel III beträgt in diesen Komplexen ebenfalls 1.

Für die Gruppen Y¹ und Y² gilt im Sinne der vorliegenden Anmeldung:
die Substituenten der Gruppen Y¹ und Y² können gemeinsam eine Brücke mit insgesamt zwei bis vier, bevorzugt zwei bis drei Atomen, bilden, wovon ein oder zwei Atome Heteroatome, bevorzugt N, sein können und die restlichen Atome Kohlenstoffatome sind, so dass die Gruppierung NCDo¹ gemeinsam mit dieser Brücke einen fünf- bis siebengliedrigen, bevorzugt fünf- bis sechsgliedrigen Ring bilden, der gegebenenfalls zwei - oder im Falle eines sechs- oder siebengliedrigen Rings ― drei Doppelbindungen aufweisen kann und gegebenenfalls mit Alkyl- oder Arylgruppen und/oder Gruppen mit Donor- oder Akzeptorwirkung substituiert sein kann und gegebenenfalls Heteroatome, bevorzugt N, enthalten kann, wobei ein fünfgliedriger oder sechsgliedriger aromatischer Ring, der mit Alkyl- oder Arylgruppen und/oder Gruppen mit Donor- oder Akzeptorwirkung substituiert oder unsubstituiert ist, bevorzugt ist, oder der bevorzugte fünfgliedrige oder sechsgliedrige aromatische Ring ist mit weiteren Ringen, die gegebenenfalls mindestens ein Heteroatom, bevorzugt N, enthalten können, bevorzugt sechsgliedrigen aromatischen Ringen, anelliert.

Die Gruppe Y¹ kann mit dem Rest R¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
   - x: 2 bis 10;
   und
   - R¹⁸, R¹⁹, R²⁰, R²¹, R²², R³⁰, R³¹: H, Alkyl, Aryl, Heteroaryl, Alkenyl, Alkinyl
bedeuten.

In dem Fall, dass Y¹ und Y² gemeinsam eine Brücke bilden, wobei ein fünf- bis siebengliedriger Ring gebildet wird, kann die verknüpfende Brücke zu dem Rest R¹ direkt mit dem fünf- bis siebengliedrigen Ring verknüpft sein oder an einen Substituenten dieses Rings geknüpft sein, wobei eine direkte Verknüpfung mit dem fünf- bis siebengliedrigen Ring bevorzugt ist. Besonders bevorzugt ist das dem N-Atom (in der allgemeinen Formel II) des fünf- bis siebengliedrigen Rings direkt benachbarte Atom über eine Brücke mit R¹ verknüpft, wenn eine solche Verknüpfung vorliegt (siehe z.B. die nachstehend genannten verbrückten Strukturen). In dem Fall, dass der durch eine gemeinsame Brücke von Y¹ und Y² gebildete fünf- bis siebengliedrige Ring mit einem weiteren fünf- bis siebengliedrigen Ring anelliert ist, kann die verknüpfende Brücke mit einem Atom des anellierten Rings verknüpft sein (siehe z.B. die nachstehend genannten verbrückten Strukturen).

Im Folgenden sind bevorzugte verbrückte Strukturen beispielhaft für die Carbenliganden der allgemeinen Formel II genannt. Die in den dargestellten Ligandsystemen dargestellten Gruppen können z.B. Substituenten tragen oder eine oder mehrere CH-Gruppen in den gezeigten aromatischen Gruppen können durch Heteroatome ersetzt sein. Es ist ebenfalls möglich, dass die Carbenliganden mehrere gleiche oder verschiedene Brücken aufweisen. Die dargestellten Brücken können auch in anderen erfindungsgemäß eingesetzten Ligandsystemen, z.B. in den nachstehend erwähnten Ligandsystemen der Formeln aa bis ae, vorkommen.

Beispiele für Carbenliganden mit verbrückten Strukturen:

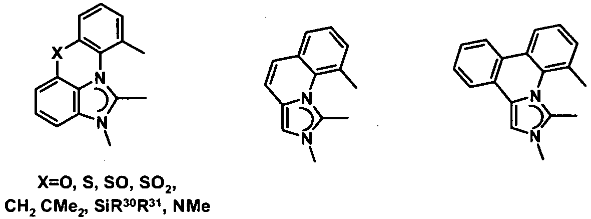

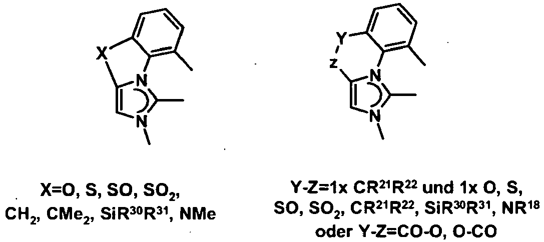

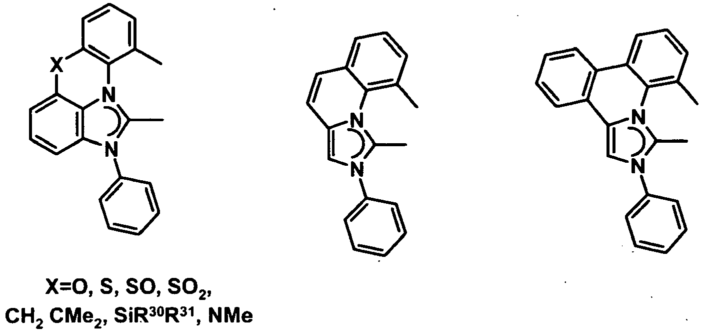

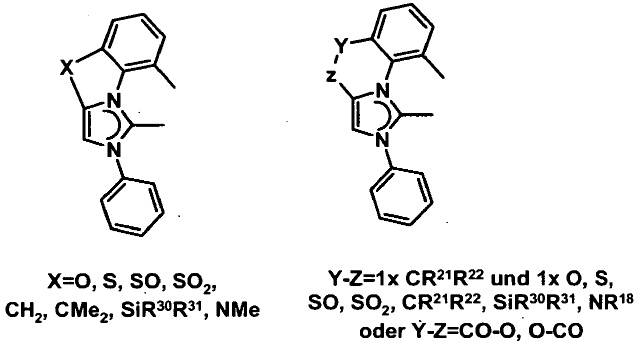

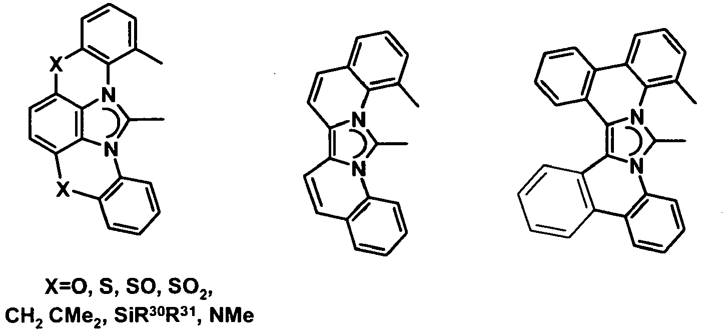

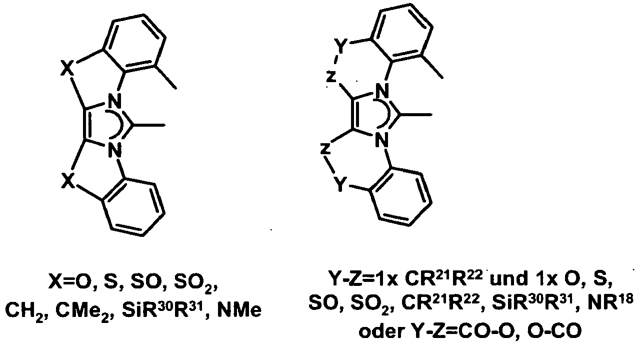

Die Reste R¹⁸, R²¹, R²², R³⁰ und R³¹ wurden bereits vorstehend definiert.

Im Sinne der vorliegenden Anmeldung haben die Begriffe Arylrest oder -gruppe, Heteroarylrest oder -gruppe, Alkylrest oder -gruppe und Alkenylrest oder -gruppe und Alkinylrest oder ―gruppe die folgenden Bedeutungen:
Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Alkylreste, bevorzugt Alkylreste mit 1 bis 8 Kohlenstoffatomen, besonders bevorzugt Methyl, Ethyl oder i-Propyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Geeignete Gruppen, mit Donor- oder Akzeptorwirkung sind nachstehend genannt. Ganz besonders bevorzugt tragen die Arylreste Substituenten ausgewählt aus der Gruppe bestehend aus Methyl, F, Cl, CN, Aryloxy und Alkoxy, Sulfonyl, Heteroaryl. Bevorzugt ist der Arylrest oder die Arylgruppe ein C₆-C₁₈-Arylrest, besonders bevorzugt ein C₆-Arylrest, der gegebenenfalls mit mindestens einem der vorstehend genannten Substituenten substituiert ist. Besonders bevorzugt weist der C₆-C₁₈-Arylrest, bevorzugt C₆-Arylrest, einen oder zwei der vorstehend genannten Substituenten auf, wobei im Falle eines C₆-Arylrests der eine Substituent in ortho-, meta- oder para-Position zur weiteren Verknüpfungsstelle des Arylrestes angeordnet ist, und - im Falle von zwei Substituenten - können diese jeweils in meta-Position oder ortho-Position zur weiteren Verknüpfungsstelle des Arylrestes angeordnet sein oder ein Rest ist in ortho-Position und ein Rest in meta-Position angeordnet oder ein Rest ist in ortho- oder meta-Position angeordnet und der weitere Rest ist in para-Position angeordnet.

Unter einem Heteroarylrest oder einer Heteroarylgruppe sind Reste zu verstehen, die sich von den vorstehend genannten Arylresten dadurch unterscheiden, dass in dem Grundgerüst der Arylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Arylreste durch Heteroatome ersetzt. Insbesondere bevorzugt ist das Grundgerüst ausgewählt aus Systemen wie Pyridin und fünfgliedrigen Heteroaromaten wie Pyrrol, Furan, Pyrazol, Imidazol, Thiophen, Oxazol, Thiazol. Das Grundgerüst kann an einer, mehreren oder allen substituierbaren Positionen des Grundgerüsts substituiert sein. Geeignete Substituenten sind dieselben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8 Kohlenstoffatomen zu verstehen. Dieser Alkylrest kann verzweigt oder unverzweigt sein und gegebenenfalls mit einem oder mehreren Heteroatomen, bevorzugt Si, N, O oder S, besonders bevorzugt N, O oder S, unterbrochen sein. Des Weiteren kann dieser Alkylrest mit einem oder mehreren der bezüglich der Arylgruppen genannten Substituenten substituiert sein. Es ist ebenfalls möglich, dass der Alkylrest eine oder mehrere (Hetero-)-Arylgruppen trägt. Dabei sind alle der vorstehend aufgeführten (Hetero-)Arylgruppen geeignet. Besonders bevorzugt sind die Alkylreste ausgewählt aus der Gruppe bestehend aus Methyl, Ethyl, iso-Propyl, n-Propyl, n-Butyl, iso-Butyl und tert-Butyl, ganz besonders bevorzugt sind Methyl und iso-Propyl.

Unter einem Alkenylrest oder einer Alkenylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Doppelbindung ersetzt ist. Bevorzugt weist der Alkenylrest eine oder zwei Doppelbindungen auf.

Unter einem Alkinylrest oder einer Alkinylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Dreifachbindung ersetzt ist. Bevorzugt weist der Alkinylrest eine oder zwei Dreifachbindungen auf.

Die Begriffe Alkylen, Arylen, Heteroarylen, Alkinylen und Alkenylen haben im Sinne der vorliegenden Anmeldung die bezüglich der Alkyl-, Aryl-, Heteroaryl-, Alkinyl- und Alkenylreste genannten Bedeutungen mit dem Unterschied, dass die Alkylen-, Arylen-, Heteroarylen-, Alkinylen- und Alkenylengruppen zwei Bindungsstellen zu Atomen des Liganden der Formel II aufweisen.

Unter einer aus Y¹ und Y² gebildeten Brücke, die mindestens zwei Atome aufweist, wovon mindestens eines ein Kohlenstoffatom ist und die weiteren Atome bevorzugt Stickstoff- oder Kohlenstoffatome sind, wobei die Brücke gesättigt oder bevorzugt ungesättigt sein kann und die mindestens zwei Atome der Brücke substituiert oder unsubstituiert sein können, sind bevorzugt die folgenden Gruppen zu verstehen:
- Eine Brücke, die zwei Kohlenstoffatome oder ein Kohlenstoffatom und ein Stickstoffatom aufweist, wobei die Kohlenstoffatome bzw. ein Kohlenstoffatom und ein Stickstoffatom durch eine Doppelbindung miteinander verbunden sind, so dass die Brücke eine der folgenden Formeln aufweist, wobei die Brücke bevorzugt zwei Kohlenstoffatome aufweist: 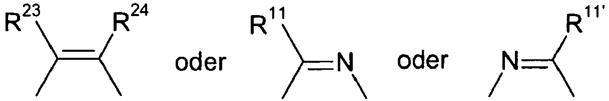
   R²³, R²⁴, R¹¹ und R^{11'} bedeuten unabhängig voneinander Wasserstoff, Alkyl, Heteroaryl, Alkenyl, Alkinyl, Aryl oder ein Substituent mit Donor- oder Akzeptorwirkung, oder
   R²³ und R²⁴ bilden gemeinsam eine Brücke mit insgesamt 3 bis 5, bevorzugt 4, Atomen, wovon gegebenenfalls 1 bis 5 Atome Heteroatome, bevorzugt N, sein können und die restlichen Atome Kohlenstoffatome sind, so dass diese Gruppe einen 5- bis 7-gliedrigen, bevorzugt sechsgliedrigen Ring bildet, der gegebenenfalls - neben der bereits vorhandenen Doppelbindung - eine - oder im Falle eines sechs - oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann. Bevorzugt ist dabei ein sechsgliedriger aromatischer Ring. Dieser kann mit Alkyl- oder Arylgruppen und/oder Gruppen mit Donor- oder Akzeptorwirkung substituiert oder unsubstituiert sein. Des Weiteren ist es möglich, dass an diesem, bevorzugt sechsgliedrigen, aromatischen Ring ein oder mehrere weitere aromatische Ringe anelliert sind. Dabei ist jede denkbare Anellierung möglich. Diese anellierten Reste können wiederum substituiert sein, bevorzugt mit den in der allgemeinen Definition der Arylreste genannten Resten.
- Eine Brücke, die zwei Kohlenstoffatome aufweist, wobei die Kohlenstoffatome durch eine Einfachbindung miteinander verbunden sind, so dass die Brücke die folgende Formel aufweist: 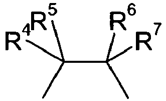 worin R⁴,
   - R⁵, R⁶ und R⁷: unabhängig voneinander Wasserstoff, Alkyl, Heteroaryl, Alkenyl, Alkinyl, Aryl oder ein Substituent mit Donor- oder Akzeptorwirkung bedeuten, bevorzugt Wasserstoff, Alkyl oder Aryl.

Unter einer Gruppe oder einem Substituenten mit Donor- oder Akzeptorwirkung sind im Sinne der vorliegenden Anmeldung, die folgenden Gruppen zu verstehen:
Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -1- und/oder ―M-Effekt aufweisen. Geeignete Gruppen, mit Donor- oder Akzeptorwirkung sind Halogenreste, bevorzugt F, Cl, Br, besonders bevorzugt F, Alkoxyreste, Aryloxyreste, Carbonylreste, Esterreste, sowohl Oxycarbonyl als auch Carbonyloxy, Aminreste, Amidreste, CH₂F-Gruppen, CHF₂-Gruppen, CF₃-Gruppen, CN-Gruppen, Thiogruppen, Sulfonsäuregruppen, Sulfonsäureestergruppen, Boronsäuregruppen, Boronsäureestergruppen, Phosphonsäuregruppen, Phosphonsäureestergruppen, Phosphinreste, Sulfoxidreste, Sulfonylreste, Sulfidreste, Heteroarylreste, Nitrogruppen, OCN, Boranreste, Silylgruppen, Stannatreste, Iminogruppen, Hydrazinreste, Hydrazonreste, Oximreste, Nitrosogruppen, Diazogruppen, Phosphinoxidgruppen, Hydroxygruppen oder SCN-Gruppen. Ganz besonders bevorzugt sind F, Cl, CN, Aryloxy, Alkoxy, Sulfonyl und Heteroaryl.

Die Gruppierung 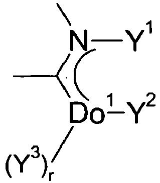 in dem Carbenliganden der allgemeinen Formel II ist bevorzugt ausgewählt aus der Gruppe bestehend aus 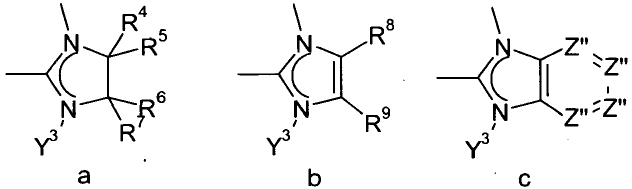 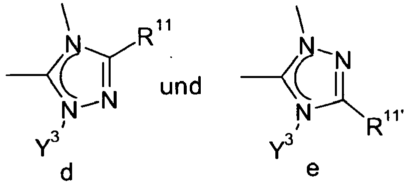 worin die Symbole die folgenden Bedeutungen aufweisen:
- Z": unabhängig voneinander CR¹⁰ oder N; bevorzugt sind 0 bis 3 der Gruppen Z" N, besonders bevorzugt 0 bis 2, ganz besonders bevorzugt 0 oder 1, wobei die übrigen Gruppen Z" CR¹⁰ bedeuten;
- R⁴, R⁵, R⁶, R⁷, R⁸, R⁹, R¹¹ und R^{11'}: Wasserstoff, Alkyl, Aryl, Heteroaryl, Alkinyl oder Alkenyl oder ein Substituent mit Donor- oder Akzeptorwirkung, bevorzugt Wasserstoff, Alkyl, Heteroaryl oder Aryl;
- R¹⁰: Wasserstoff, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom, bevorzugt N, enthalten kann, oder R¹⁰ bedeutet einen Rest mit Donor- oder Akzeptorwirkung;
weiterhin können R⁴ oder R⁵ in der Gruppierung a, R⁸ in der Gruppierung b, einer der Reste R¹⁰ in der Gruppierung c und R¹¹ in der Gruppierung d mit R¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
   - x: 2 bis 10;
   und
   - R¹⁸, R¹⁹, R²⁰, R²¹, R²², R³⁰, R³¹: H, Alkyl, Aryl, Heteroaryl, Alkenyl, Alkinyl
   bedeuten, wobei Beispiele betreffend bevorzugt geeignete Brücken vorstehend gezeigt sind.

Der Rest Y³ in den Strukturen a, b, c, d und e bedeutet erfindungsgemäß Wasserstoff, ein Alkyl-, Alkinyl- oder Alkenylrest, wobei bevorzugte Alkyl-, Alkinyl- und Alkenylreste vorstehend genannt sind, besonders bevorzugt ist ein Alkylrest, ganz besonders bevorzugt Methyl, Ethyl, iso-Propyl, n-Propyl, n-Butyl, iso-Butyl oder tert-Butyl, insbesondere besonders bevorzugt Methyl oder iso-Propyl;
oder 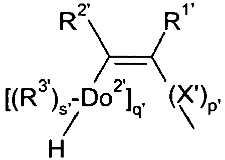 wobei Do^{2'}, q^{'}, s^{'}, R^{3'}, R^{1'}, R^{2'}, X^{'} und p^{'} unabhängig die gleichen Bedeutungen wie Do², q, s, R³, R¹, R², X und p ― die bereits vorstehend definiert sind ― aufweisen;
bevorzugt ist Y³ in den Strukturen a, b, c, d und e, ein Alkyl-, Alkinyl- oder Alkenylrest, wobei bevorzugte Alkyl-, Alkinyl- und Alkenylreste vorstehend genannt sind, besonders bevorzugt ein Alkylrest, ganz besonders bevorzugt Methyl, Ethyl, iso-Propyl, n-Propyl, n-Butyl, iso-Butyl oder tert-Butyl, insbesondere besonders bevorzugt Methyl oder iso-Propyl.

Die Gruppierung 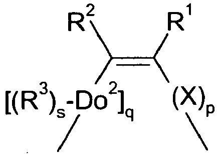 des Carbenliganden der Formel II weist bevorzugt die Struktur 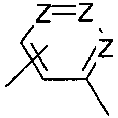 auf, worin die Symbole die folgenden Bedeutungen aufweisen:
- Z: unabhängig voneinander CR¹² oder N, wobei 0 bis 3 der Symbole Z N bedeuten können, bevorzugt 0 bis 2, besonders bevorzugt 0 oder 1, und Z in dem Fall, dass ein Symbol Z N bedeutet; in o-, m- oder p-Position, bevorzugt in o- oder p-Position, zur Verknüpfungsstelle der Gruppierung mit der Guppierung 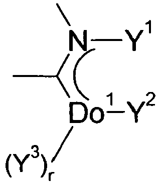 angeordnet sein kann;
- R¹²: in den Gruppen Z unabhängig voneinander H, ein Alkyl-, Aryl-, Heteroaryl-, Alkinyl-, Alkenylrest, oder jeweils 2 Reste R¹² bilden gemeinsam einen anellierten Ring, der gegebenenfalls mindestens ein Heteroatom, bevorzugt N, enthalten kann, oder R¹² bedeutet einen Rest mit Donor- oder Akzeptorwirkung; bevorzugt H oder ein Rest mit Donor- oder Akzeptorwirkung;
weiterhin kann die Gruppe der Struktur 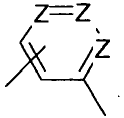 über den aromatischen Grundkörper oder über einen der Reste R¹² mit Y¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
   - x: 2 bis 10;
   und
   - R¹⁸, R¹⁹, R²⁰, R²¹, R²², R³⁰, R³¹: H, Alkyl, Aryl, Heteroaryl, Alkenyl, Alkinyl
bedeuten.

In einer bevorzugten Ausführungsform der vorliegenden Erfindung weist die Gruppe 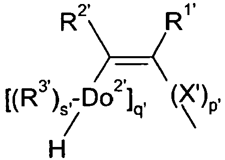 die folgende Bedeutung auf: 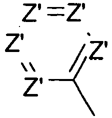 worin die Symbole die folgenden Bedeutungen aufweisen:
- Z': unabhängig voneinander CR^{12'} oder N, wobei 0 bis 5 der Symbole Z' N bedeuten können, bevorzugt 0 bis 4, besonders bevorzugt 0 bis 3, ganz besonders bevorzugt 0 bis 2, insbesondere ganz besonders bevorzugt 0 oder 1, und Z' in dem Fall, dass 1 Symbol Z' N bedeutet, in o-, m- oder p-Position, bevorzugt in o- oder p-Position, zur Verknüpfungsstelle der Gruppierung mit der Gruppierung 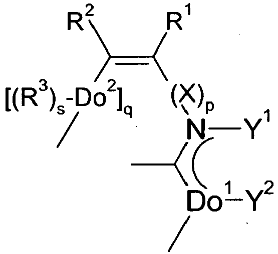 angeordnet sein kann;
- R^{12'}: in den Gruppen Z' unabhängig voneinander H, ein Alkyl-, Aryl-, Heteroaryl-, Alkinyl-, Alkenylrest, oder jeweils 2 Reste R^{12'} bilden gemeinsam einen anellierten Ring, der gegebenenfalls mindestens ein Heteroatom, bevorzugt N, enthalten kann, oder R^{12'} bedeutet einen Rest mit Donor- oder Akzeptorwirkung; bevorzugt H oder ein Rest mit Donor- oder Akzeptorwirkung;
weiterhin kann die Gruppe der Struktur 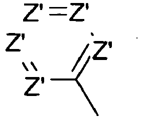 über den aromatischen Grundkörper oder über einen der Reste R^{12'} mit Y¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
   - x: 2 bis 10;
   und
   - R¹⁸, R¹⁹, R²⁰, R²¹, R²², R³⁰, R³¹: H, Alkyl, Aryl, Heteroaryl, Alkenyl, Alkinyl
bedeuten.

Weiterhin können Y³ und Y² in jedem der n Carbenliganden der allgemeinen Formel II über eine Brücke miteinander verknüpft sein, wobei die Brücke die folgenden Bedeutungen aufweisen kann:
Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
   - y: 2 bis 10;
   und
   - R²⁵, R²⁶, R²⁷, R²⁸, R²⁹, R³², R³³: H, Alkyl, Aryl, Heteroaryl, Alkenyl, Alkinyl
bedeuten.

In einer ganz besonders bevorzugten Ausführungsform betrifft die vorliegende Erfindung heteroleptische Carbenkomplexe der Formel I, worin der mindestens eine Carbenligand ausgewählt ist aus der Gruppe bestehend aus 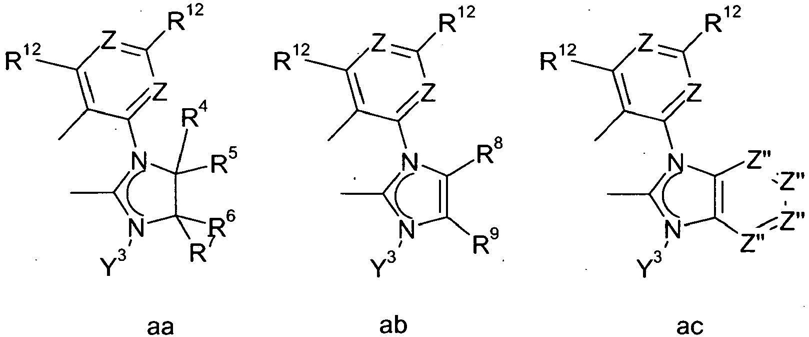 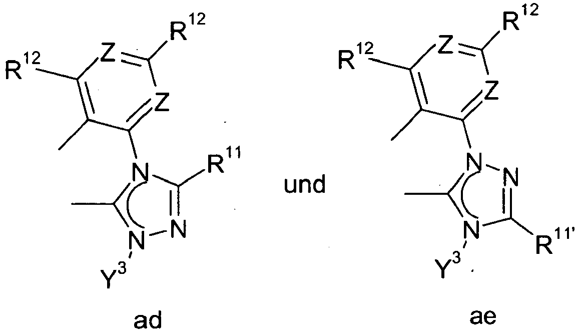 worin die Symbole die folgenden Bedeutungen aufweisen:
- Y³: ein Alkyl-, Alkinyl- oder Alkenylrest
oder
eine Gruppe der folgenden Struktur 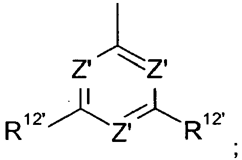
- Z: gleich oder verschieden CR¹² oder N;
- Z': gleich oder verschieden CR^{12'} oder N;
- Z": gleich oder verschieden CR¹⁰ oder N;
- R¹², R^{12'}: gleich oder verschieden jeweils unabhängig voneinander H, ein Alkyl-, Aryl- , Heteroaryl-, Alkinyl- oder Alkenylrest, oder jeweils 2 Reste R¹² bzw. R^{12'} bilden gemeinsam einen anellierten Ring, der gegebenenfalls mindestens ein Heteroatom enthalten kann, oder R¹² bzw. R^{12'} bedeutet einen Rest mit Donor- oder Akzeptorwirkung;
- R⁴, R⁵, R⁶, R⁷, R⁸, R⁹, R¹¹ und R^{11'}: Wasserstoff, Alkyl, Aryl, Heteroaryl, Alkinyl oder Alkenyl oder ein Rest mit Donor- oder Akzeptorwirkung;
- R¹⁰: in den Gruppen Z" unabhängig voneinander H, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom enthalten kann, oder R¹⁰ bedeutet einen Rest mit Donor- oder Akzeptorwirkung;
weiterhin kann die Gruppe der Struktur 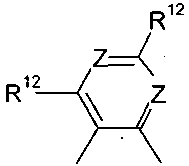 über den aromatischen Grundkörper oder über einen der Reste R¹² mit R⁴ oder R⁵ oder dem Kohlenstoffatom, mit dem R⁴ und R⁵ verknüpft sind, in der Gruppierung aa, R⁸ oder dem Kohlenstoffatom, mit dem R⁸ verknüpft ist, in der Gruppierung ab, einen der Reste R¹⁰ oder einem der Kohlenstoffatome, mit dem R¹⁰ verknüpft ist, in der Gruppierung ac und R¹¹ oder dem Kohlenstoffatom, mit dem R¹¹ verknüpft ist, in der Gruppierung ad über eine Brücke verknüpft sein;
und/oder
die Gruppe der Struktur 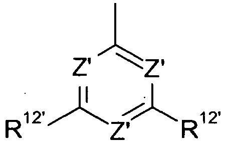 über den aromatischen Grundkörper oder über einen der Reste R^{12'} mit R⁶ oder R⁷ oder dem Kohlenstoffatom, mit dem R⁶ und R⁷ verknüpft sind, in der Gruppierung aa, R⁹ oder dem Kohlenstoffatom, mit dem R⁹ verknüpft ist, in der Gruppierung ab, einen der Reste R¹⁰ oder einem der Kohlenstoffatome, mit dem R¹⁰ verknüpft ist, in der Gruppierung ac und R^{11'} oder dem Kohlenstoffatom, mit dem R^{11'} verknüpft ist, in der Gruppierung ae über eine Brücke verknüpft sein;
wobei die jeweilige Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
   - x: 2 bis 10;
   und
   - R¹⁸, R¹⁹, R²⁰, R²¹, R²², R³⁰, R³¹: H, Alkyl, Aryl, Heteroaryl, Alkenyl, Alkinyl
   bedeuten;
wobei in den Fällen, worin die Gruppe der Struktur 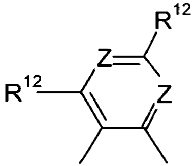
über eine Brücke mit dem Kohlenstoffatom, mit dem R⁴ und R⁵ verknüpft sind (Gruppierung aa), dem Kohlenstoffatom, mit dem R⁸ verknüpft ist (Gruppierung ab), einem der Kohlenstoffatome, mit dem R¹⁰ verknüpft ist (Gruppierung ac) oder dem Kohlenstoffatom, mit dem R¹¹ verknüpft ist (Gruppierung ad), verknüpft ist, der jeweilige Rest R⁴ oder R⁵, R⁸, einer der Reste R¹⁰ oder R¹¹ durch eine Bindung zu der Brücke ersetzt ist;
und in den Fällen, worin die Gruppe der Struktur 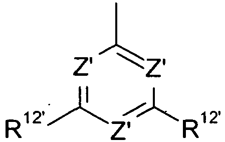
über eine Brücke mit dem Kohlenstoffatom, mit dem R⁶ und R⁷ verknüpft sind (Gruppierung aa), dem Kohlenstoffatom, mit dem R⁹ verknüpft ist (Gruppierung ab), einem der Kohlenstoffatome, mit dem R¹⁰ verknüpft ist (Gruppierung ac) oder dem Kohlenstoffatom, mit dem R^{11'} verknüpft ist (Gruppierung ad), verknüpft ist, der jeweilige Rest R⁶ oder R⁷, R⁹, einer der Reste R¹⁰ oder R^{11'} durch eine Bindung zu der Brücke ersetzt ist.

Besonders bevorzugt ist Y³ in den Strukturen aa, ab, ac, ad und ae ein Alkyl-, Alkinyl - oder Alkenylrest, wobei bevorzugte Alkyl-, Alkinyl- oder Alkenylreste vorstehend erwähnt sind.

Bei dem Carbenliganden der Formel II handelt es sich in einer bevorzugten Ausführungsform der vorliegenden Erfindung somit um einen "unsymmetrischen" Carbenliganden, worin Y³ Wasserstoff, ein Alkyl-, Alkinyl- oder Alkenylrest, bevorzugt ein Alkyl-, Alkinyl- oder Alkenylrest ist, wobei bevorzugte Alkyl-, Alkinyl- oder Alkenylreste vorstehend erwähnt sind.

Falls in den erfindungsgemäßen heteroleptischen Carbenkomplexen weitere Carbenliganden vorliegen (wenn n in den Carbenkomplexen der Formel I ≥ 2 ist), können diese mit dem ersten Carbenliganden indentisch sein oder von dem ersten Carbenliganden verschieden sein. Bevorzugt sind die Carbenliganden in dem Fall von n ≥ 2 identisch. In dem Fall, dass die Carbenliganden verschieden sind, kann z.B. ein Carbenligand "unsymmetrisch" sein, d.h. Y³ bedeutet: Wasserstoff, ein Alkyl-, Alkinyl- oder Alkenylrest, bevorzugt ein Alkyl-, Alkinyl- oder Alkenylrest, und ein weiterer Carbenligand "symmetrisch" sein, d.h. Y³ bedeutet: 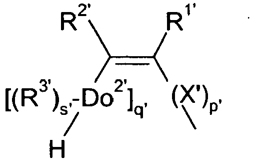 wobei Do^{2'}, q^{'}, s^{'}, R^{3'}, R^{1'}, R^{2'}, X^{'} und p^{'} vorstehend definiert sind. Es ist auch möglich, dass der heteroleptische Carbenkomplex der Formel I mehrere verschiedene symmetrische Carbenliganden oder mehrere verschiedene unsymmetrische Carbenliganden aufweist.

Erfindungsgemäß enthalten die heteroleptischen Carbenkomplexe der allgemeinen Formel I der vorliegenden Anmeldung neben mindestens einem Carbenliganden der allgemeinen Formel II mindestens einen heterocyclischen Nicht-Carbenliganden (het) der allgemeinen Formel III: 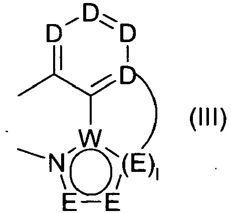 worin die Symbole in dem Liganden het der allgemeinen Formel III die folgenden Bedeutungen aufweisen:
- D: unabhängig voneinander CR³⁴ oder N; bevorzugt CR³⁴;
- W: C, N, P; bevorzugt C oder N;
- E: unabhängig voneinander CR³⁵, N, NR³⁶, S, O, P oder PR³⁷; bevorzugt unabhängig voneinander CR³⁵, N, NR³⁶, S oder O;
- I: 1 oder 2;
- R³⁴, R³⁵, R³⁶, R³⁷: unabhängig voneinander H, ein Alkyl-, Aryl-, Heteroaryl-, Alkinyl- oder Alkenylrest, oder jeweils 2 Reste R³⁴, R³⁵, R³⁶ oder R³⁷ bilden gemeinsam einen anellierten Ring, der gegebenenfalls mindestens ein Heteroatom enthalten kann, oder R³⁴, R³⁵, R³⁶ oder R³⁷ bedeutet einen Rest mit Donor - oder Akzeptorwirkung;
wobei die gestrichelte Linie eine optionale Verbrückung zwischen einer der Gruppen D und einer der Gruppen E bedeutet; wobei die Verbrückung die folgenden Bedeutungen aufweisen kann:
Alkylen, Arylen, Heteroarylen, Alkinylen, Alkenylen, NR³⁸, PR³⁹, BR⁴⁰, O, S, SO, SO₂, SiR⁴¹R⁴², CO, CO-O, O-CO und (CR⁴³R⁴⁴)ᵥ, wobei eine oder mehrere nicht benachbarte Gruppen (CR⁴³R⁴⁴) durch NR³⁸, PR³⁹, BR⁴⁰, O, S, SO, SO₂, SiR⁴¹R⁴², CO, CO-O, O-CO ersetzt sein können, wobei
   - v: 2 bis 10;
   und
   - R³⁸, R³⁹, R⁴⁰, R⁴¹, R⁴², R⁴³, R⁴⁴: H, Alkyl, Aryl, Heteroaryl, Alkenyl, Alkinyl
bedeuten.

Ganz besonders bevorzugt sind Liganden der allgemeinen Formel III, die neben dem N-Atom 0, 1 oder 2 weitere Heteroatome, bevorzugt ausgewählt aus N, O und S, aufweisen.

Insbesondere ganz besonders bevorzugt weisen die heterocyclischen Nicht-Carbenliganden der allgemeinen Formel III die folgenden Strukturen ba bis bu auf: 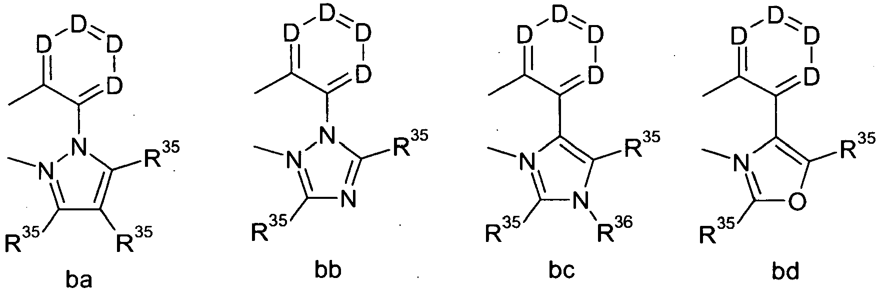 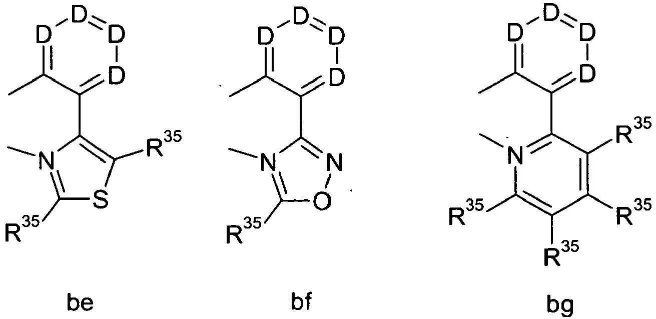 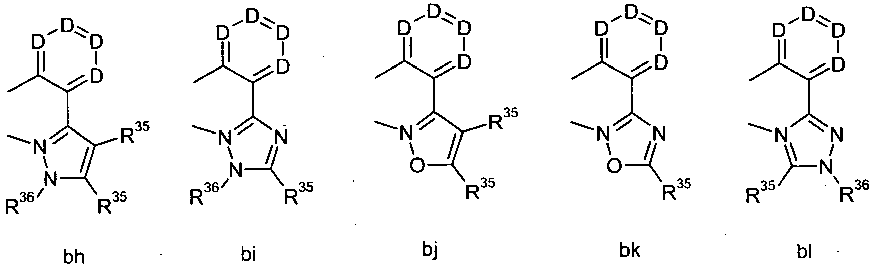 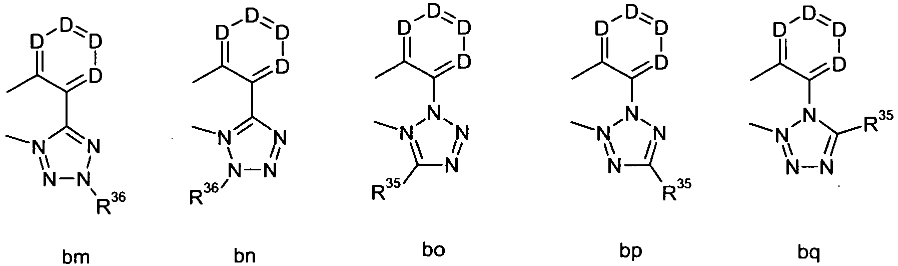 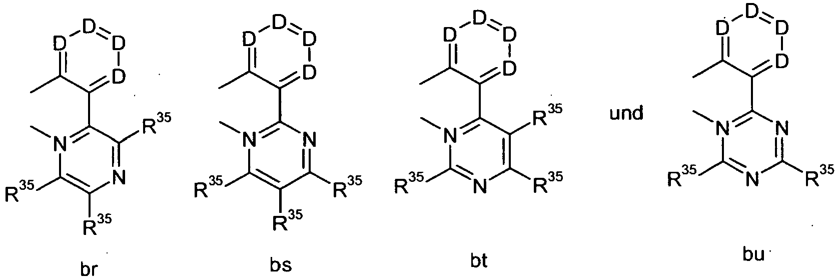 worin bedeuten:
- D: unabhängig voneinander CR³⁴ oder N; bevorzugt bedeuten 0 bis 3 Gruppen D N, besonders bevorzugt 0 bis 2, ganz besonders bevorzugt 0, 1 oder 2, wobei die weiteren Gruppen D CR³⁴ bedeuten; insbesondere ganz besonders bevorzugt bedeutet D in den Strukturen ba bis bu CR³⁴;
- R³⁴, R³⁵, R³⁶: unabhängig voneinander H, ein Alkyl-, Aryl-, Heteroaryl-, Alkinyl- oder Alkenylrest, oder jeweils 2 Reste R³⁴, R³⁵ oder R³⁶ bilden gemeinsam einen anellierten Ring, der gegebenenfalls mindestens ein Heteroatom enthalten kann, oder R³⁴, R³⁵ oder R³⁶ bedeutet einen Rest mit Donor- oder Akzeptorwirkung; bevorzugt H, ein Alkyl- oder Arylrest oder ein Rest mit Donor- oder Akzeptorwirkung.

Das Metallatom M¹ ist in den erfindungsgemäßen heteroleptischen Carbenkomplexen der allgemeinen Formel I besonders bevorzugt ausgewählt aus der Gruppe bestehend aus Ir, Os, Rh und Pt, wobei Os(II), Rh(III), Ir(III) und Pt(II) bevorzugt sind. Besonders bevorzugt ist Ir(III).

In einer weiteren bevorzugten Ausführungsform ist das Metallatom M¹ Fe(II), Fe(III), Ru(II), Cr(III), Mo(VI), W(O), Re(II), Mn(II), Ir(III), Co(II), Co(III), Rh(III), Os(II), Pt(IV)), n = 2 und m = 1. Ganz besonders bevorzugt sind heteroleptische Carbenkomplexe, worin M¹ Ir(III), n = 2 und m = 1 ist. Diese erfindungsgemäßen heteroleptischen Carbenkomplexe zeichnen sich gegenüber heteroleptischen Carbenkomplexen, die die gleichen Liganden auweisen, worin jedoch n = 1 und m = 2 ist, durch eine wesentlich verbesserte Effizienz aus.

Die erfindungsgemäßen heteroleptischen Carbenkomplexe weisen somit in einer ganz besonders bevorzugten Ausführungsform die Formel (Ii) auf: 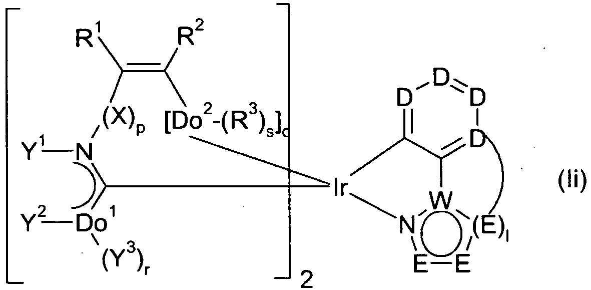 wobei die Symbole in den Carbenkomplexen der allgemeinen Formel (Ii) die folgenden Bedeutungen aufweisen:
- Do¹: Donoratom ausgewählt aus der Gruppe bestehend aus C, P, N, O, S und Si, bevorzugt P, N, O und S;
- Do²: Donoratom ausgewählt aus der Gruppe bestehend aus C, N, P, O und S;
- r: 2, wenn Do¹ C oder Si ist, 1, wenn Do¹ N oder P ist und 0, wenn Do¹ O oder S ist;
- s: 2, wenn Do² C ist, 1, wenn Do² N oder P ist und 0, wenn Do² O oder S ist;
- X: Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
- w: 2 bis 10;
- R¹³, R¹⁴, R¹⁵, R¹⁶,R¹⁷: H, Alkyl, Aryl, Heteroaryl, Alkenyl, Alkinyl;
- p: 0 oder 1;
- q: 0 oder 1;
- Y¹, Y²: jeweils unabhängig voneinander Wasserstoff oder eine kohlenstoffhaltige Gruppe ausgewählt aus der Gruppe bestehend aus Alkyl-, Aryl-, Heteroaryl-, Alkinyl - und Alkenylgruppen;
oder
Y¹ und Y² bilden gemeinsam eine Brücke zwischen dem Donoratom Do¹ und dem Stickstoffatom N die mindestens zwei Atome aufweist, wovon mindestens eines ein Kohlenstoffatom ist,
R¹, R² unabhängig voneinander Wasserstoff, Alkyl-, Aryl-, Heteroaryl-, Alkinyl- oder Alkenylreste,
oder
R¹ und R² bilden gemeinsam eine Brücke mit insgesamt drei bis fünf Atomen, wovon 1 bis 5 Atome Heteroatome sein können und die restlichen Atome Kohlenstoffatome sind, so dass die Gruppe 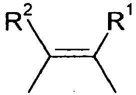 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl - oder Arylgruppen und/oder Gruppen mit Donor- oder Akzeptorwirkung substituiert sein kann und gegebenenfalls mindestens ein Heteroatom enthalten kann, und der fünf- bis siebengliedrige Ring gegebenenfalls mit einem oder mehreren weiteren Ringen anelliert sein kann;
weiterhin können Y¹ und R¹ über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
   - x: 2 bis 10;
   und
   - R¹⁸, R¹⁹, R²⁰, R²¹, R²², R³⁰, R³¹: H, Alkyl, Aryl, Heteroaryl, Alkenyl, Alkinyl bedeuten;
   - R³: Wasserstoff, ein Alkyl-, Aryl-, Heteroaryl-, Alkinyl- oder Alkenylrest;

   - Y³: Wasserstoff, ein Alkyl-, Alkinyl- oder Alkenylrest,
   oder 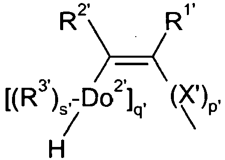 wobei Do^{2'}, q', s', R^{3'}, R^{1'}, R^{2'}, X' und p' unabhängig die gleichen Bedeutungen wie Do², q, s, R³, R¹, R², X und p aufweisen;
weiterhin können Y³ und Y² in jedem der n Carbenliganden über eine Brücke miteinander verknüpft sein, wobei die Brücke die folgenden Bedeutungen aufweisen kann:
Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
   - y: 2 bis 10;
   und
   - R²⁵, R²⁶, R²⁷, R²⁸, R²⁹, R³², R³³: H, Alkyl, Aryl, Heteroaryl, Alkenyl, Alkinyl bedeuten;
   - D: unabhängig voneinander CR³⁴ oder N;
   - W: C, N, P;
   - E: unabhängig voneinander CR³⁵, N, NR³⁶, S, O, P oder PR³⁷;
   - I: 1 oder 2;
   - R³⁴, R³⁵ R³⁶, R³⁷: unabhängig voneinander H, ein Alkyl-, Aryl-, Heteroaryl-, Alkinyl- oder Alkenylrest, oder jeweils 2 Reste R³⁴, R³⁵, R³⁶ oder R³⁷ bilden gemeinsam einen anellierten Ring, der gegebenenfalls mindestens ein Heteroatom enthalten kann, oder R³⁴, R³⁵, R³⁶ oder R³⁷ bedeutet einen Rest mit Donor - oder Akzeptorwirkung;
wobei die Reste, Gruppen und Indizes R¹, R², R³, Do¹, Do², Y¹, Y², Y³, X, p, q und r in den Carbenliganden in den Verbindungen der allgemeinen Formel Ii gleich oder verschieden sein können;
wobei die gestrichelte Linie eine optionale Verbrückung zwischen einer der Gruppen D und einer der Gruppen E bedeutet; wobei die Verbrückung die folgenden Bedeutungen aufweisen kann:
Alkylen, Arylen, Heteroarylen, Alkinylen, Alkenylen, NR³⁸, PR³⁹, BR⁴⁰, O, S, SO, SO₂, SiR⁴¹R⁴², CO, CO-O, O-CO und (CR⁴³R⁴⁴)ᵥ, wobei eine oder mehrere nicht benachbarte Gruppen (CR⁴³R⁴⁴) durch NR³⁸, PR³⁹, BR⁴¹), O, S, SO, SO₂, SiR⁴¹R⁴², CO, CO-O, O-CO ersetzt sein können, wobei
   - v: 2 bis 10;
   und
   - R³⁸, R³⁹, R⁴⁰, R⁴¹, R⁴², R⁴³, R⁴⁴: H, Alkyl, Aryl, Heteroaryl, Alkenyl, Alkinyl
bedeuten.

Bevorzugte Ausführungsformen und Definitionen der in der allgemeinen Formel Ii genannten Reste, Gruppen und Indizes entsprechen den bereits vorstehend für diese Reste, Gruppen und Indizes genannten Bedeutungen.

Die erfindungsgemäßen heteroleptischen Carbenkomplexe der Formel I können grundsätzlich analog zu dem Fachmann bekannten Verfahren hergestellt werden, wobei zu berücksichtigen ist, dass die erfindungsgemäßen heteroleptischen Carbenkomplexe der Formel I mindestens einen Carbenliganden der allgemeinen Formel II und mindestens einen heterocyclischen Nicht-Carbenliganden der allgemeinen Formel III tragen. Geeignete Verfahren zur Herstellung von Carbenkomplexen sind zum Beispiel in den Übersichtsartikeln W. A. Hermann et al., Advances in Organometallic Chemistry, 2001 Vol. 48, 1 bis 69, W. A. Hermann et al., Angew. Chem. 1997, 109, 2256 bis 2282 und G. Bertrand et al. Chem. Rev. 2000, 100, 39 bis 91 und der darin zitierten Literatur aufgeführt, sowie in WO 2005/113704, WO 2005/019373 und in der nicht vorveröffentlichten europäischen Anmeldung mit dem Aktenzeichen EP 06 101 109.4.

In einer Ausführungsform werden die erfindungsgemäßen heteroleptischen Carbenkomplexe der Formel I aus den Carbenliganden entsprechenden Ligandvorläufern, den heterocyclischen Nicht-Carbenligandvorläufern und geeigneten, das gewünschte Metall enthaltenden, Metallkomplexen hergestellt.

Geeignete Ligandvorläufer der Carbenliganden sind dem Fachmann bekannt. Bevorzugt handelt es sich um kationische Vorstufen der Carbenliganden der allgemeinen Formel IV 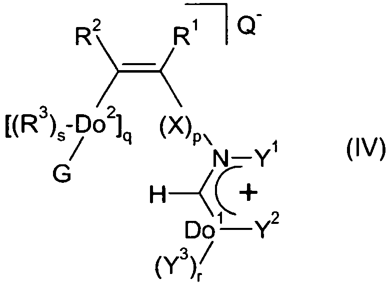 worin
- Q⁻: ein monoanionisches Gegenion, bevorzugt Halogenid, Pseudohalogenid, BF₄⁻, BPh₄⁻, PF₆⁻, AsF₆⁻ oder SbF₆⁻;
und
- G: wenn Do² = C oder q = 0 ist, H bedeutet, und
wenn Do² = N, S, O oder P ist, H oder ein freies Elektronenpaar des Heteroatoms bedeutet;
bedeuten, und
die weiteren Reste, Symbole und Indizes in dem Ligandvorläufer der allgemeinen Formel IV die vorstehend genannten Bedeutungen aufweisen.

Die Ligandvorläufer der allgemeinen Formel IV können gemäß dem Fachmann bekannten Verfahren hergestellt werden. Geeignete Verfahren sind z.B. in WO 2005/019373 und der darin zitierten Literatur, z.B. Organic Letters, 1999, 1, 953-956; Angewandte Chemie, 2000, 112, 1672-1674 genannt. Weitere geeignete Verfahren sind z.B. in T. Weskamp et al., J. Organometal. Chem. 2000, 600, 12-22; G. Xu et al., Org. Lett. 2005, 7, 4605-4608 ; V. Lavallo et al., Angew. Chem. Int. Ed. 2005, 44, 5705-5709 genannt. Einige der geeigneten Ligandvorläufer sind kommerziell erhältlich.

Geeignete heterocyclische Nicht-Carbenligandvorläufer sind dem Fachmann ebenfalls bekannt. Bevorzugt handelt es sich um Ligandvorläufer der allgemeinen Formel V 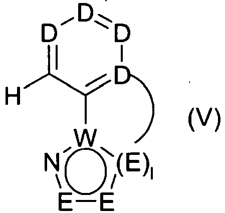 worin bedeuten:
- D: unabhängig voneinander CR³⁴ oder N;
- W: C, N, P;
- E: unabhängig voneinander CR³⁵, N, NR³⁶, S, O, P oder PR³⁷;
- I: 1 oder 2;
- R³⁴, R³⁵, R³⁶, R³⁷: unabhängig voneinander H, ein Alkyl-, Aryl-, Heteroaryl-, Alkinyl- oder Alkenylrest, oder jeweils 2 Reste R³⁴, R³⁵, R³⁶ oder R³⁷ bilden gemeinsam einen anellierten Ring, der gegebenenfalls mindestens ein Heteroatom enthalten kann, oder R³⁴, R³⁵, R³⁶ oder R³⁷ bedeutet einen Rest mit Donor - oder Akzeptorwirkung;
wobei die gestrichelte Linie eine optionale Verbrückung zwischen einer der Gruppen D und einer der Gruppen E bedeutet; wobei die Verbrückung die folgenden Bedeutungen. aufweisen kann:
Alkylen, Arylen, Heteroarylen, Alkinylen, Alkenylen, NR³⁸, PR³⁹, BR⁴⁰, O, S, SO, SO₂, SiR⁴¹R⁴², CO, CO-O, O-CO und (CR⁴³R⁴⁴)ᵥ, wobei eine oder mehrere nicht benachbarte Gruppen (CR⁴³R⁴⁴) durch NR³⁸, PR³⁹, BR⁴⁰, O, S, SO, SO₂, SiR⁴¹R⁴², CO, CO-O, O-. CO ersetzt sein können, wobei
   - v: 2 bis 10;
   und
   - R³⁸, R³⁹, R⁴⁰, R⁴¹, R⁴², R⁴³, R⁴⁴: H, Alkyl, Aryl, Heteroaryl, Alkenyl, Alkinyl
   bedeuten.

Bevorzugte Ausführungsformen der genannten Reste, Symbole und Indizes sind vorstehend genannt.

Die Ligandvorläufer der allgemeinen Formel V können gemäß dem Fachmann bekannten Verfahren hergestellt werden bzw. sind kommerziell erhältlich. Geeignete Herstellungsverfahren sind z.B. in B.M Choudary et al., *J. Am. Chem.* Soc. **2005,** 127, 9948; H. Zhang et al., *J. Org. Chem.* **2005,** *70*, 5164; S.V. Ley et al., *Angew. Chem. Int. Ed.* **2003,** *42,* 5400; J. Hassan et al., *Chem. Rev.* **2002,** *102,* 1359; *Metal-catalyzed* Cross*coupling Reactions,* A. de Meijere, F. Diederich, Wiley-VCH, **2004** offenbart.

In einer bevorzugten Ausführungsform betrifft die vorliegende Erfindung ein Verfahren zur Herstellung der erfindungsgemäßen heteroleptischen Carbenkomplexe der allgemeinen Formel I, wobei die Herstellung den folgenden Schritt umfasst:
Umsetzung von mindestens einem Ligandvorläufer der allgemeinen Formel (IV) 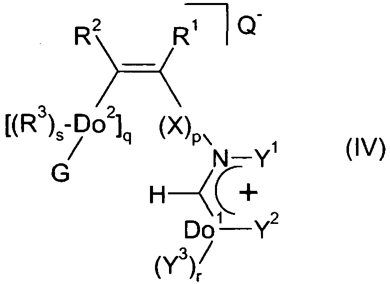 worin die Symbole, Reste und Indizes die vorstehend genannten Bedeutungen aufweisen;
   und
mindestens einem Ligandvorläufer der allgemeinen Formel V 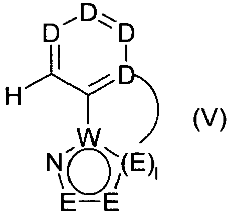
worin die Symbole, Reste und Indizes die vorstehend genannten Bedeutungen aufweisen;
mit einem Metallkomplex enthaltend mindestens ein Metall M^{1'}, wobei M^{1'} die folgenden Bedeutungen aufweist:
- M^{1'}: Metallatom ausgewählt aus der Gruppe bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, in jeder für das entsprechende Metallatom möglichen Oxidationsstufe.

Die Herstellung der erfindungsgemäßen heteroleptischen Carbenkomplexe ist grundsätzlich durch gleichzeitige Umsetzung von Carbenligandvorläufern der allgemeinen Formel IV und Ligandvorläufern der allgemeinen Formel V mit einem Metallkomplex enthaltend mindestens ein Metall M^{1'} möglich ("Eintopfverfahren") oder bevorzugt durch sequentielle Umsetzung. Die sequentielle Umsetzung kann entweder durch Umsetzung des Metallkomplexes mit mindestens einem Carbenligandvorläufer der allgemeinen Formel IV in einem ersten Schritt erfolgen, wobei zunächst als Zwischenstufe ein Carbenkomplex, der mindestens einen Carbenliganden entweder der allgemeinen Formel 11 oder als nicht-cyclometallierte Form und mindestens eine weitere Koordinationsmöglichkeit (wobei die weitere Koordinationsmöglichkeit entweder durch eine freie Koordinationsstelle am Metall M^{1'} oder durch die Verdrängung anderer Liganden vorliegt) für mindestens einen weiteren bidentaten heterocyclischen Nicht-Carbenliganden der Formel III aufweist, gebildet wird; oder durch Umsetzung des Metallkomplexes mit mindestens einem Ligandvorläufer der allgemeinen Formel V in einem ersten Schritt, wobei zunächst als Zwischenstufe ein Komplex, der mindestens einen heterocyclischen Nicht-Carbenliganden entweder der allgemeinen Formel III oder als nicht-cyclometallierte Form und mindestens eine weitere Koordinationsmöglichkeit (wobei die weitere Koordinationsmöglichkeit entweder durch eine freie Koordinationsstelle am Metall M^{1'} oder durch die Verdrängung anderer Liganden vorliegt) für mindestens einen bidentaten Carbenliganden der Formel II aufweist, gebildet wird. In einem auf den ersten Schritt folgenden zweiten Schritt erfolgt eine Umsetzung des jeweiligen im ersten Schritt erhaltenen Komplexes mit mindestens einem Ligandvorläufer der allgemeinen Formel V (wenn im ersten Schritt mindestens ein Carbenligandvorläufer der allgemeinen Formel IV eingesetzt wurde) bzw. mit mindestens einem Carbenligandvorläufer der allgemeinen Formel IV (wenn im ersten Schritt mindestens ein Ligandvorläufer der allgemeinen Formel V eingesetzt wurde).

In dem besonders bevorzugten Fall, dass das Metall M¹ in den erfindungsgemäßen heteroleptischen Carbenkomplexen der Formel I Ir(III) mit einer Koordinationszahl von 6 ist, ergeben sich bei einer sequentiellen Umsetzung z.B. die folgenden besonders bevorzugten Wege, wobei ein Carbenkomplex der allgemeinen Formel Ii erhalten wird:

### Weg ia:

- (iaa): Umsetzung eines Metallkomplexes enthaltend mindestens ein Metall M^{1'}, worin das mindestens eine Metall M^{1'} Ir ist, mit einer im Verhältnis zu Ir mindestens doppelt stöchiometrischen Menge eines Carbenligandvorläufers IV, wobei ein Di-Carbenkomplex gebildet wird, der Carbenliganden der allgemeinen Formel II und eine weitere Koordinationsstelle für einen weiteren bidentaten Liganden aufweist, und
- (iab): anschließende Umsetzung des erhaltenen Di-Carbenkomplexes mit einer im Verhältnis zu Ir mindestens stöchiometrischen Menge eines Ligandvorläufers der allgemeinen Formel V, wobei ein heteroleptischer Ir-Carbenkomplex der allgemeinen Formel Ii erhalten wird.

### Weg ib:

- (iba): Umsetzung eines Metallkomplexes enthaltend mindestens ein Metall M^{1'}, worin das mindestens eine Metall M^{1'} Ir ist, mit einer im Verhältnis zu Ir mindestens stöchiometrischen Menge eines Ligandvorläufers der allgemeinen Formel V, wobei ein Komplex gebildet wird, der einen heterocyclischen Nicht-Carbenliganden der allgemeinen Formel III und zwei weitere Koordinationsstellen für zwei weitere bidentate Liganden aufweist, und
- (ibb): anschließende Umsetzung des erhaltenen Komplexes mit einer im Verhältnis zu Ir mindestens doppelt stöchiometrischen Menge eines Carbenligandvorläufers der allgemeinen Formel IV, wobei ein heteroleptischer Ir-Carbenkomplex der allgemeinen Formel Ii erhalten wird.

In den in den Schritten (iaa) und (iba) gebildeten Zwischenstufen können die jeweiligen Carbenliganden bzw. Nicht-Carbenliganden entweder in cyclometallierter Form oder in nicht cyclometallierter Form vorliegen.

In einer besonders bevorzugten Ausführungsform der vorliegenden Erfindung erfolgt die Umsetzung zu einem Carbenkomplex der allgemeinen Formel Ii gemäß Weg ia.

Die vorstehend in Schritt (iaa) oder (iba) erhaltenen Komplexe können ggf. isoliert werden oder "in situ", d.h. ohne Aufarbeitung, mit dem/den weiteren Ligandvorläufern umgesetzt werden.

Bei dem Metallkomplex enthaltend mindestens ein Metall M^{1'} handelt es sich um einen Metallkomplex enthaltend mindestens ein Metall ausgewählt aus der Gruppe bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, ganz besonders bevorzugt Ir, in jeder für das entsprechende Metallatom möglichen Oxidationsstufe, bevorzugt Ir(I) oder Ir(III). Geeignete Metallkomplexe sind dem Fachmann bekannt. Beispiele für geeignete Metallkomplexe sind Pt(cod)Cl₂, Pt(cod)Me₂, Pt(acac)₂, Pt(PPh₃)₂Cl₂, PtCl₂, [Rh(cod)Cl]₂, Rh(acac)CO(PPh₃), Rh(acac)(CO)₂, Rh(cod)₂BF₄, RhCl(PPh₃)₃, RhCl₃ x n H₂O, Rh(acac)₃, [Os(CO)₃I₂]₂, [OS₃(CO)₁₂], OsH₄(PPH₃)₃, Cp₂OS, Cp*₂Os, H₂OsCl₆ x 6H₂O, OsCl₃ x H₂O), sowie [(µ-Cl)Ir(η⁴-1,5-cod)]₂, [(µ-Cl)Ir(η²-coe)₂]₂, Ir(acac)₃, IrCl₃ x n H₂O, (tht)₃IrCl₃, Ir(η³-Allyl)₃, Ir(η³-Methallyl)₃, worin cod Cyclooctadien, coe Cycloocten, acac Acetylacetonat und tht Tetrahydrothiophen bedeuten. Die Metallkomplexe können gemäß dem Fachmann bekannten Verfahren hergestellt werden bzw. sind kommerziell erhältlich.

Bei der Herstellung von Iridium(III)-Komplexen der allgemeinen Formel I (M¹ in Formel I ist Ir), die gemäß der vorliegenden Anmeldung besonders bevorzugt sind, können die vorstehend genannten Iridium(I)- oder (III)-Komplexe eingesetzt werden, insbesondere [(µ-Cl)Ir(η⁴-1,5-cod)]₂, [(µ-Cl)Ir(η²-coe)₂]₂, Ir(acac)₃, IrCl₃ x n H₂O, (tht)₃IrCl₃, Ir(η³-Allyl)₃, Ir(η³-Methallyl)₃, worin cod Cyclooctadien, coe Cycloocten, acac Acetylacetonat und tht Tetrahydrothiophen bedeuten.

Im Anschluss an die Umsetzung wird der erfindungsgemäße heteroleptische Carbenkomplex nach dem Fachmann bekannten Verfahren aufgearbeitet und ggf. gereinigt. Üblicherweise erfolgen die Aufarbeitung und Reinigung durch Extraktion, Säulenchromatographie und/oder Umkristallisation gemäß dem Fachmann bekannten Verfahren.

Die erfindungsgemäßen heteroleptischen Carbenkomplexe eignen sich hervorragend als Emittersubstanzen, da sie eine Emission (Elektrolumineszenz) im sichtbaren Bereich des elektromagnetischen Spektrums aufweisen. Mit Hilfe der erfindungsgemäßen heteroleptischen Carbenkomplexe als Emittersubstanzen ist es möglich, Verbindungen bereit zu stellen, die Elektrolumineszenz im roten, grünen sowie im blauen Bereich des elektromagnetischen Spektrums mit sehr guter Effizienz zeigen. Dabei ist die Quantenausbeute hoch und die Stabilität der erfindungsgemäßen heteroleptischen Carbenkomplexe im Device hoch.

Des Weiteren sind die erfindungsgemäßen heteroleptischen Carbenkomplexe als Elektronen-, Excitonen- oder Lochblocker oder Lochleiter, Elektronenleiter, Lochinjektionsschicht oder Matrixmaterial in OLEDs geeignet, in Abhängigkeit von den eingesetzten Liganden und dem eingesetzten Zentralmetall.

Organische Licht-emittierende Dioden (OLEDs) sind grundsätzlich aus mehreren Schichten aufgebaut:
1. Anode (1)
2. Löcher-transportierende Schicht (2)
3. Licht-emittierende Schicht (3)
4. Elektronen-transportierende Schicht (4)
5. Kathode (5)

Es ist jedoch auch möglich, dass das OLED nicht alle der genannten Schichten aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Die heteroleptischen Carbenkomplexe gemäß der vorliegenden Anmeldung können in verschiedenen Schichten eines OLEDs eingesetzt werden. Ein weiterer Gegenstand der vorliegenden Erfindung ist daher die Verwendung der erfindungsgemäßen heteroleptischen Carbenkomplexe in organischen Leuchtdioden (OLEDs), sowie ein OLED enthaltend mindestens einen erfindungsgemäßen heteroleptischen Carbenkomplex. Die erfindungsgemäßen heteroleptischen Carbenkomplexe werden bevorzugt in der Licht-emittierenden Schicht, besonders bevorzugt als Emittermoleküle, eingesetzt. Ein weiterer Gegenstand der vorliegenden Erfindung ist daher eine Licht-emittierende Schicht enthaltend mindestens einen heteroleptischen Carbenkomplex, bevorzugt als Emittermolekül. Bevorzugte heteroleptische Carbenkomplexe sind vorstehend genannt.

Die erfindungsgemäßen heteroleptischen Carbenkomplexe können in Substanz - ohne weitere Zusätze - in der Licht-emittierenden Schicht oder einer anderen Schicht des OLEDs, bevorzugt in der Licht-emittierenden Schicht, vorliegen. Es ist jedoch ebenfalls möglich und bevorzugt, dass neben den erfindungsgemäßen heteroleptischen Carbenkomplexen weitere Verbindungen in den Schichten enthaltend mindestens einen erfindungsgemäßen heteroleptischen Carbenkomplex, bevorzugt in der Licht-emittierenden Schicht, vorliegen. Beispielsweise kann in der Licht-emittierenden Schicht ein fluoreszierender Farbstoff anwesend sein, um die Emissionsfarbe des als Emittermoleküls eingesetzten heteroleptischen Carbenkomplexes zu verändern. Des Weiteren kann - in einer bevorzugten Ausführungsform - ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N, N'-Dicarbazolbiphenyl (CDP=CBP) oder tertiäre aromatische Amine.

Die einzelnen der vorstehend genannten Schichten des OLEDs können wiederum aus 2 oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Lochinjektionsschicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektroneninjektionsschicht Elektronen erhält und in die Licht-emittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß, bevorzugt als Emittersubstanzen, verwendeten heteroleptischen Carbenkomplexe angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist ein OLED enthaltend mindestens eine erfindungsgemäße Licht-emittierende Schicht. Die weiteren Schichten in dem OLED können aus einem beliebigen Material aufgebaut sein, das üblicherweise in solchen Schichten eingesetzt wird und dem Fachmann bekannt ist.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (α-NPD), N, N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N, N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB) 4,4',4"-tris(N,N-Diphenylamino)triphenylamin (TDTA) und Porphyrinverbindungen sowie Phthalocyaninen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen, PEDOT (Poly(3,4-ethylendioxythiophen), bevorzugt PEDOT dotiert mit PSS (Polystyrolsulfonat), und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronentransportmaterialien für die Schicht (4) der erfindungsgemäßen OLEDs umfassen mit oxinoiden Verbindungen chelatisierte Metalle wie Tris(8-hydroxychinolato)aluminium (Alq₃), Verbindungen auf Phenanthrolinbasis wie 2,9-Dimethyl, 4,7-Diphenyl-1, 10-phenanthrolin (DDPA = BCP) oder 4,7-Diphenyl-1, 10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons.

Von den vorstehend als Lochtransportmaterialien und Elektronen transportierende Materialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochtransportmaterialien mit Elektronenakzeptoren dotiert werden, zum Beispiel können Phthalocyanine bzw. Arylamine wie TPD oder TDTA mit Tetrafluorotetracyano-chinodimethan (F4-TCNQ) dotiert werden. Die Elektronentransportmaterialien können zum Beispiel mit Alkalimetallen dotiert werden, beispielsweise Alq₃ mit Lithium. Die elektronische Dotierung ist dem Fachmann bekannt und zum Beipsiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo, Appl. Phys. Lett., Vol. 82, No. 25, 23 June 2003 und Pfeiffer et al., Organic Electronics 2003, 4, 89 - 103 offenbart.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:
- eine Loch-Injektionsschicht zwischen der Anode (1) und der Löchertransportierenden Schicht (2);
- eine Blockschicht für Elektronen und/oder Excitonen zwischen der Löchertransportierenden Schicht (2) und der Licht-emittierenden Schicht (3);
- eine Blockschicht für Löcher und/oder Excitonen zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Wie bereits vorstehend erwähnt, ist es jedoch auch möglich, dass das OLED nicht alle der genannten Schichten (1) bis (5) aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Dem Fachmann ist bekannt, wie er (zum Beispiel auf Basis von elektrochemischen Untersuchungen) geeignete Materialien auswählen muss. Geeignete Materialien für die einzelnen Schichten sowie geeignete OLED-Aufbauten sind dem Fachmann bekannt und z.B. in W02005/113704 offenbart.

Des Weiteren kann jede der genannten Schichten des erfindungsgemäßen OLEDs aus zwei oder mehreren Schichten aufgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des erfindungsgemäßen OLEDs kann nach dem Fachmann bekannten Methoden erfolgen. Im Allgemeinen wird das OLED durch aufeinander folgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Zusammensetzungen, die neben dem mindestens einen erfindungsgemäßen heteroleptischen Carbenkomplex ein polymeres Material in einer der Schichten des OLEDs, bevorzugt in der Licht-emittierenden Schicht, aufweisen, werden im Allgemeinen mittels lösungsverarbeitenden Verfahren als Schicht aufgebracht.

Im Allgemeinen haben die verschiedenen Schichten folgende Dicken: Anode (2) 500 bis 5000 Å, bevorzugt 1000 bis 2000 Å; Löcher-transportierende Schicht (3) 50 bis 1000 Å, bevorzugt 200 bis 800 Å, Licht-emittierende Schicht (4) 10 bis 1000 Å, bevorzugt 100 bis 800 Å, Elektronen transportierende Schicht (5) 50 bis 1000 Å, bevorzugt 200 bis 800 Å, Kathode (7) 200 bis 10.000 Å, bevorzugt 300 bis 5000 Å. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz der erfindungsgemäßen heteroleptischen Carbenkomplexe in mindestens einer Schicht des erfindungsgemäßen OLEDs, bevorzugt als Emittermolekül in der Licht-emittierenden Schicht der erfindungsgemäßen OLEDs, können OLEDs mit hoher Effizienz erhalten werden. Die Effizienz der erfindungsgemäßen OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Digitalkameras, Fahrzeugen sowie Zielanzeigen an Bussen und Bahnen.

Weiterhin können die erfindungsgemäßen heteroleptischen Carbenkomplexe in OLEDs mit inverser Struktur eingesetzt werden. Bevorzugt werden die erfindungsgemäßen heteroleptischen Carbenkomplexe in diesen inversen OLEDs wiederum in der Licht-emittierenden Schicht eingesetzt. Der Aufbau von inversen OLEDs und die üblicherweise darin eingesetzten Materialien sind dem Fachmann bekannt.

Die vorstehend beschriebenen erfindungsgemäßen heteroleptischen Carbenkomplexe können neben dem Einsatz in OLEDs als Färbemittel eingesetzt werden, die bei Einstrahlung von Licht im sichtbaren Bereich des elektromagnetischen Spektrums emittieren (Photolumineszenz).

Ein weiterer Gegenstand der vorliegenden Anmeldung ist daher die Verwendung der vorstehend beschriebenen erfindungsgemäßen heteroleptischen Carbenkomplexe zur Massenfärbung polymerer Materialien.

Geeignete polymere Materialien sind Polyvinylchlorid, Celluloseacetat, Polycarbonate, Polyamide, Polyurethane, Polyimide, Polybenzimidazole, Melaminharze, Silikone, Polyester, Polyether, Polystyrol, Polymethylmethacrylat, Polyethylen, Polypropylen, Polyvinylacetat, Polyacrylnitril, Polybutadien, Polychlorbutadien, Polyisopren bzw. die Copolymere der aufgeführten Monomere.

Des Weiteren können die vorstehend beschriebenen erfindungsgemäßen heteroleptischen Carbenkomplexe in den folgenden Anwendungen eingesetzt werden:
- Anwendung der erfindungsgemäßen heteroleptischen Carbenkomplexe als oder in Küpenfarbstoffe(n), zum Beispiel zur Färbung von Naturstoffen, Beispiele sind Papier, Holz, Stroh, Leder, Felle oder natürliche Fasermaterialien wie Baumwolle, Wolle, Seide, Jute, Sisal, Hanf, Flachs oder Tierhaare (zum Beispiel Rosshaar) und deren Umwandlungsprodukte wie zum Beispiel die Viskosefaser, Nitratseide oder Kupferrayon (Reyon)
- Anwendung der erfindungsgemäßen heteroleptischen Carbenkomplexe als Farbmittel, zum Beispiel zur Färbung von Farben, Lacken und anderen Anstrichstoffen, Papierfarben, Druckfarben, Tinten und andere Farben für Mal- und Schreib-Zwecke.
- Anwendung der erfindungsgemäßen heteroleptischen Carbenkomplexe als Pigmentfarbstoffe, zum Beispiel zur Färbung von Farben, Lacken und anderen Anstrichsstoffen, Papierfarben, Druckfarben, Tinten und andere Farben für Mal- und Schreib-Zwecke.
- Anwendung der erfindungsgemäßen heteroleptischen Carbenkomplexe als Pigmente in der Elektrophotographie: zum Beispiel für Trockenkopiersysteme (Xerox-Verfahren) und Laserdrucker.
- Anwendung der erfindungsgemäßen heteroleptischen Carbenkomplexe für Sicherheitsmarkierungs-Zwecke, wobei die große chemische und photochemische Beständigkeit und gegebenenfalls auch die Lumineszenz der Substanzen von Bedeutung ist. Bevorzugt ist dies für Schecks, Scheckkarten, Geldscheine Coupons, Dokumente, Ausweispapiere und dergleichen, bei denen ein besonderer, unverkennbarer Farbeindruck erzielt werden soll.
- Anwendung der erfindungsgemäßen heteroleptischen Carbenkomplexe als Zusatz zu anderen Farben, bei denen eine bestimmte Farbnuance erzielt werden soll, bevorzugt sind besonders leuchtende Farbtöne.
- Anwendung der erfindungsgemäßen heteroleptischen Carbenkomplexe zum Markieren von Gegenständen zum maschinellen Erkennen dieser Gegenstände über die Lumineszenz, bevorzugt ist die maschinelle Erkennung von Gegenständen zum Sortieren, zum Beispiel auch für das Recycling von Kunststoffen.
- Anwendung der erfindungsgemäßen heteroleptischen Carbenkomplexe als Lumineszenzfarbstoffe für maschinenlesbare Markierungen, bevorzugt sind alphanumerische Aufdrucke oder Barcodes.
- Anwendung der erfindungsgemäßen heteroleptischen Carbenkomplexe zur Frequenzumsetzung von Licht, zum Beispiel um aus kurzwelligem Licht längerwelliges, sichtbares Licht zu machen.
- Anwendung der erfindungsgemäßen heteroleptischen Carbenkomplexe in Anzeigeelementen für vielerlei Anzeige-, Hinweis- und Markierungszwecke, zum Beispiel in passiven Anzeigeelementen, Hinweis- und Verkehrszeichen, wie Ampeln.
- Anwendung der erfindungsgemäßen heteroleptischen Carbenkomplexe in Tintenstrahldruckern, bevorzugt in homogener Lösung als lumineszierende Tinte.
- Anwendung der erfindungsgemäßen heteroleptischen Carbenkomplexe als Ausgangsmaterial für supraleitende organische Materialien.
- Anwendung der erfindungsgemäßen heteroleptischen Carbenkomplexe für Feststoff-Lumineszenz-Markierungen.
- Anwendung der erfindungsgemäßen heteroleptischen Carbenkomplexe für dekorative Zwecke.
- Anwendung der erfindungsgemäßen heteroleptischen Carbenkomplexe zu Tracer-Zwecken, zum Beispiel in der Biochemie, Medizin, Technik und Naturwissenschaft. Hierbei können die Farbstoffe kovalent mit Substraten verknüpft sein oder über Nebenvalenzen wie Wasserstoffbrückenbindungen oder hydrophobe Wechselwirkungen (Adsorption).
- Anwendung der erfindungsgemäßen heteroleptischen Carbenkomplexe als Lumineszenzfarbstoffe in hochempfindlichen Nachweisverfahren (siehe C. Aubert, J. Fünfschilling, I. Zschocke-Gränacher und H. Langhals, Z. Analyt. Chem. 320 (1985) 361).
- Anwendung der erfindungsgemäßen heteroleptischen Carbenkomplexe als Lumineszenzfarbstoffe in Szintillatoren.
- Anwendung der erfindungsgemäßen heteroleptischen Carbenkomplexe als Farbstoffe oder Lumineszenzfarbstoffe in optischen Lichtsammelsystemen.
- Anwendung der erfindungsgemäßen heteroleptischen Carbenkomplexe als Farbstoffe oder Lumineszenzfarbstoffe in Lumineszenz-Solarkollektoren (siehe Langhals, Nachr. Chem. Tech. Lab. 28 (1980) 716).
- Anwendung der erfindungsgemäßen heteroleptischen Carbenkomplexe als Farbstoffe oder Lumineszenzfarbstoffe in Lumineszenz-aktivierten Displays (siehe W. Greubel und G. Baur, Elektronik 26 (1977) 6).
- Anwendung der erfindungsgemäßen heteroleptischen Carbenkomplexe als Farbstoffe oder Lumineszenzfarbstoffe in Kaltlichtquellen zur lichtinduzierten Polymerisation zur Darstellung von Kunststoffen.
- Anwendung der erfindungsgemäßen heteroleptischen Carbenkomplexe als Farbstoffe oder Lumineszenzfarbstoffe zur Materialprüfung, zum Beispiel bei der Herstellung von Halbleiterschaltungen.
- Anwendung der erfindungsgemäßen heteroleptischen Carbenkomplexe als Farbstoffe oder Lumineszenzfarbstoffe zur Untersuchung von Mikrostrukturen von integrierten Halbleiterbauteilen.
- Anwendung der erfindungsgemäßen heteroleptischen Carbenkomplexe als Farbstoffe oder Lumineszenzfarbstoffe in Photoleitern.
- Anwendung der erfindungsgemäßen heteroleptischen Carbenkomplexe als Farbstoffe oder Lumineszenzfarbstoffe in fotografischen Verfahren.
- Anwendung der erfindungsgemäßen heteroleptischen Carbenkomplexe als Farbstoffe oder Lumineszenzfarbstoffe in Anzeige-, Beleuchtungs- oder Bildwandlersystemen, bei denen die Anregung durch Elektronen, Ionen oder UV-Strahlung erfolgt, zum Beispiel in Lumineszenzanzeigen, Braunschen Röhren oder in Leuchtstoffröhren.
- Anwendung der erfindungsgemäßen heteroleptischen Carbenkomplexe als Farbstoffe oder Lumineszenzfarbstoffe als Teil einer integrierten Halbleiterschaltung, die Farbstoffe als solche oder in Verbindung mit anderen Halbleitern zum Beispiel in Form einer Epitaxie.
- Anwendung der erfindungsgemäßen heteroleptischen Carbenkomplexe als Farbstoffe oder Lumineszenzfarbstoffe in Chemilumineszenzsystemen, zum Beispiel in Chemilumineszenz-Leuchtstäben, in Lumineszenzimmunessays oder anderen Lumineszenznachweisverfahren.
- Anwendung der erfindungsgemäßen heteroleptischen Carbenkomplexe als Farbstoffe oder Lumineszenzfarbstoffe als Signalfarben, bevorzugt zum optischen Hervorheben von Schriftzügen und Zeichnungen oder anderen graphischen Produkten, zum Kennzeichnen von Schildern und anderen Gegenständen, bei denen ein besonderer optischer Farbeindruck erreicht werden soll.
- Anwendung der erfindungsgemäßen heteroleptischen Carbenkomplexe als Farbstoffe oder Lumineszenzfarbstoffe in Farbstoff-Lasern, bevorzugt als Lumineszenzfarbstoffe zur Erzeugung von Laserstrahlen.
- Anwendung der erfindungsgemäßen heteroleptischen Carbenkomplexe als aktive Substanzen für eine nichtlineare Optik, zum Beispiel für die Frequenzverdopplung und die Frequenzverdreifachung von Laserlicht.
- Anwendung der erfindungsgemäßen heteroleptischen Carbenkomplexe als Rheologieverbesserer.
- Anwendung der erfindungsgemäßen heteroleptischen Carbenkomplexe als Farbstoffe in photovoltaischen Anordnungen zur Umwandlung elektromagnetischer Strahlung in elektrische Energie.

## Patentansprüche

1. Heteroleptische Carbenkomplexe der allgemeinen Formel (I)
M¹[carben]ₙ[het]ₘ (I)
enthaltend sowohl Carbenliganden als auch heterocyclische Nicht-Carbenliganden,
worin die Symbole die folgenden Bedeutungen aufweisen:
M¹ Metallatom ausgewählt aus der Gruppe bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, in jeder für das entsprechende Metallatom möglichen Oxidationsstufe;
n Zahl der Carbenliganden, wobei n in dem Fall, dass die Summe (n + m) = 2 ist, 1 bedeutet, und in dem Fall, dass die Summe (n + m) ≥ 3 ist, mindestens 2 bedeutet, wobei die Carbenliganden in dem Fall, wenn n mindestens 2 bedeutet, gleich oder verschieden sein können;
m Zahl der heterocyclischen Nicht-Carbenliganden, wobei m ≥ 1 ist, wobei die heterocyclischen Nicht-Carbenliganden in dem Fall, wenn m > 1 ist, gleich oder verschieden sein können;
wobei n und m von der Oxidationsstufe und Koordinationszahl des eingesetzten Metallatoms und von der Ladung der Liganden carben und het abhängig sind;
carben Carbenligand der allgemeinen Formel (11) 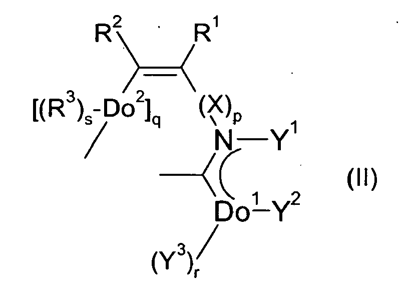 wobei die Symbole in dem Carbenliganden der allgemeinen Formel II die folgenden Bedeutungen aufweisen:
Do¹ Donoratom ausgewählt aus der Gruppe bestehend aus C, P, N, O, S und Si, bevorzugt P, N, O und S;
Do² Donoratom ausgewählt aus der Gruppe bestehend aus C, N, P, O und S;
r 2, wenn Do¹ C oder Si ist, 1, wenn Do¹ N oder P ist und 0, wenn Do¹ O oder S ist;
s 2, wenn Do² C ist, 1, wenn Do² N oder P ist und 0, wenn Do² O oder S ist;
X Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
w 2 bis 10;
R¹³, R¹⁴, R¹⁵, R¹⁶, R¹⁷ H, Alkyl, Aryl, Heteroaryl, Alkenyl, Alkinyl;
p 0 oder 1;
q 0 oder 1;
Y¹, Y² jeweils unabhängig voneinander Wasserstoff oder eine kohlenstoffhaltige Gruppe ausgewählt aus der Gruppe bestehend aus Alkyl-, Aryl-, Heteroaryl-, Alkinyl- und Alkenylgruppen;
oder
Y¹ und Y² bilden gemeinsam eine Brücke zwischen dem Donoratom Do¹ und dem Stickstoffatom N die mindestens zwei Atome aufweist, wovon mindestens eines ein Kohlenstoffatom ist,
R¹, R² unabhängig voneinander Wasserstoff, Alkyl-, Aryl-, Heteroaryl-, Alkinyl - oder Alkenylreste,
oder
R¹ und R² bilden gemeinsam eine Brücke mit insgesamt drei bis fünf Atomen, wovon 1 bis 5 Atome Heteroatome sein können und die restlichen Atome Kohlenstoffatome sind, so dass die Gruppe 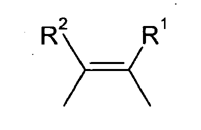 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann, und der fünf- bis siebengliedrige Ring gegebenenfalls mit einem oder mehreren weiteren Ringen anelliert sein kann;
weiterhin können Y¹ und R¹ über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹, H, Alkyl, Aryl, Heteroaryl, Alkenyl, Alkinyl
bedeuten;
R³ Wasserstoff, ein Alkyl-, Aryl-, Heteroaryl-, Alkinyl- oder Alkenylrest;
Y³ Wasserstoff, ein Alkyl-, Alkinyl- oder Alkenylrest,
oder 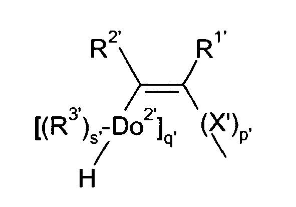 wobei Do^{2'}, q', s', R^{3'}, R^{1'}, R^{2'}, X' und p' unabhängig die gleichen Bedeutungen wie Do², q, s, R³, R¹, R², X und p aufweisen;
weiterhin können Y³ und Y² in jedem der n Carbenliganden über eine Brücke miteinander verknüpft sein, wobei die Brücke die folgenden Bedeutungen aufweisen kann:
Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
y 2 bis 10;
und
R²⁵ R²⁶, R²⁷, R²⁸, R²⁹, R³², R³³ H, Alkyl, Aryl, Heteroaryl, Alkenyl, Alkinyl
bedeuten;
und
het heterocyclischer Nicht-Carbenligand der allgemeinen Formel (III) 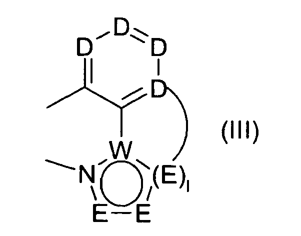 worin die Symbole in dem Liganden het der allgemeinen Formel III die folgenden Bedeutungen aufweisen:
D unabhängig voneinander CR³⁴ oder N;
W C, N, P;
E unabhängig voneinander CR³⁵, N, NR³⁶, S, O, P oder PR³⁷;
I 1 oder 2;
R³⁴, R³⁵, R³⁶, R³⁷ unabhängig voneinander H, ein Alkyl-, Aryl-, Heteroaryl-, Alkinyl- oder Alkenylrest, oder jeweils 2 Reste R³⁴, R³⁵, R³⁶ oder R³⁷ bilden gemeinsam einen anellierten Ring, der gegebenenfalls mindestens ein Heteroatom enthalten kann, oder R³⁴, R³⁵, R³⁶ oder R³⁷ bedeutet einen Rest mit Donor- oder Akzeptorwirkung;
wobei die gestrichelte Linie eine optionale Verbrückung zwischen einer der Gruppen D und einer der Gruppen E bedeutet; wobei die Verbrückung die folgenden Bedeutungen aufweisen kann:
Alkylen, Arylen, Heteroarylen, Alkinylen, Alkenylen, NR³⁸, PR³⁹, BR⁴⁰, O, S, SO, SO₂, SiR⁴¹R⁴², CO, CO-O, O-CO und (CR⁴³R⁴⁴)ᵥ, wobei eine oder mehrere nicht benachbarte Gruppen (CR⁴³R⁴⁴) durch NR³⁸, PR³⁹, BR⁴⁰, O, S, SO, SO₂, SiR⁴¹R⁴², CO, CO-O, O-CO ersetzt sein können, wobei
v 2 bis 10;
und
R³⁸, R³⁹, R⁴⁰, R⁴¹, R⁴², R⁴³, R⁴⁴ H, Alkyl, Aryl, Heteroaryl, Alkenyl, Alkinyl
bedeuten.

2. Carbenkomplexe nach Anspruch 1, **dadurch gekennzeichnet, dass** die Gruppierung 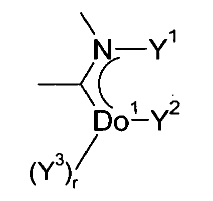 ausgewählt ist aus der Gruppe bestehend aus 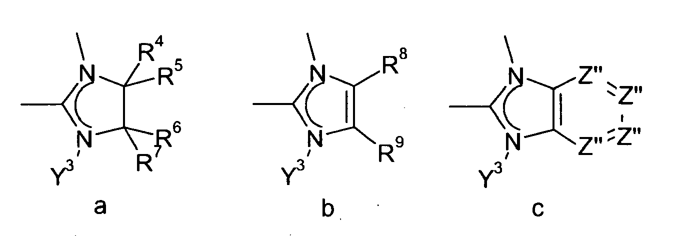 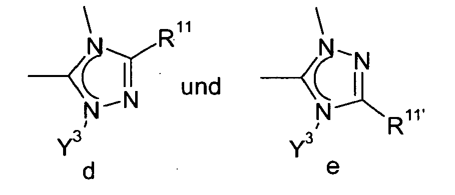 worin die Symbole die folgenden Bedeutungen aufweisen:
Z" unabhängig voneinander CR¹⁰ oder N;
R⁴, R⁵, R⁶, R⁷, R⁸, R⁹, R¹¹ und R^{11'} Wasserstoff, Alkyl, Aryl, Heteroaryl, Alkinyl oder Alkenyl oder ein Substituent mit Donor- oder Akzeptorwirkung;
R¹⁰ Wasserstoff, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom enthalten kann, oder R¹⁰ bedeutet einen Rest mit Donor- oder Akzeptorwirkung;
weiterhin können R⁴ oder R⁵ in der Gruppierung a, R⁸ in der Gruppierung b, einer der Reste R¹⁰ in der Gruppierung c und R¹¹ in der Gruppierung d mit R¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten.

3. Carbenkomplexe nach Anspruch 1 oder 2, **dadurch gekennzeichnet, dass** die Gruppierung 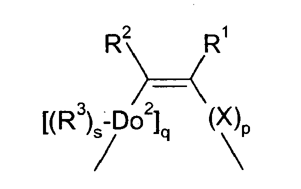 die Struktur 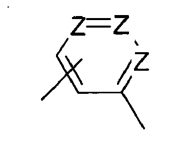 bedeutet,
worin die Symbole die folgenden Bedeutungen aufweisen:
Z unabhängig voneinander CR¹² oder N, wobei 0 bis 3 Symbole Z N bedeuten können;
R¹² in den Gruppen Z unabhängig voneinander H, ein Alkyl-, Aryl-, Heteroaryl-, Alkinyl-, Alkenylrest, oder jeweils 2 Reste R¹² bilden gemeinsam einen anellierten Ring, der gegebenenfalls mindestens ein Heteroatom enthalten kann, oder R¹² bedeutet einen Rest mit Donor- oder Akzeptorwirkung;
weiterhin kann die Gruppe der Struktur 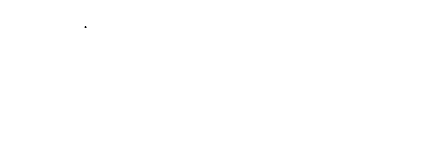 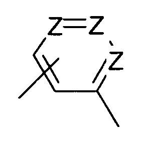 über den aromatischen Grundkörper oder über einen der Reste R¹² mit Y¹ über eine Brücke verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten.

4. Carbenkomplexe nach einem der Ansprüche 1 bis 3, **dadurch gekennzeichnet, dass** der mindestens eine Carbenligand ausgewählt ist aus der Gruppe bestehend aus 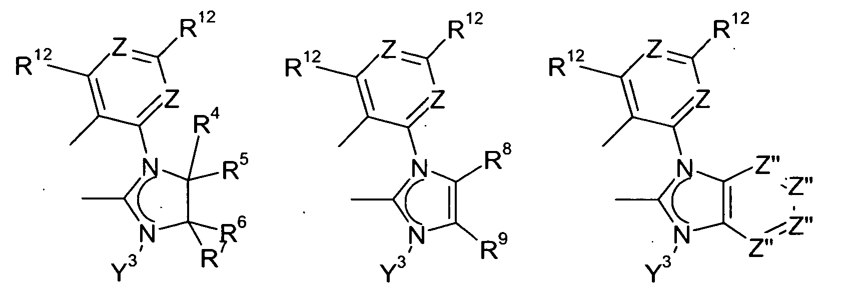 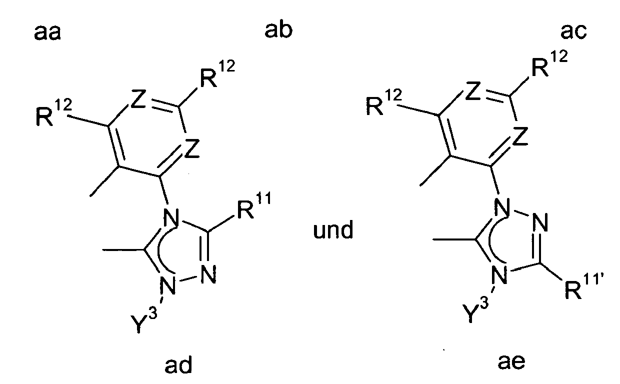 worin die Symbole die folgenden Bedeutungen aufweisen:
Y³ ein Alkyl-, Alkinyl- oder Alkenylrest
oder
eine Gruppe der folgenden Struktur 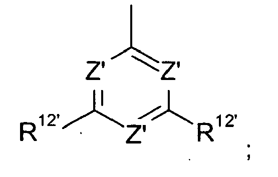
Z gleich oder verschieden CR¹² oder N;
Z' gleich oder verschieden CR^{12'} oder N;
Z" gleich oder verschieden CR¹⁰ oder N;
R¹² , R¹² gleich oder verschieden jeweils unabhängig voneinander H, ein Alkyl-, Aryl-, Heteroaryl-, Alkinyl- oder Alkenylrest, oder jeweils 2 Reste R¹² bzw. R^{12'} bilden gemeinsam einen anellierten Ring, der gegebenenfalls mindestens ein Heteroatom enthalten kann, oder R¹² bzw. R^{12'} bedeutet einen Rest mit Donor- oder Akzeptorwirkung;
R⁴, R⁵, R⁶, R⁷, R⁸, R⁹, R¹¹ und R^{11'} Wasserstoff, Alkyl, Aryl, Heteroaryl, Alkinyl oder Alkenyl oder ein Rest mit Donor- oder Akzeptorwirkung;
R¹⁰ in den Gruppen Z" unabhängig voneinander H, Alkyl, Aryl, Heteroaryl, Alkinyl oder Alkenyl oder jeweils 2 Reste R¹⁰ bilden gemeinsam einen anellierten Ring, der gegebenenfalls mindestens ein Heteroatom enthalten kann, oder R¹⁰ bedeutet einen Rest mit Donor- oder Akzeptorwirkung;
weiterhin kann die Gruppe der Struktur 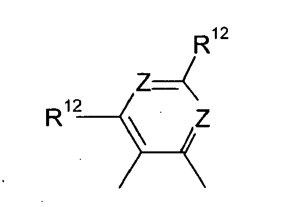 über den aromatischen Grundkörper oder über einen der Reste R¹² mit R⁴ oder R⁵ oder dem Kohlenstoffatom, mit dem R⁴ und R⁵ verknüpft sind, in der Gruppierung aa, R⁸ oder dem Kohlenstoffatom, mit dem R⁸ verknüpft ist, in der Gruppierung ab, einen der Reste R¹⁰ oder einem der Kohlenstoffatome, mit dem R¹⁰ verknüpft ist, in der Gruppierung ac und R¹¹ oder dem Kohlenstoffatom, mit dem R¹¹ verknüpft ist, in der Gruppierung ad über eine Brücke verknüpft sein;
und/oder
die Gruppe der Struktur 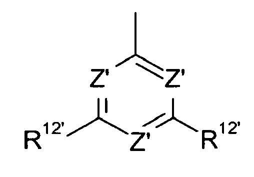 über den aromatischen Grundkörper oder über einen der Reste R^{12'} mit R⁶ oder R⁷ oder dem Kohlenstoffatom, mit dem R⁶ und R⁷ verknüpft sind, in der Gruppierung aa, R⁹ oder dem Kohlenstoffatom, mit dem R⁹ verknüpft ist, in der Gruppierung ab, einen der Reste R¹⁰ oder einem der Kohlenstoffatome, mit dem R¹⁰ verknüpft ist, in der Gruppierung ac und R^{11'} oder dem Kohlenstoffatom, mit dem R^{11'} verknüpft ist, in der Gruppierung ad über eine Brücke verknüpft sein;
wobei die jeweilige Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten;
wobei in den Fällen, worin die Gruppe der Struktur 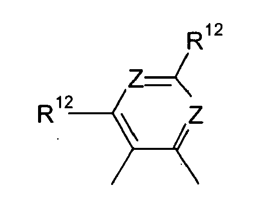 über eine Brücke mit dem Kohlenstoffatom, mit dem R⁴ und R⁵ verknüpft sind (Gruppierung aa), dem Kohlenstoffatom, mit dem R⁸ verknüpft ist (Gruppierung ab), einem der Kohlenstoffatome, mit dem R¹⁰ verknüpft ist (Gruppierung ac) oder dem Kohlenstoffatom, mit dem R¹¹ verknüpft ist (Gruppierung ad), verknüpft ist, der jeweilige Rest R⁴ oder R⁵, R⁸, einer der Reste R¹⁰ oder R¹¹ durch eine Bindung zu der Brücke ersetzt ist;
und in den Fällen, worin die Gruppe der Struktur 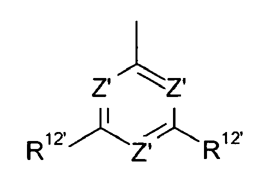 über eine Brücke mit dem Kohlenstoffatom, mit dem R⁶ und R⁷ verknüpft sind (Gruppierung aa), dem Kohlenstoffatom, mit dem R⁹ verknüpft ist (Gruppierung ab), einem der Kohlenstoffatome, mit dem R¹⁰ verknüpft ist (Gruppierung ac) oder dem Kohlenstoffatom, mit dem R^{11'} verknüpft ist (Gruppierung ad), verknüpft ist, der jeweilige Rest R⁶ oder R⁷, R⁹, einer der Reste R¹⁰ oder R^{11'} durch eine Bindung zu der Brücke ersetzt ist.

5. Carbenkomplexe nach einem der Ansprüche 1 bis 4, **dadurch gekennzeichnet, dass** der heterocyclische Nicht-Carbenligand het ausgewählt ist aus der Gruppe bestehend aus 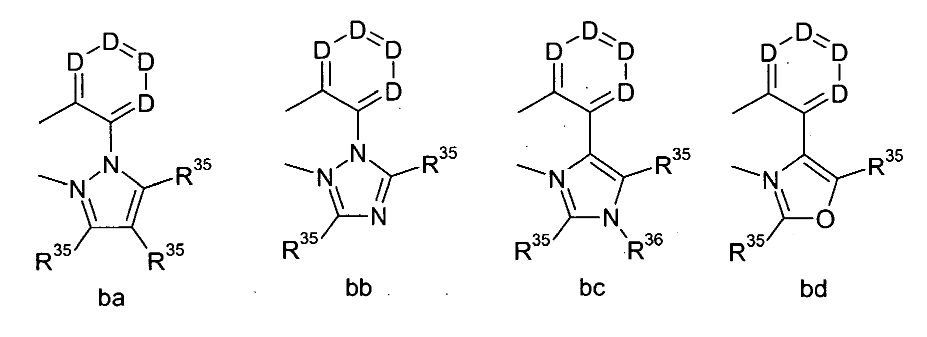 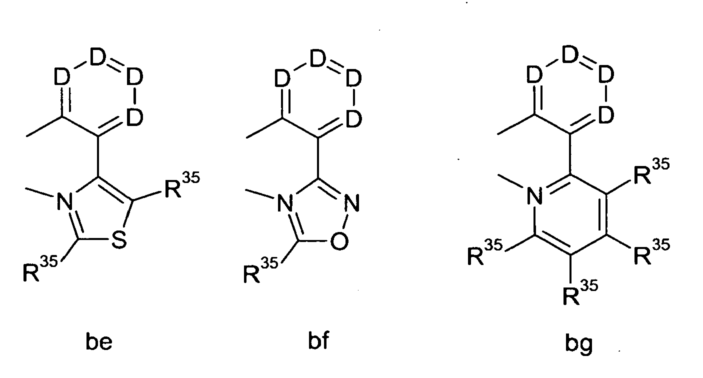 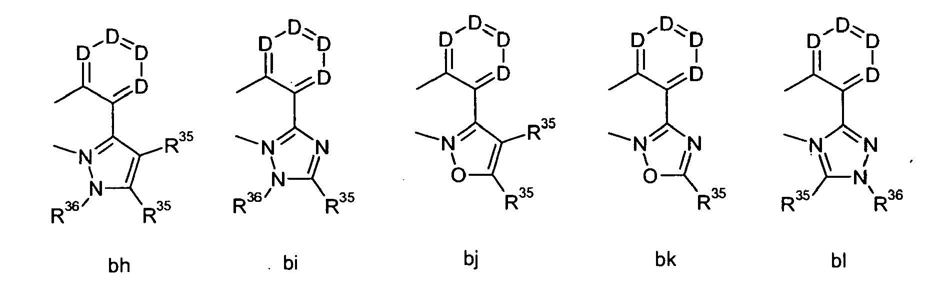 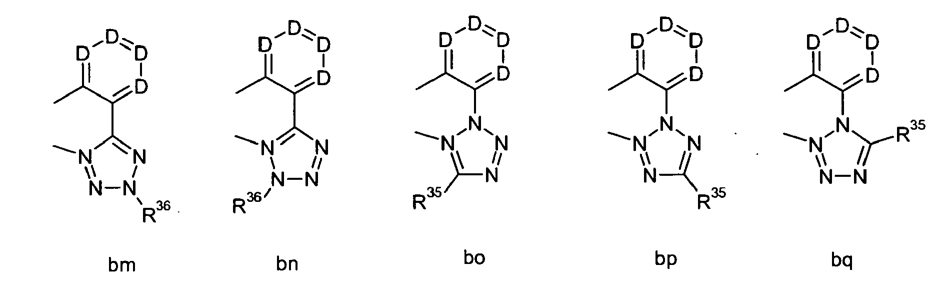 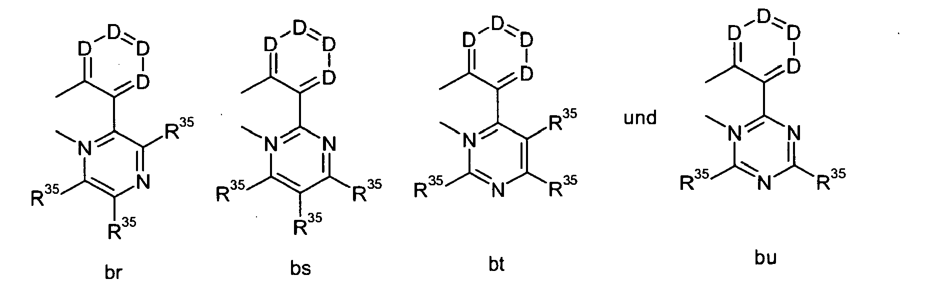 worin bedeuten:
D unabhängig voneinander CR³⁴ oder N;
R³⁴, R³⁵, R³⁶ unabhängig voneinander H, ein Alkyl-, Aryl-, Heteroaryl-, Alkinyl- oder Alkenylrest, oder jeweils 2 Reste R³⁴, R³⁵ oder R³⁶ bilden gemeinsam einen anellierten Ring, der gegebenenfalls mindestens ein Heteroatom enthalten kann, oder R³⁴, R³⁵ oder R³⁶ bedeutet einen Rest mit Donor- oder Akzeptorwirkung.

6. Carbenkomplexe nach einem der Ansprüche 1 bis 5, **dadurch gekennzeichnet, dass** M¹ Fe(II), Fe(III), Ru(II), Cr(III), Mo(VI), W(O), Re(II), Mn(II), Ir(III), Co(II), Co(III), Rh(III), Os(II), Pt(IV)) ist und n = 2 und m = 1 ist.

7. Carbenkomplexe nach Anspruch 6, **dadurch gekennzeichnet, dass** M¹ Ir(III) und n = 2 und m = 1 ist.

8. Carbenkomplexe nach Anspruch 7, **dadurch gekennzeichnet, dass** die Carbenkomplexe die allgemeine Formel (li) aufweisen: 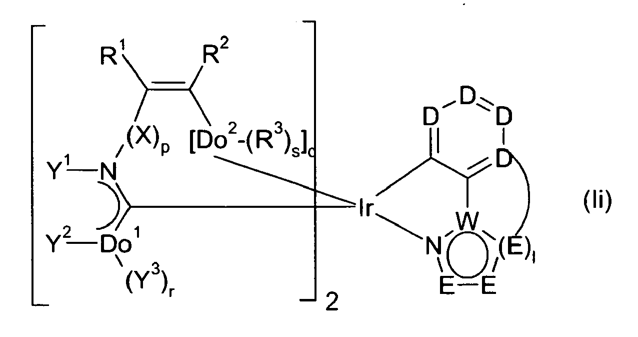 wobei die Symbole in den Carbenkomplexen der allgemeinen Formel (li) die folgenden Bedeutungen aufweisen:
Do¹ Donoratom ausgewählt aus der Gruppe bestehend aus C, P, N, O, S und Si, bevorzugt P, N, O und S;
Do² Donoratom ausgewählt aus der Gruppe bestehend aus C, N, P, O und S;
r 2, wenn Do¹ C oder Si ist, 1, wenn Do¹ N oder P ist und 0, wenn Do¹ O oder S ist;
s 2, wenn Do² C ist, 1, wenn Do² N oder P ist und 0, wenn Do² O oder S ist;
X Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
w 2 bis 10;
R¹³, R¹⁴, R¹⁵, R¹⁶, R¹⁷ H, Alkyl, Aryl, Heteroaryl, Alkenyl, Alkinyl;
p 0 oder 1;
q 0 oder 1;
Y¹, Y² jeweils unabhängig voneinander Wasserstoff oder eine kohlenstoffhaltige Gruppe ausgewählt aus der Gruppe bestehend aus Alkyl-, Aryl-, Heteroaryl-, Alkinyl- und Alkenylgruppen; oder
Y¹ und Y² bilden gemeinsam eine Brücke zwischen dem Donoratom Do¹ und dem Stickstoffatom N die mindestens zwei Atome aufweist, wovon mindestens eines ein Kohlenstoffatom ist,
R¹, R² unabhängig voneinander Wasserstoff, Alkyl-, Aryl-, Heteroaryl-, Alkinyl - oder Alkenylreste, oder
R¹ und R² bilden gemeinsam eine Brücke mit insgesamt drei bis fünf Atomen, wovon 1 bis 5 Atome Heteroatome sein können und die restlichen Atome Kohlenstoffatome sind, so dass die Gruppe 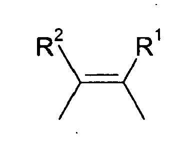 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann, und der fünf- bis siebengliedrige Ring gegebenenfalls mit einem oder mehreren weiteren Ringen anelliert sein kann;
weiterhin können Y¹ und R¹ über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹; CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten;
R³ Wasserstoff, ein Alkyl-, Aryl-, Heteroaryl-, Alkinyl- oder Alkenylrest;
Y³ Wasserstoff, ein Alkyl-, Alkinyl- oder Alkenylrest,
oder 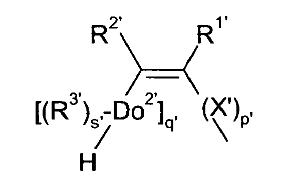 wobei Do^{2'}, q', s', R^{3'}, R^{1'}, R^{2'}, X' und p' unabhängig die gleichen Bedeutungen wie Do², q, s, R³, R¹, R², X und p aufweisen;
weiterhin können Y³ und Y² in jedem der n Carbenliganden über eine Brücke miteinander verknüpft sein, wobei die Brücke die folgenden Bedeutungen aufweisen kann:
Alkylen, Arylen, Heteroarylen, Alkinylen, Alkenylen, NR²⁵, PR²⁶, BR²⁷, O, S, SO, SO₂, SiR³²R³³, CO, CO-O, O-CO und (CR²⁸R²⁹)_{y}, wobei eine oder mehrere nicht benachbarte Gruppen (CR²⁸R²⁹) durch NR²⁵, PR²⁶, BR²⁷, O, S, SO, SO₂, SiR³²R³³, CO, CO-O, O-CO ersetzt sein können, wobei
y 2 bis 10;
und
R²⁵, R²⁶, R²⁷, R²⁸ R²⁹, R³², R³³ H, Alkyl, Aryl, Heteroaryl, Alkenyl, Alkinyl
bedeuten;
D unabhängig voneinander CR³⁴ oder N;
W C, N, P;
E unabhängig voneinander CR³⁵, N, NR³⁶, S, O, P oder PR³⁷;
I 1 oder 2;
R³⁴, R³⁵, R³⁶, R³⁷ unabhängig voneinander H, ein Alkyl-, Aryl-, Heteroaryl-, Alkinyl- oder Alkenylrest, oder jeweils 2 Reste R³⁴, R³⁵, R³⁶ oder R³⁷ bilden gemeinsam einen anellierten Ring, der gegebenenfalls mindestens ein Heteroatom enthalten kann, oder R³⁴, R³⁵, R³⁶ oder R³⁷ bedeutet einen Rest mit Donor- oder Akzeptorwirkung;
wobei die Reste, Gruppen und Indizes R¹, R², R³, Do¹, Do², Y¹, Y², Y³, X, p, q und r in den Carbenliganden in den Verbindungen der allgemeinen Formel li gleich oder verschieden sein können;
wobei die gestrichelte Linie eine optionale Verbrückung zwischen einer der Gruppen D und einer der Gruppen E bedeutet; wobei die Verbrückung die folgenden Bedeutungen aufweisen kann:
Alkylen, Arylen, Heteroarylen, Alkinylen, Alkenylen, NR³⁸, PR³⁹, BR⁴⁰, O, S, SO, SO₂, SiR⁴¹R⁴², CO, CO-O, O-CO und (CR⁴³R⁴4)ᵥ, wobei eine oder mehrere nicht benachbarte Gruppen (CR⁴³R⁴⁴) durch NR³⁸, PR³⁹, BR⁴⁰, O, S, SO, SO₂, SiR⁴¹R⁴², CO, CO-O, O-CO ersetzt sein können, wobei
v 2 bis 10;
und
R³⁸, R³⁹, R⁴⁰, R⁴¹, R⁴², R⁴³, R⁴⁴ H, Alkyl, Aryl, Heteroaryl, Alkenyl, Alkinyl
bedeuten.

9. Verfahren zur Herstellung von heteroleptischen Carbenkomplexen der allgemeinen Formel I nach einem der Ansprüche 1 bis 8, **dadurch gekennzeichnet, dass** die Herstellung den folgenden Schritt umfasst:
Umsetzung von mindestens einem Ligandvorläufer der allgemeinen Formel (IV) 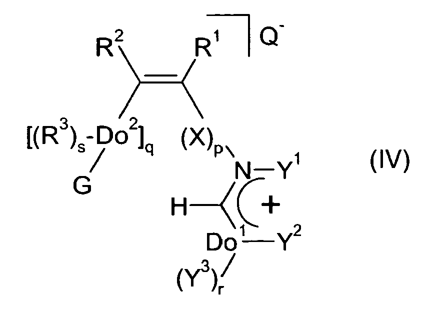 worin
Q- ein monoanionisches Gegenion, bevorzugt Halogenid, Pseudohalogenid, BF₄⁻, BPh₄⁻, PF₆⁻, AsF₆⁻ oder SbF₆⁻;
und
G wenn Do² = C oder q = 0 ist, H bedeutet, und wenn Do² = N, S, O oder P ist, H oder ein freies Elektronenpaar des Heteroatoms bedeutet;
bedeuten, und
die weiteren Symbole in dem Ligandvorläufer der allgemeinen Formel IV die folgenden Bedeutungen aufweisen:
Do¹ Donoratom ausgewählt aus der Gruppe bestehend aus C, P, N, O, S und Si, bevorzugt P, N, O und S;
Do² Donoratom ausgewählt aus der Gruppe bestehend aus C, N, P, O und S;
r 2, wenn Do¹ C oder Si ist, 1, wenn Do¹ N oder P ist und 0, wenn Do¹ O oder S ist;
s 2, wenn Do² C ist, 1, wenn Do² N oder P ist und 0, wenn Do² O oder S ist;
X Spacer ausgewählt aus der Gruppe bestehend aus Silylen, Alkylen, Arylen, Heteroarylen, Alkinylen, Alkenylen, NR¹³, PR¹⁴, BR¹⁵, O, S, SO, SO₂, CO, CO-O, O-CO und (CR¹⁶R¹⁷)_{w}, wobei eine oder mehrere nicht benachbarte Gruppen (CR¹⁶R¹⁷) durch NR¹³, PR¹⁴, BR¹⁵, O, S, SO, SO₂, CO, CO-O, O-CO ersetzt sein können;
w 2 bis 10;
R¹³, R¹⁴, R¹⁵, R¹⁶, R¹⁷ H, Alkyl, Aryl, Heteroaryl, Alkenyl, Alkinyl;
p 0 oder 1;
q 0 oder 1;
Y¹, Y² jeweils unabhängig voneinander Wasserstoff oder eine kohlenstoffhaltige Gruppe ausgewählt aus der Gruppe bestehend aus Alkyl-, Aryl-, Heteroaryl-, Alkinyl- und Alkenylgruppen; oder
Y¹ und Y² bilden gemeinsam eine Brücke zwischen dem Donoratom Do¹ und dem Stickstoffatom N die mindestens zwei Atome aufweist, wovon mindestens eines ein Kohlenstoffatom ist,
R¹, R² unabhängig voneinander Wasserstoff, Alkyl-, Aryl-, Heteroaryl-, Alkinyl - oder Alkenylreste,
oder
R¹ und R² bilden gemeinsam eine Brücke mit insgesamt drei bis fünf Atomen, wovon 1 bis 5 Atome Heteroatome sein können und die restlichen Atome Kohlenstoffatome sind, so dass die Gruppe 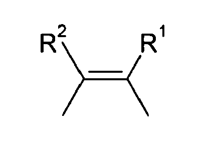 einen fünf- bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen und/oder Gruppen mit Donor- oder Akzeptorwirkung substituiert sein kann und gegebenenfalls mindestens ein Heteroatom enthalten kann und der fünf- bis siebengliedrige Ring gegebenenfalls mit einem oder mehreren weiteren Ringen anelliert sein kann.
weiterhin können Y¹ und R¹ über eine Brücke miteinander verknüpft sein, wobei die Brücke die folgenden Bedeutungen aufweisen kann:
Alkylen, Arylen, Heteroarylen, Alkinylen, Alkenylen, NR¹⁸, PR¹⁹, BR²⁰, O, S, SO, SO₂, SiR³⁰R³¹, CO, CO-O, O-CO und (CR²¹R²²)ₓ, wobei eine oder mehrere nicht benachbarte Gruppen (CR²¹R²²) durch NR¹⁸, PR¹⁹, BR²⁰, O, S, SO, SO₂, SiR³⁰R³¹, CO, CO-O, O-CO ersetzt sein können, wobei
x 2 bis 10;
und
R¹⁸, R¹⁹, R²⁰, R²¹, R²², R³⁰, R³¹ H, Alkyl, Aryl, Heteroaryl, Alkenyl, Alkinyl
bedeuten;
R³ Wasserstoff, ein Alkyl-, Aryl-, Heteroaryl-, Alkinyl- oder Alkenylrest;
Y³ Wasserstoff, ein Alkyl-, Alkinyl- oder Alkenylrest, oder 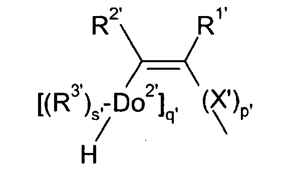
wobei Do^{2'}, q', s', R^{3'}, R^{1'}, R^{2'}, X' und p' unabhängig die gleichen Bedeutungen wie Do², q, s, R³, R¹, R², X und p aufweisen;
und
mindestens einem Ligandvorläufer der allgemeinen Formel V 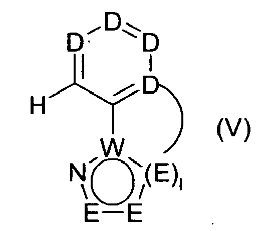 worin bedeuten:
D unabhängig voneinander CR³⁴ oder N;
W C, N, P;
E unabhängig voneinander CR³⁵, N, NR³⁶, S, O, P oder PR³⁷;
I 1 oder 2;
R³⁴, R³⁵, R³⁶, R³⁷ unabhängig voneinander H, ein Alkyl-, Aryl-, Heteroaryl-, Alkinyl- oder Alkenylrest, oder jeweils 2 Reste R³⁴, R³⁵, R³⁶ oder R³⁷ bilden gemeinsam einen anellierten Ring, der gegebenenfalls mindestens ein Heteroatom enthalten kann, oder R³⁴, R³⁵, R³⁶ oder R³⁷ bedeutet einen Rest mit Donor- oder Akzeptorwirkung;
mit einem Metallkomplex enthaltend mindestens ein Metall M^{1'}, wobei M^{1'} die folgenden Bedeutungen aufweist:
M¹ Metallatom ausgewählt aus der Gruppe bestehend aus Ir, Co, Rh, Ni, Pd, Pt, Fe, Ru, Os, Cr, Mo, W, Mn, Tc, Re, Cu und Au, bevorzugt Ir, Os, Ru, Rh, Pd, Co und Pt, besonders bevorzugt Ir, Pt, Rh und Os, in jeder für das entsprechende Metallatom möglichen Oxidationsstufe.

10. Verfahren nach Anspruch 9, **dadurch gekennzeichnet, dass** als Metall M^{1'} Ir, bevorzugt Ir(I) oder Ir(III) eingesetzt wird.

11. Verwendung von heteroleptischen Carbenkomplexen gemäß einem der Ansprüche 1 bis 8 oder hergestellt gemäß Anspruch 9 oder 10 in organischen Leuchtdioden.

12. Organische Leuchtdiode enthaltend mindestens einen heteroleptischen Carbenkomplex gemäß einem der Ansprüche 1 bis 8 oder hergestellt gemäß Anspruch 9 oder 10.

13. Licht-emittierende Schicht enthaltend mindestens einen heteroleptischen Carbenkomplex gemäß einem der Ansprüche 1 bis 8 oder hergestellt gemäß Anspruch 9 oder 10.

14. Organische Leuchtdiode enthaltend mindestens eine Licht-emittierende Schicht nach Anspruch 13.

15. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, Fahrzeugen sowie Zielanzeigen an Bussen und Bahnen enthaltend mindestens eine organische Leuchtdiode gemäß Anspruch 12 oder 14.

## Claims

1. A heteroleptic carbene complex of the general formula (I)
M¹[carbene]ₙ[het]ₘ (I)
comprising both carbene ligands and heterocyclic noncarbene ligands,
in which the symbols are each defined as follows:
M¹ is a metal atom selected from the group consisting of Ir, Co, Rh, Ni, Pd, Pt, Fe, Ru, Os, Cr, Mo, W, Mn, Tc, Re, Cu and Au, preferably Ir, Os, Ru, Rh, Pd, Co and Pt, more preferably Ir, Pt, Rh and Os, in any oxidation state possible for the corresponding metal atom;
n is the number of carbene ligands, where n, in the case that the sum of (n + m) = 2, is 1 and, in the case that the sum of (n + m) ≥ 3, is at least 2, where the carbene ligands in the case where n is at least 2 may be the same or different;
m is the number of heterocyclic noncarbene ligands, where m ≥ 1, where the heterocyclic noncarbene ligands may be the same or different in the case when m > 1;
where n and m are each dependent on the oxidation state and coordination number of the metal atom used and on the charge of the carbene and het ligands;
carbene is a carbene ligand of the general formula (II) 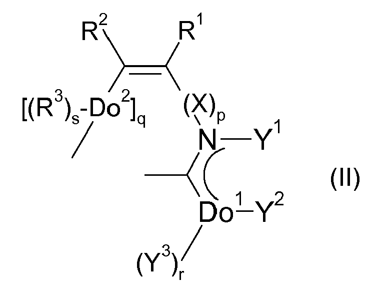 where the symbols in the carbene ligand of the general formula II are each defined as follows:
Do¹ is a donor atom selected from the group consisting of C, P, N, O, S and Si, preferably P, N, O and S;
Do² is a donor atom selected from the group consisting of C, N, P, O and S;
r is 2 when Do¹ is C or Si, is 1 when Do¹ is N or P, and is 0 when Do¹ is O or S;
s is 2 when Do² is C, is 1 when Do² is N or P, and is 0 when Do² is O or S;
X is a spacer selected from the group consisting of silylene, alkylene, arylene, heteroarylene, alkynylene, alkenylene, NR¹³, PR¹⁴, BR¹⁵, O, S, SO, SO₂, CO, CO-O, O-CO and (CR¹⁶R¹⁷)_{w}, where one or more nonadjacent (CR¹⁶R¹⁷) groups may be replaced by NR¹³, PR¹⁴, BR¹⁵, O, S, SO, SO₂, CO, CO-O, O-CO;
w is from 2 to 10;
R¹³, R¹⁴, R¹⁵, R¹⁶, R¹⁷ are each H, alkyl, aryl, heteroaryl, alkenyl, alkynyl;
p is 0 or 1;
q is 0 or 1;
Y¹, Y² are each independently hydrogen or a carbon group selected from the group consisting of alkyl, aryl, heteroaryl, alkynyl and alkenyl groups;
or
Y¹ and Y² together form a bridge between the donor atom Do¹ and the nitrogen atom N, said bridge having at least two atoms of which at least one is a carbon atom,
R¹, R² are each independently hydrogen, alkyl, aryl, heteroaryl, alkynyl or alkenyl radicals,
or
R¹ and R² together form a bridge having a total of from three to five atoms, of which from 1 to 5 atoms may be heteroatoms and the remaining atoms are carbon atoms, so that the group 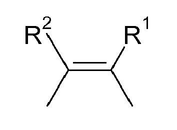 forms a five- to seven-membered ring which optionally - in addition to the double bond already present - may have one further double bond or - in the case of a six- or seven-membered ring - two further double bonds, and may optionally be substituted by alkyl or aryl groups and/or groups with donor or acceptor action, and may optionally comprise at least one heteroatom, and the five- to seven-membered ring may optionally be fused to one or more further rings;
in addition, Y¹ and R¹ may be bonded to one another via a bridge, where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹ are each H, alkyl, aryl, heteroaryl, alkenyl, alkynyl;
R³ is hydrogen, an alkyl, aryl, heteroaryl, alkynyl or alkenyl radical;
Y³ is hydrogen, an alkyl, alkynyl or alkenyl radical,
or 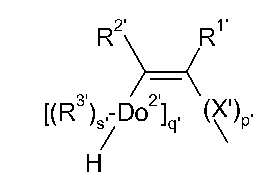 where Do^{2'}, q', s', R^{3'}, R^{1'}, R^{2'}, X' and p' are each independently as defined for Do², q, s, R³, R¹, R², X and p,
in addition, Y³ and Y² in each of the n carbene ligands may be bonded to one another via a bridge, where the bridge may be defined as follows:
alkylene, arylene, heteroarylene, alkynylene, alkenylene, NR²⁵, PR²⁶, BR²⁷, O, S, SO, SO₂, SiR³²R³³, CO, CO-O, O-CO and (CR²⁸R²⁹)_{y}, where one or more nonadjacent (CR²⁸R²⁹) groups may be replaced by NR²⁵, PR²⁶, BR²⁷, O, S, SO, SO₂, SiR³²R³³, CO, CO-O, O-CO, where
y is from 2 to 10;
and
R²⁵, R²⁶, R²⁷, R²⁸, R²⁹, R³², R³³ are each H, alkyl, aryl, heteroaryl, alkenyl, alkynyl;
and
het is a heterocyclic noncarbene ligand of the general formula (III) 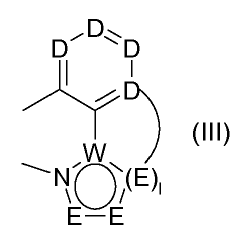 in which the symbols in the ligand het of the general formula III are each defined as follows:
D are each independently CR³⁴ or N;
W is C, N, P;
E are each independently CR³⁵, N, NR³⁶, S, O, P or PR³⁷;
I is 1 or 2;
R³⁴, R³⁵, R³⁶, R³⁷ are each independently H, an alkyl, aryl, heteroaryl, alkynyl or alkenyl radical, or in each case 2 R³⁴, R³⁵, R³⁶ or R³⁷ radicals together form a fused ring which may optionally comprise at least one heteroatom, or R³⁴, R³⁵, R³⁶, or R³⁷ is a radical having donor or acceptor action;
where the dotted line means an optional bridge between one of the D groups and one of the E groups; where the bridge may be defined as follows:
alkylene, arylene, heteroarylene, alkynylene, alkenylene, NR³⁸, PR³⁹, BR⁴⁰, O, S, SO, SO₂, SiR⁴¹R⁴², CO, CO-O, O-CO and (CR⁴³R⁴⁴)ᵥ, where one or more nonadjacent (CR⁴³R⁴⁴) groups may be replaced by NR³⁸, PR³⁹, BR⁴⁰, O, S, SO, SO₂, SiR⁴¹R⁴², CO, CO-O, O-CO, where
v is from 2 to 10;
and
R³⁸, R³⁹, R⁴⁰, R⁴¹, R⁴², R⁴³, R⁴⁴ are each H, alkyl, aryl, heteroaryl, alkenyl, alkynyl.

2. The carbene complex according to claim 1, wherein the moiety 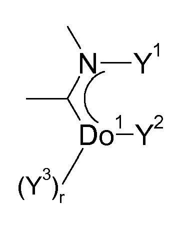 is selected from the group consisting of 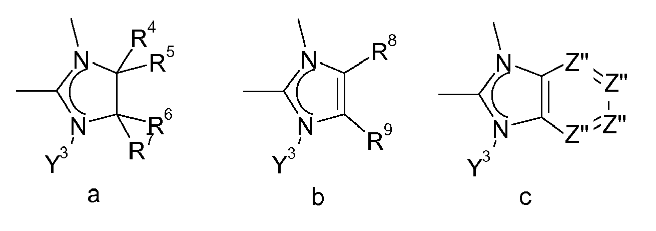 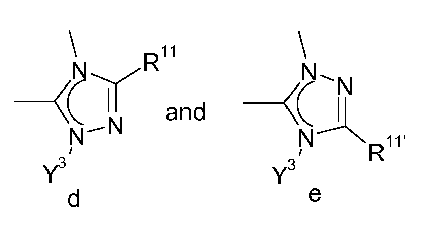 in which the symbols are each defined as follows:
Z" are each independently CR¹⁰ or N;
R⁴, R⁵, R⁶, R⁷, R⁸, R⁹, R¹¹ and R^{11'} are each hydrogen, alkyl, aryl, heteroaryl, alkynyl or alkenyl or a substituent with donor or acceptor action;
R¹⁰ is hydrogen, alkyl, aryl, heteroaryl, alkynyl or alkenyl, or in each case 2 R¹⁰ radicals together form a fused ring which may optionally comprise at least one heteroatom, or R¹⁰ is a radical with donor or acceptor action;
in addition, R⁴ or R⁵ in the moiety a, R⁸ in the moiety b, one of the R¹⁰ radicals in the moiety c and R¹¹ in the moiety d may be bonded to R¹ via a bridge, where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹ are each H, alkyl, aryl, heteroaryl, alkenyl, alkynyl.

3. The carbene complex according to claim 1 or 2, wherein the moiety 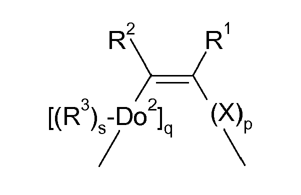 has the structure 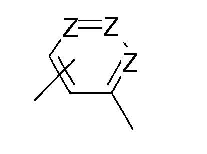 in which the symbols are each defined as follows:
Z are each independently CR¹² or N, where from 0 to 3 Z symbols may be N;
R¹² in the Z groups are each independently H, an alkyl, aryl, heteroaryl, alkynyl, alkenyl radical, or in each case 2 R¹² radicals together form a fused ring which may optionally comprise at least one heteroatom, or R¹² is a radical with donor or acceptor action;
in addition, the group of the structure 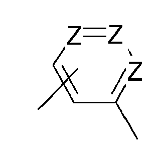 via the aromatic base structure or via one of the R¹² radicals, may be bonded to Y¹ via a bridge, where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸ R¹⁹, R²⁰, R²¹, R²², R³⁰, R³¹ are each H, alkyl, aryl, heteroaryl, alkenyl, alkynyl.

4. The carbene complex according to any of claims 1 to 3, wherein the at least one carbene ligand is selected from the group consisting of 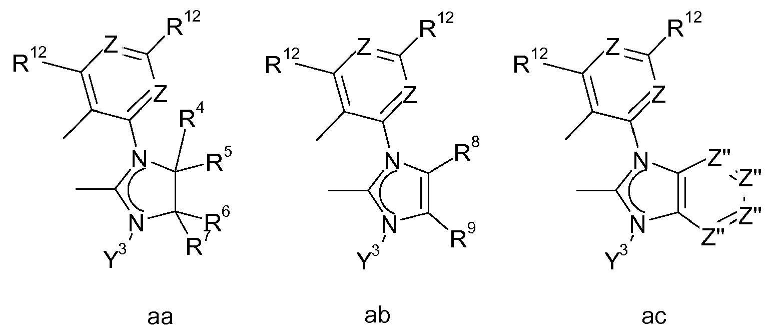 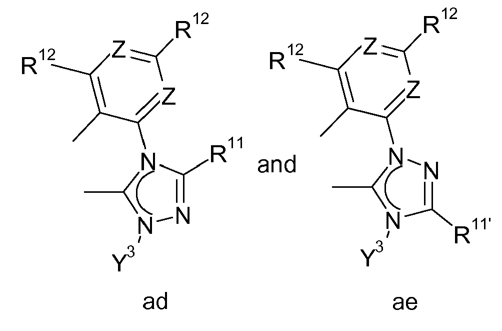 where the symbols are each defined as follows:
Y³ is an alkyl, alkynyl or alkenyl radical
or
a group of the following structure 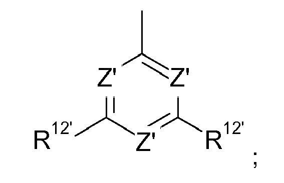
Z is the same or different and is CR¹² or N;
Z' is the same or different and is CR^{12'} or N;
Z" is the same or different and is CR¹⁰ or N;
R¹² , R^{12'} are the same or different and are each independently H, an alkyl, aryl, heteroaryl, alkynyl or alkenyl radical, or in each case 2 R¹² or R^{12'} radicals together form a fused ring which may optionally comprise at least one heteroatom, or R¹² or R^{12'} is a radical with donor or acceptor action;
R⁴, R⁵, R⁶, R⁷, R⁸, R⁹, R¹¹ and R^{11'} are each hydrogen, alkyl, aryl, heteroaryl, alkynyl or alkenyl, or a radical with donor or acceptor action;
R¹⁰ in the Z" groups are each independently H, alkyl, aryl, heteroaryl, alkynyl or alkenyl, or in each case 2 R¹⁰ radicals together form a fused ring which may optionally comprise at least one heteroatom, or R¹⁰ is a radical with donor or acceptor action;
in addition, the group of the structure 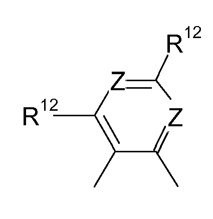 via the aromatic base structure or via one of the R¹² radicals, may be bonded via a bridge to R⁴ or R⁵ or the carbon atom to which R⁴ and R⁵ are bonded in the moiety aa, R⁸ or the carbon atom to which R⁸ is bonded in the moiety ab, one of the R¹⁰ radicals or one of the carbon atoms to which R¹⁰ is bonded in the moiety ac, and R¹¹ or the carbon atom to which R¹¹ is bonded in the moiety ad;
and/or
the group of the structure 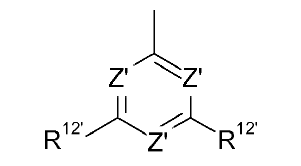 via the aromatic base structure or via one of the R^{12'} radicals, may be bonded via a bridge to R⁶ or R⁷ or the carbon atom to which R⁶ and R⁷ are bonded in the moiety aa, R⁹ or the carbon atom to which R⁹ is bonded in the moiety ab, one of the R¹⁰ radicals or one of the carbon atoms to which R¹⁰ is bonded in the moiety ac, and R^{11'} or the carbon atom to which R^{11'} is bonded in the moiety ad;
where the particular bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹ are each H, alkyl, aryl, heteroaryl, alkenyl, alkynyl;
where, in the cases in which the group of the structure 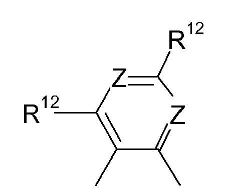 is bonded via a bridge to the carbon atom to which R⁴ and R⁵ are bonded (moiety aa), the carbon atom to which R⁸ is bonded (moiety ab), one of the carbon atoms to which R¹⁰ is bonded (moiety ac) or the carbon atom to which R¹¹ is bonded (moiety ad), the particular R⁴ or R⁵ radical, R⁸, one of the R¹⁰ radicals or R¹¹ is replaced by a bond to the bridge;
and, in the cases in which the group of the structure 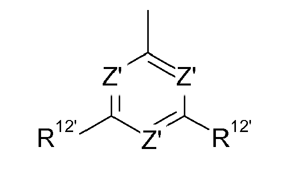 is bonded via a bridge to the carbon atom to which R⁶ and R⁷ are bonded (moiety aa), the carbon atom to which R⁹ is bonded (moiety ab), one of the carbon atoms to which R¹⁰ is bonded (moiety ac) or the carbon atom to which R^{11'} is bonded (moiety ad), the particular R⁶ or R⁷ radical, R⁹, one of the R¹⁰ radicals or R^{11'} is replaced by a bond to the bridge.

5. The carbene complex according to any of claims 1 to 4, wherein the heterocyclic noncarbene ligand het is selected from the group consisting of 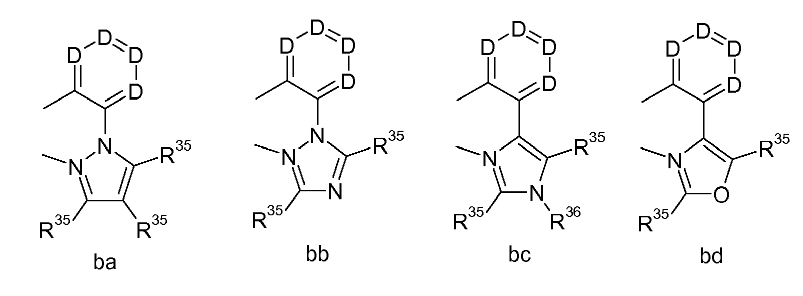 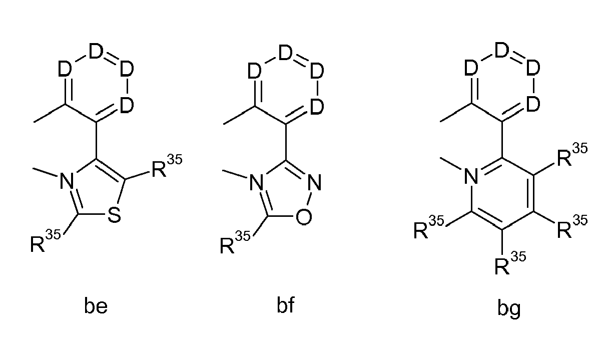 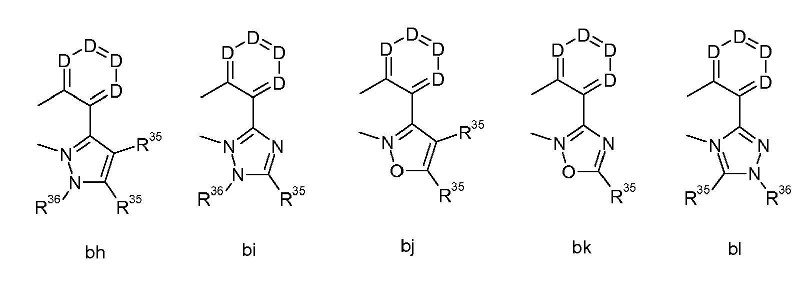 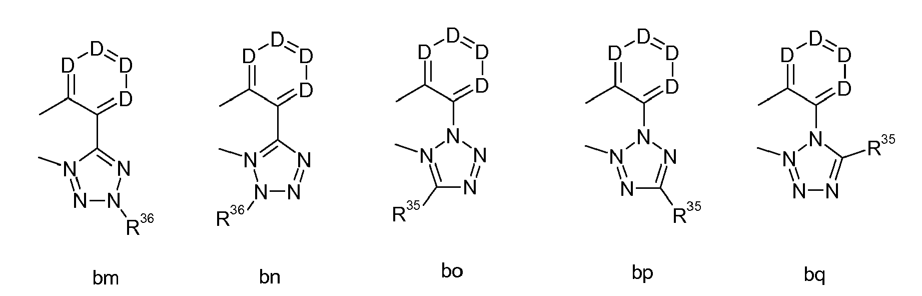 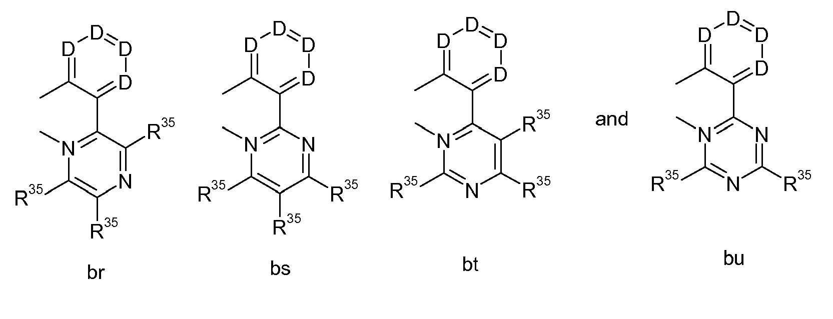 where
D are each independently CR³⁴ or N;
R³⁴, R³⁵, R³⁶ are each independently H, an alkyl, aryl, heteroaryl, alkynyl or alkenyl radical, or in each case 2 R³⁴, R³⁵ or R³⁶ radicals together form a fused ring which may optionally comprise at least one heteroatom, or R³⁴, R³⁵ or R³⁶ is a radical with donor or acceptor action.

6. The carbene complex according to any of claims 1 to 5, wherein M¹ is Fe(II), Fe(III), Ru(II), Cr(III), Mo(VI), W(0), Re(II), Mn(II), Ir(III), Co(II), Co(III), Rh(III), Os(II), Pt(IV), and n = 2 and m = 1.

7. The carbene complex according to claim 6, wherein M1 is Ir(III) and n = 2 and m=1.

8. The carbene complex according to claim 7, wherein the carbene complex has the general formula (Ii): 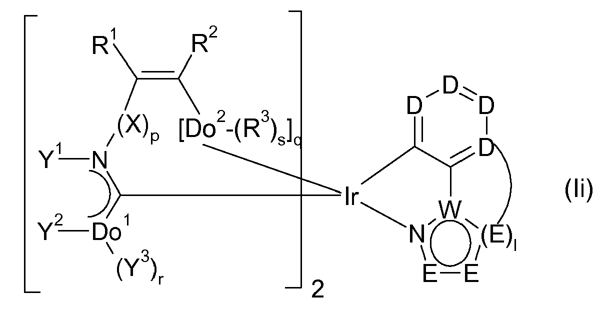 where the symbols in the carbene complexes of the general formula (Ii) are each defined as follows:
Do¹ is a donor atom selected from the group consisting of C, P, N, O, S and Si, preferably P, N, O and S;
Do² is a donor atom selected from the group consisting of C, N, P, O and S;
r is 2 when Do¹ is C or Si, is 1 when Do¹ is N or P, and is 0 when Do¹ is O or S;
s is 2 when Do² is C, is 1 when Do² is N or P, and is 0 when Do² is O or S;
X is a spacer selected from the group consisting of silylene, alkylene, arylene, heteroarylene, alkynylene, alkenylene, NR¹³, PR¹⁴, BR¹⁵, O, S, SO, SO₂, CO, CO-O, O-CO and (CR¹⁶R¹⁷)_{w}, where one or more nonadjacent (CR¹⁶R¹⁷) groups may be replaced by NR¹³, PR¹⁴, BR¹⁵, O, S, SO, SO₂, CO, CO-O, O-CO;
w is from 2 to 10;
R¹³, R¹⁴, R¹⁵, R¹⁶, R¹⁷ are each H, alkyl, aryl, heteroaryl, alkenyl, alkynyl;
p is 0 or 1;
q is 0 or 1;
Y¹, Y² are each independently hydrogen or a carbon group selected from the group consisting of alkyl, aryl, heteroaryl, alkynyl and alkenyl groups;
or
Y¹ and Y² together form a bridge between the donor atom Do¹ and the nitrogen atom N which has at least two atoms, of which at least one is a carbon atom,
R¹, R² are each independently hydrogen, alkyl, aryl, heteroaryl, alkynyl or alkenyl radicals,
or
R¹ and R² together form a bridge having a total of from three to five atoms, of which 1 to 5 atoms may be heteroatoms and the remaining atoms are carbon atoms, so that the group 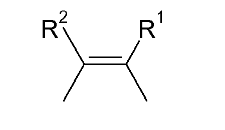 forms a five- to seven-membered ring which optionally - in addition to the double bond already present - may have one further double bond or - in the case of a six- or seven-membered ring - two further double bonds, and may optionally be substituted by alkyl or aryl groups and/or groups with donor or acceptor action, and may optionally comprise at least one heteroatom, and the five- to seven-membered ring may optionally be fused to one or more further rings;
in addition, Y¹ and R¹ may be bonded to one another via a bridge, where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹ are each H, alkyl, aryl, heteroaryl, alkenyl, alkynyl;
R³ is hydrogen, an alkyl, aryl, heteroaryl, alkynyl or alkenyl radical;
Y³ is hydrogen, an alkyl, alkynyl or alkenyl radical,
or 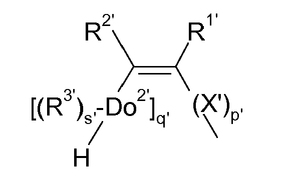 where Do^{2'}, q^{'}, s^{'}, R^{3'}, R^{1'}, R^{2'}, X^{'} and p^{'} are each independently as defined for Do², q, s, R³, R¹, R², X and p;
in addition, Y³ and Y² in each of the n carbene ligands may be bonded to one another via a bridge, where the bridge may be defined as follows:
alkylene, arylene, heteroarylene, alkynylene, alkenylene, NR²⁵, PR²⁶, BR²⁷, O, S, SO, SO₂, SiR³²R³³, CO, CO-O, O-CO and (CR²⁸R²⁹)_{y}, where one or more nonadjacent (CR²⁸R²⁹) groups may be replaced by NR²⁵, PR²⁶, BR²⁷, O, S, SO, SO₂, SiR³²R³³, CO, CO-O, O-CO, where
y is from 2 to 10;
and
R²⁵, R²⁶, R²⁷, R²⁸, R²⁹, R³², R³³ are each H, alkyl, aryl, heteroaryl, alkenyl, alkynyl;
D are each independently CR³⁴ or N;
W is C, N, P;
E are each independently CR³⁵, N, NR³⁶, S, O, P or PR³⁷;
I is 1 or 2;
R³⁴, R³⁵, R³⁶, R³⁷ are each independently H, an alkyl, aryl, heteroaryl, alkynyl or alkenyl radical, or in each case 2 R³⁴, R³⁵, R³⁶ or R³⁷ radicals together form a fused ring which may optionally comprise at least one heteroatom, or R³⁴, R³⁵, R³⁶ or R³⁷ is a radical with donor or acceptor action;
where the radicals, groups and indices R¹, R², R³, Do¹, Do², Y¹, Y², Y³, X, p, q and r in the carbene ligands in the compounds of the general formula Ii may each be the same or different;
where the dotted line means an optional bridge between one of the D groups and one of the E groups; where the bridge may be defined as follows:
alkylene, arylene, heteroarylene, alkynylene, alkenylene, NR³⁸, PR³⁹, BR⁴⁰, O, S, SO, SO₂, SiR⁴¹R⁴², CO, CO-O, O-CO and (CR⁴³R⁴⁴)ᵥ, where one or more nonadjacent (CR⁴³R⁴⁴) groups may be replaced by NR³⁸, PR³⁹, BR⁴⁰, O, S, SO, SO₂, SiR⁴¹R⁴², CO, CO-O, O-CO, where
v is from 2 to 10;
and
R³⁸ R³⁹, R⁴⁰, R⁴¹, R⁴², R⁴³, R⁴⁴ are each H, alkyl, aryl, heteroaryl, alkenyl, alkynyl.

9. A process for preparing heteroleptic carbene complexes of the general formula I according to any of claims 1 to 8, wherein the preparation comprises the following step:
reaction of at least one ligand precursor of the general formula (IV) 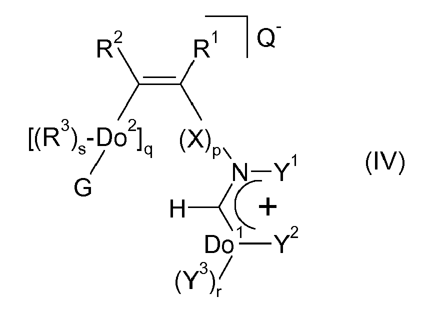 in which
Q- is a monoanionic counterion, preferably halide, pseudohalide, BF₄⁻, BPh₄⁻, PF₆⁻, AsF₆⁻ or SbF₆⁻;
and
G is H when Do² = C or q = 0, and
is H or is a free electron pair of the heteroatom when Do² = N, S, O or P;
and
the further symbols in the ligand precursor of the general formula IV are each defined as follows:
Do¹ is a donor atom selected from the group consisting of C, P, N, O, S and Si, preferably P, N, O and S;
Do² is a donor atom selected from the group consisting of C, N, P, O and S;
r is 2 when Do¹ is C or Si, is 1 when Do¹ is N or P, and is 0 when Do¹ is O or S;
s is 2 when Do² is C, is 1 when Do² is N or P, and is 0 when Do² is O or S;
X is a spacer selected from the group consisting of silylene, alkylene, arylene, heteroarylene, alkynylene, alkenylene, NR¹³, PR¹⁴, BR¹⁵, O, S, SO, SO₂, CO, CO-O, O-CO and (CR¹⁶R¹⁷)_{w}, where one or more nonadjacent (CR¹⁶R¹⁷) groups may be replaced by NR¹³, PR¹⁴, BR¹⁵, O, S, SO, SO₂, CO, CO-O, O-CO;
w is from 2 to 10;
R¹³, R¹⁴, R¹⁵, R¹⁶, R¹⁷ are each H, alkyl, aryl, heteroaryl, alkenyl, alkynyl;
p is 0 or 1;
q is 0 or 1;
Y¹, Y² are each independently hydrogen or a carbon group selected from the group consisting of alkyl, aryl, heteroaryl, alkynyl and alkenyl groups; or
Y¹ and Y² together form a bridge between the donor atom Do¹ and the nitrogen atom N, said bridge having at least two atoms of which at least one is a carbon atom,
R¹, R² are each independently hydrogen, alkyl, aryl, heteroaryl, alkynyl or alkenyl radicals, or
R¹ and R² together form a bridge having a total of from three to five atoms, of which from 1 to 5 atoms may be heteroatoms and the remaining atoms are carbon atoms, so that the group 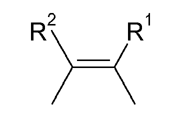 forms a five- to seven-membered ring which optionally - in addition to the double bond already present - may have one further double bond or - in the case of a six- or seven-membered ring - two further double bonds, and may optionally be substituted by alkyl or aryl groups and/or groups with donor or acceptor action, and may optionally comprise at least one heteroatom, and the five- to seven-membered ring may optionally be fused to one or more further rings;
in addition, Y¹ and R¹ may be bonded to one another via a bridge, where the bridge may be defined as follows:
alkylene, arylene, heteroarylene, alkynylene, alkenylene, NR¹⁸, PR¹⁹, BR²⁰, O, S, SO, SO₂, SiR³⁰R³¹, CO, CO-O, O-CO and (CR²¹R²²)ₓ, where one or more nonadjacent (CR²¹R²²) groups may be replaced by NR¹⁸, PR¹⁹, BR²⁰, O, S, SO, SO₂, SiR³⁰R³¹, CO, CO-O, O-CO, where
x is from 2 to 10;
and
R¹⁸, R¹⁹, R²⁰, R²¹, R²², R³⁰, R³¹ are each H, alkyl, aryl, heteroaryl, alkenyl, alkynyl;
R³ is hydrogen, an alkyl, aryl, heteroaryl, alkynyl or alkenyl radical;
Y³ is hydrogen, an alkyl, alkynyl or alkenyl radical, or 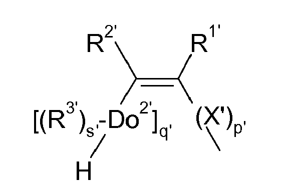 where Do^{2'}, q^{'}, s^{'}, R^{3'}, R^{1'}, R^{2'}, X^{'} and p^{'} are each independently as defined for Do², q, s, R³, R¹, R², X and p;
and
at least one ligand precursor of the general formula V 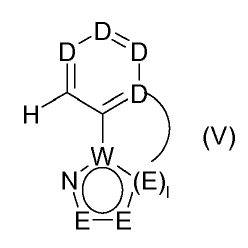 in which:
D are each independently CR³⁴ or N;
W is C, N, P;
E are each independently CR³⁵, N, NR³⁶, S, O, P or PR³⁷;
I is 1 or 2;
R³⁴, R³⁵, R³⁶, R³⁷ are each independently H, an alkyl, aryl, heteroaryl, alkynyl or alkenyl radical, or in each case 2 R³⁴, R³⁵, R³⁶ or R³⁷ radicals together form a fused ring which may optionally comprise at least one heteroatom, or R³⁴, R³⁵, R³⁶ or R³⁷ is a radical with donor or acceptor action;
with a metal complex comprising at least one metal M^{1'}, where M^{1'} is defined as follows:
M^{1'} is a metal atom selected from the group consisting of Ir, Co, Rh, Ni, Pd, Pt, Fe, Ru, Os, Cr, Mo, W, Mn, Tc, Re, Cu and Au, preferably Ir, Os, Ru, Rh, Pd, Co and Pt, more preferably Ir, Pt, Rh and Os, in any oxidation state possible for the corresponding metal atom.

10. The process according to claim 9, wherein the metal M^{1'} used is Ir, preferably Ir(I) or Ir(III).

11. The use of heteroleptic carbene complexes according to any of claims 1 to 8 or prepared according to claim 9 or 10 in organic light-emitting diodes.

12. An organic light-emitting diode comprising at least one heteroleptic carbene complex according to any of claims 1 to 8 or prepared according to claim 9 or 10.

13. A light-emitting layer comprising at least one heteroleptic carbene complex according to any of claims 1 to 8 or prepared according to claim 9 or 10.

14. An organic light-emitting diode comprising at least one light-emitting layer according to claim 13.

15. A device selected from the group consisting of stationary visual display units such as visual display units of computers, televisions, visual display units in printers, kitchen appliances and advertising panels, illuminations, information panels and mobile visual display units such as visual display units in cell phones, laptops, digital cameras, vehicles and destination displays on buses and trains, comprising at least one organic light-emitting diode according to claim 12 or 14.

## Revendications

1. Complexes de carbène hétéroleptiques de formule générale (I)
M¹[carbène]ₙ[hét]ₘ (I)
contenant aussi bien des ligands carbène que des ligands non carbène hétérocycliques
les symboles présentant les significations suivantes:
M¹ atome métallique choisi dans le groupe constitué par Ir, Co, Rh, Ni, Pd, Pt, Fe, Ru, Os, Cr, Mo, W, Mn, Tc, Re, Cu et Au, de préférence Ir, Os, Ru, Rh, Pd, Co et Pt, de manière particulièrement préférée Ir, Pt, Rh et Os, à chaque degré d'oxydation possible pour l'atome métallique correspondant ;
n nombre de ligands carbène, n signifiant 1 lorsque la somme (n+m) = 2 et signifiant au moins 2 lorsque la somme (n+m) ≥ 3, les ligands carbène pouvant être identiques ou différents lorsque n signifie au moins 2 ;
m nombre de ligands non carbène hétérocycliques, avec m ≥ 1, les ligands non carbène hétérocycliques pouvant être identiques ou différents lorsque m > 1 ;
n et m étant dépendants du degré d'oxydation et de l'indice de coordination de l'atome métallique utilisé et de la charge des ligands carbène et hét ;
carbène ligand carbène de formule générale (II) 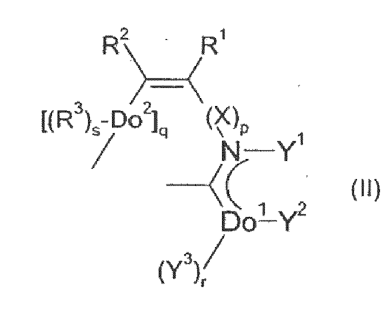 les symboles dans le ligand carbène de formule générale II présentant les significations suivantes:
Do¹ atome donneur choisi dans le groupe constitué par C, P, N, 0, S et Si, de préférence P, N, 0 et S ;
Do² atome donneur choisi dans le groupe constitué par C, N, P, 0 et S ;
r 2 lorsque Do¹ est C ou Si, 1 lorsque Do¹ est N ou P, et 0 lorsque Do¹ est 0 ou S ;
s 2 lorsque Do² est C, 1 lorsque Do² est N ou P, et 0 lorsque Do² est 0 ou S ;
X espaceur choisi dans le groupe constitué par silylène, alkylène, arylène, hétéroarylène, alcynylène, alcénylène, NR¹³, PR¹⁴, BR¹⁵, O, S, SO, SO₂, CO, CO-O-, O-CO et (CR¹⁶R¹⁷)_{w}, un ou plusieurs groupes (CR¹⁶R¹⁷) non voisins pouvant être remplacés par NR¹³, PR¹⁴, BR¹⁵, O, S, SO, SO₂, CO, CO-O-, O-CO;
w 2 à 10 ;
R¹³, R¹⁴, R¹⁵, R¹⁶, R¹⁷ H, alkyle, aryle, hétéroaryle, alcényle, alcynyle;
p 0 ou 1;
q 0 ou 1;
Y¹, Y² à chaque fois indépendamment l'un de l'autre hydrogène ou un groupe carboné choisi dans le groupe constitué par les groupes alkyle, aryle, hétéroaryle, alcynyle et alcényle;
ou
Y¹ et Y² forment ensemble un pont entre l'atome donneur Do¹ et l'atome d'azote N qui comprend au moins deux atomes, parmi lesquels au moins un est un atome de carbone,
R¹, R² indépendamment l'un de l'autre hydrogène, radicaux alkyle, aryle, hétéroaryle, alcynyle ou alcényle,
ou
R¹ et R² forment ensemble un pont contenant au total trois à cinq atomes, parmi lesquels 1 à 5 atomes peuvent être des hétéroatomes et les atomes restants sont des atomes de carbone, de manière à ce que le groupe 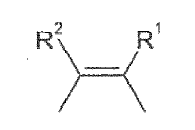 forme un cycle de cinq à sept éléments, qui peut éventuellement comprendre, en plus de la double liaison déjà présente, une, ou dans le cas d'un cycle à six ou sept éléments, deux doubles liaisons supplémentaires et qui peut éventuellement être substitué avec des groupes alkyle ou aryle et/ou des groupes à effet donneur ou accepteur et qui peut éventuellement contenir au moins un hétéroatome, le cycle de cinq à sept éléments pouvant éventuellement être annelé avec un ou plusieurs cycles supplémentaires ;
Y¹ et R¹ pouvant également être reliés l'un à l'autre par un pont, le pont pouvant présenter les significations suivantes:
alkylène, arylène, hétéroarylène, alcynylène, alcénylène, NR¹⁸, PR¹⁹, BR²⁰, 0, S, SO, SO₂, SiR³⁰R³¹, CO, CO-O-, O-CO et (CR²¹R²²)ₓ, un ou plusieurs groupes (CR²¹R²²) non voisins pouvant être remplacés par NR¹⁸, PR¹⁹, BR²⁰, O, S, SO, SO₂, SiR³⁰R³¹, CO, CO-O-, O-CO,
x signifiant 2 à 10;
et
R¹⁸, R¹⁹, R²⁰, R²¹, R²², R³⁰, R³¹ signifiant H, alkyle, aryle, hétéroaryle, alcényle, alcynyle;
R³ hydrogène, un radical alkyle, aryle, hétéroaryle, alcynyle ou alcényle;
Y³ hydrogène, un radical alkyle, alcynyle ou alcényle,
ou 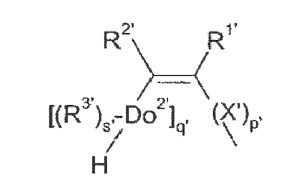 Do^{2'}, q', s', R^{3'}, R^{1'}, R^{2'}, X' et p' présentant indépendamment les mêmes significations que Do², q, s, R³, R¹, R², X et p;
Y³ et Y² pouvant également dans chacun des n ligands carbène être reliés l'un à l'autre par un pont, le pont pouvant présenter les significations suivantes:
alkylène, arylène, hétéroarylène, alcynylène, alcénylène, NR²⁵, PR²⁶, BR²⁷, O, S, SO, SO₂, SiR³²R³³, CO, CO-O-, O-CO et (CR²⁸R²⁹)_{y}, un ou plusieurs groupes (CR²⁸R²⁹) non voisins pouvant être remplacés par NR²⁵, PR26, BR²⁷, O, S, SO, SO₂, SiR³²R³³, CO, CO-O-, O-CO,
y signifiant 2 à 10 ;
et
R²⁵, R²⁶, R²⁷, R²⁸, R²⁹, R³², R³³ signifiant H, alkyle, aryle, hétéroaryle, alcényle, alcynyle;
et
hét ligand non carbène hétérocyclique de formule générale (III) 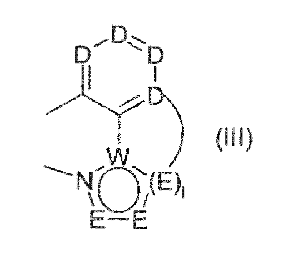
les symboles dans le ligand hét de formule générale III présentant les significations suivantes:
D indépendamment les uns des autres CR³⁴ ou N;
W C, N, P ;
E indépendamment les uns des autres CR³⁵, N, NR³⁶, S, 0, P ou PR³⁷;
1 1 ou 2;
R³⁴, R³⁵, R³⁶, R³⁷ indépendamment les uns des autres H, un radical alkyle, aryle, hétéroaryle, alcynyle ou alcényle, ou 2 radicaux R³⁴, R³⁵, R³⁶ ou R³⁷ forment respectivement ensemble un cycle annelé, qui peut éventuellement contenir au moins un hétéroatome, ou R³⁴, R³⁵, R³⁶ ou R³⁷ signifie un radical à effet donneur ou accepteur;
la ligne en pointillé signifiant un pontage optionnel entre un des groupes D et un des groupes E ; le pontage pouvant présenter les significations suivantes:
alkylène, arylène, hétéroarylène, alcynylène, alcénylène, NR³⁸, PR³⁹, BR⁴⁰, 0, S, SO, SO₂, SiR⁴¹R⁴², CO, CO-O-, O-CO et (CR⁴³R⁴⁴)ᵥ, un ou plusieurs groupes (CR⁴³R⁴⁴) non voisins pouvant être remplacés par NR³⁸, PR³⁹_{,} BR⁴⁰, O, S, SO, SO₂, SiR⁴¹R⁴², CO, CO-O-, O-CO,
v signifiant 2 à 10 ;
et
R³⁸, R³⁹, R⁴⁰, R⁴¹, R⁴², R⁴³, R⁴⁴ signifiant H, alkyle, aryle, hétéroaryle, alcényle, alcynyle.

2. Complexes de carbène selon la revendication 1, **caractérisés en ce que** le groupe 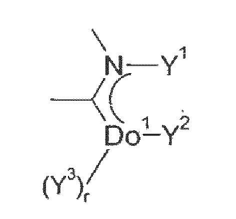 est choisi dans le groupe constitué par 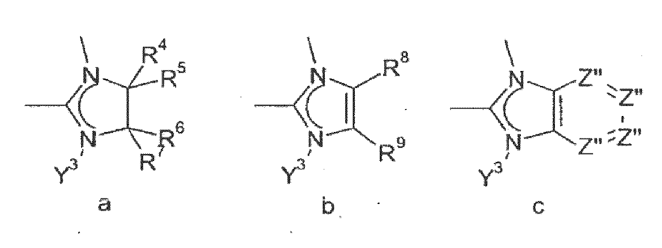 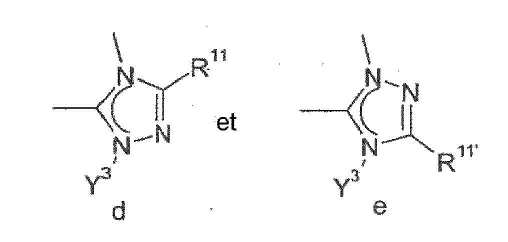 les symboles présentant les significations suivantes :
Z" indépendamment les uns des autres CR¹⁰ ou N ;
R⁴, R⁵, R⁶, R⁷, R⁸, R⁹, R¹¹ et R¹¹, hydrogène, alkyle, aryle, hétéroaryle, alcynyle ou alcényle ou un substituant à effet donneur ou accepteur;
R¹⁰ hydrogène, alkyle, aryle, hétéroaryle, alcynyle ou alcényle ou 2 radicaux R¹⁰ forment respectivement ensemble un cycle annelé, qui peut éventuellement contenir au moins un hétéroatome, ou R¹⁰ signifie un radical à effet donneur ou accepteur;
R⁴ ou R⁵ dans le groupe a, R⁸ dans le groupe b, un des radicaux R¹⁰ dans le groupe c et R¹¹ dans le groupe d pouvant également être reliés avec R¹ par un pont, le pont pouvant présenter les significations suivantes: alkylène, arylène, hétéroarylène, alcynylène, alcénylène, NR¹⁸, PR¹⁹, BR²⁰, 0, S, SO, SO₂, SiR³⁰R³¹, CO, CO-O-, O-CO et (CR²¹R²²)ₓ, un ou plusieurs groupes (CR²¹R²²) non voisins pouvant être remplacés par NR¹⁸, PR¹⁹, BR²⁰, O, S, SO, SO₂, SiR³⁰R³¹, CO, CO-O-, O-CO,
x signifiant 2 à 10;
et
R¹⁸, R¹⁹, R²⁰, R²¹, R²², R³⁰, R³¹ signifiant H, alkyle, aryle, hétéroaryle, alcényle, alcynyle.

3. Complexes de carbène selon la revendication 1 ou 2, **caractérisés en ce que** le groupe 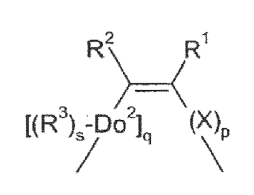 signifie la structure 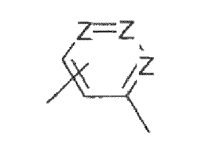 dans laquelle les symboles présentent les significations suivantes:
Z indépendamment les uns des autres CR¹² ou N, 0 à 3 symboles Z pouvant signifier N ;
R¹² dans les groupes Z, indépendamment les uns des autres H, un radical alkyle, aryle, hétéroaryle, alcynyle, alcényle, ou 2 radicaux R¹² forment respectivement ensemble un cycle annelé, qui peut éventuellement contenir au moins un hétéroatome, ou R¹² signifie un radical à effet donneur ou accepteur;
le groupe de structure 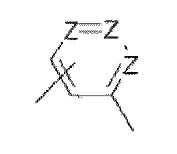 pouvant également être relié par le corps de base aromatique ou par un des radicaux R¹² avec Y¹ par un pont, le pont pouvant présenter les significations suivantes :
alkylène, arylène, hétéroarylène, alcynylène, alcénylène, NR¹⁸, PR¹⁹, BR²⁰, O, S, SO, SO₂, SiR³⁰R³¹, CO, CO-O-, O-CO et (CR²¹R ²²)ₓ, un ou plusieurs groupes (CR²¹R²²) non voisins pouvant être remplacés par NR¹⁸, PR¹⁹, BR²⁰, O, S, SO, SO₂, SiR³⁰R³¹, CO, CO-O-, O-CO,
x signifiant 2 à 10 ;
et
R¹⁸, R¹⁹, R²⁰, R²¹, R²², R³⁰, R³¹ signifiant H, alkyle, aryle, hétéroaryle, alcényle, alcynyle.

4. Complexes de carbène selon l'une quelconque des revendications 1 à 3, **caractérisés en ce que** le ou les ligands carbène sont choisis dans le groupe constitué par 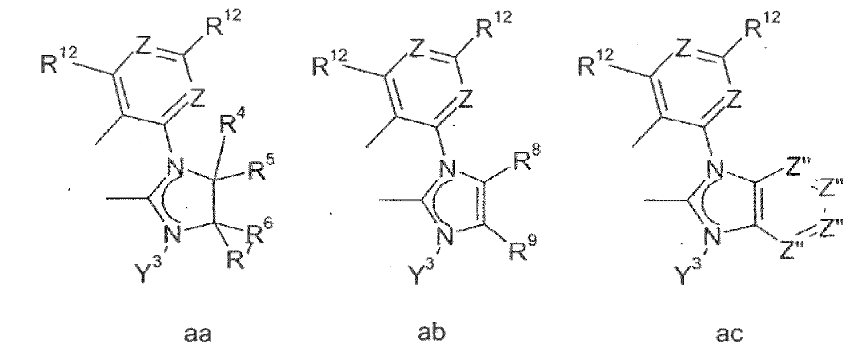 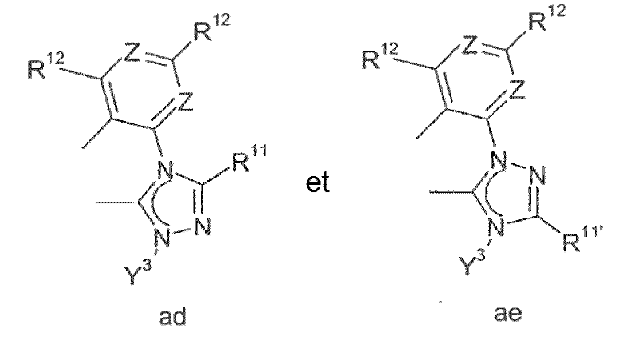 les symboles présentant les significations suivantes :
Y³ un radical alkyle, alcynyle ou alcényle ou
un groupe de la structure suivante 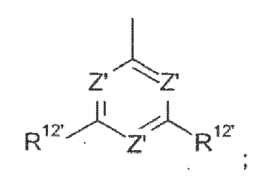
Z identiques ou différents, CR¹² ou N ;
Z' identiques ou différents, CR^{12'} ou N ;
Z" identiques ou différents, CR¹⁰ ou N ;
R¹², R^{12'} identiques ou différents, à chaque fois indépendamment l'un de l'autre H, un radical alkyle, aryle, hétéroaryle, alcynyle ou alcényle, ou 2 radicaux R¹² ou R^{12'} forment respectivement ensemble un cycle annelé, qui peut éventuellement contenir au moins un hétéroatome, ou R¹² ou R^{12'} signifie un radical à effet donneur ou accepteur ;
R⁴, R⁵, R⁶, R⁷, R⁸, R⁹, R¹¹ et R^{11'} hydrogène, alkyle, aryle, hétéroaryle, alcynyle ou alcényle ou un radical à effet donneur ou accepteur ;
R¹⁰ dans les groupes Z", indépendamment les uns des autres, H, alkyle, aryle, hétéroaryle, alcynyle ou alcényle ou 2 radicaux R¹⁰ forment respectivement ensemble un cycle annelé, qui peut éventuellement contenir au moins un hétéroatome, ou R¹⁰ signifie un radical à effet donneur ou accepteur ;
le groupe de structure 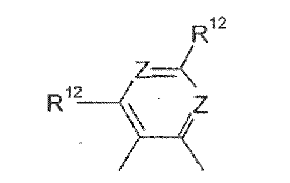 pouvant également être relié par le corps de base aromatique ou par un des radicaux R¹² avec R⁴ ou R⁵ ou l'atome de carbone avec lequel R⁴ et R⁵ sont reliés, dans le groupe aa, R⁸ ou l'atome de carbone avec lequel R⁸ est relié, dans le groupe ab, un des radicaux R¹⁰ ou un des atomes de carbone avec lesquels R¹⁰ est relié, dans le groupe ac, et R¹¹ ou l'atome de carbone avec lequel R¹¹ est relié, dans le groupe ad, par un pont ; et/ou
le groupe de structure 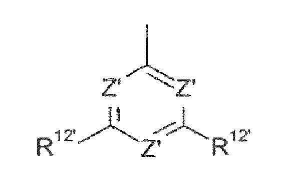 pouvant également être relié par le corps de base aromatique ou par un des radicaux R^{12'} avec R⁶ ou R⁷ ou l'atome de carbone avec lequel R⁶ et R⁷ sont reliés, dans le groupe aa, R⁹ ou l'atome de carbone avec lequel R⁹ est relié, dans le groupe ab, un des radicaux R¹⁰ ou un des atomes de carbone avec lesquels R¹⁰ est relié, dans le groupe ac, et R^{11'} ou l'atome de carbone avec lequel R^{11'} est relié, dans le groupe ad, par un pont ; les ponts respectifs pouvant présenter les significations suivantes :
alkylène, arylène, hétéroarylène, alcynylène, alcénylène, NR¹⁸, PR¹⁹, BR²⁰, O, S, SO, SO₂, SiR³⁰R³¹, CO, CO-O-, O-CO et (CR²¹R²²)ₓ, un ou plusieurs groupes (CR²¹R²²) non voisins pouvant être remplacés par NR¹⁸, PR¹⁹, BR²⁰, O, S, SO, SO₂, SiR³⁰R³¹, CO, CO-O-, O-CO,
x signifiant 2 à 10 ;
et
R¹⁸, R¹⁹, R²⁰, R²¹, R²², R³⁰, R³¹ signifiant H, alkyle, aryle, hétéroaryle, alcényle, alcynyle ;
lorsque le groupe de structure 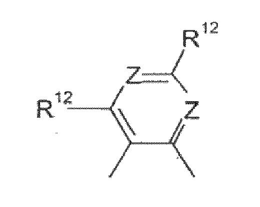 est relié par un pont avec l'atome de carbone avec lequel R⁴ et R⁵ sont reliés (groupe aa), l'atome de carbone avec lequel R⁸ est relié (groupe ab), un des atomes de carbone avec lesquels R¹⁰ est relié (groupe ac), ou l'atome de carbone avec lequel R¹¹ est relié (groupe ad), le radical respectif R⁴ ou R⁵, R⁸, un des radicaux R¹⁰ ou R¹¹ étant remplacé par une liaison au pont ;
et lorsque le groupe de structure 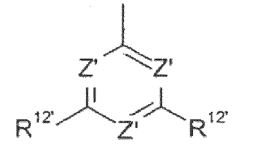 est relié par un pont avec l'atome de carbone avec lequel R⁶ et R⁷ sont reliés (groupe aa), l'atome de carbone avec lequel R⁹ est relié (groupe ab), un des atomes de carbone avec lesquels R¹⁰ est relié (groupe ac), ou l'atome de carbone avec lequel R^{11'} est relié (groupe ad), le radical respectif R⁶ ou R⁷, R⁹, un des radicaux R¹⁰ ou R^{11'} étant remplacé par une liaison au pont.

5. Complexes de carbène selon l'une quelconque des revendications 1 à 4, **caractérisés en ce que** le ligand non carbène hétérocyclique hét est choisi dans le groupe constitué par 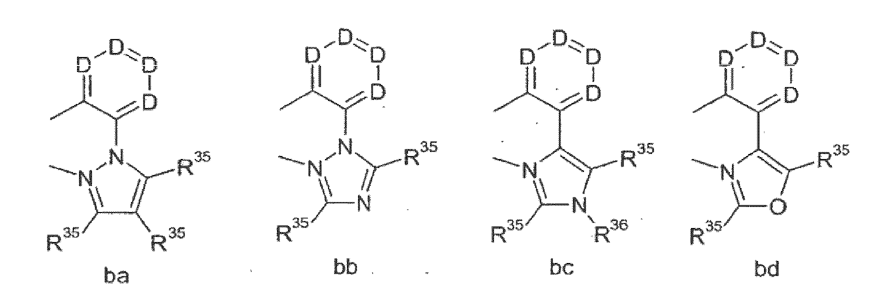 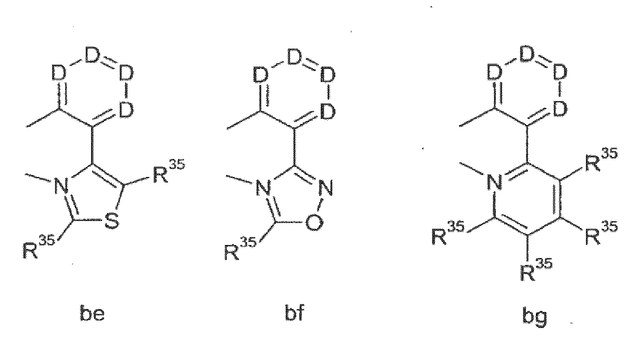 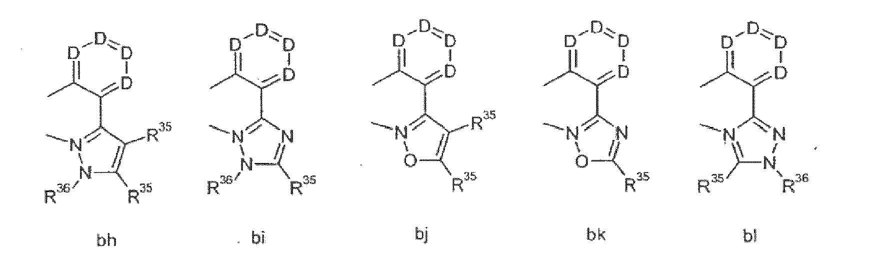 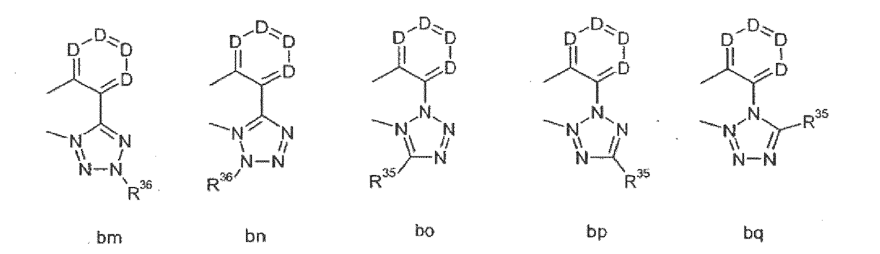 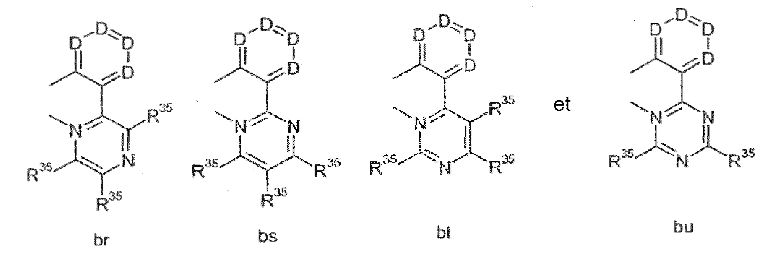 dans lesquelles :
D signifient indépendamment les uns des autres CR³⁴ ou N ;
R³⁴, R³³, R³⁶ signifient indépendamment les uns des autres H, un radical alkyle, aryle, hétéroaryle, alcynyle ou alcényle, ou 2 radicaux R³⁴, R³⁵ ou R³⁶ forment respectivement ensemble un cycle annelé, qui peut éventuellement contenir au moins un hétéroatome, ou R³⁴, R³⁵ ou R³⁶ signifie un radical à effet donneur ou accepteur.

6. Complexes de carbène selon l'une quelconque des revendications 1 à 5, **caractérisés en ce que** M¹ est Fe(II), Fe(III), Ru(II), Cr(III), Mo(VI), W(O), Re(II), Mn(II), Ir(III), Co(II), Co(III), Rh(III), Os(II), Pt(IV) et n = 2 et m = 1.

7. Complexes de carbène selon la revendication 6, **caractérisés en ce que** M¹ est Ir(III) et n = 2 et m = 1.

8. Complexes de carbène selon la revendication 7, **caractérisés en ce que** les complexes de carbène présentent la formule générale (Ii) : 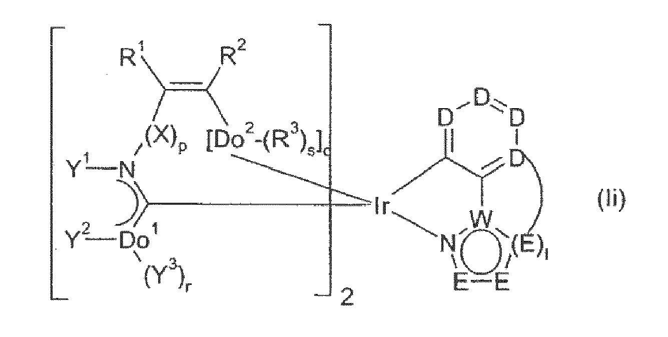 les symboles dans les complexes de carbène de formule générale (Ii) présentant les significations suivantes :
Do¹ atome donneur choisi dans le groupe constitué par C, P, N, 0, S et Si, de préférence P, N, 0 et S ;
Do² atome donneur choisi dans le groupe constitué par C, N, P, 0 et S ;
r 2 lorsque Do¹ est C ou Si, 1 lorsque Do¹ est N ou P, et 0 lorsque Do¹ est 0 ou S ;
s 2 lorsque Do² est C, 1 lorsque Do² est N ou P, et 0 lorsque Do² est 0 ou S ;
X espaceur choisi dans le groupe constitué par silylène, alkylène, arylène, hétéroarylène, alcynylène, alcénylène, NR¹³, PR¹⁴, BR¹⁵, O, S, SO, SO₂, CO, CO-O-, O-CO et (CR¹⁶R¹⁷)_{w}, un ou plusieurs groupes (CR¹⁶R¹⁷) non voisins pouvant être remplacés par NR¹³, PR¹⁴, BR¹⁵, O, S, SO, SO₂, CO, CO-O-, O-CO ;
w 2 à 10 ;
R¹³, R¹⁴, R¹⁵, R¹⁶, R¹⁷ H, alkyle, aryle, hétéroaryle, alcényle, alcynyle ;
p 0 ou 1 ;
q 0 ou 1 ;
Y¹, Y² à chaque fois indépendamment l'un de l'autre hydrogène ou un groupe carboné choisi dans le groupe constitué par les groupes alkyle, aryle, hétéroaryle, alcynyle et alcényle ;
ou
Y¹ et Y² forment ensemble un pont entre l'atome donneur Do¹ et l'atome d'azote N qui comprend au moins deux atomes, parmi lesquels au moins un est un atome de carbone,
R¹, R² indépendamment l'un de l'autre hydrogène, radicaux alkyle, aryle, hétéroaryle, alcynyle ou alcényle,
ou
R¹ et R² forment ensemble un pont contenant au total trois à cinq atomes, parmi lesquels 1 à 5 atomes peuvent être des hétéroatomes et les atomes restants sont des atomes de carbone, de manière à ce que le groupe 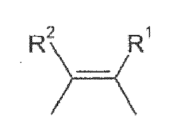 forme un cycle de cinq à sept éléments, qui peut éventuellement comprendre, en plus de la double liaison déjà présente, une, ou dans le cas d'un cycle à six ou sept éléments, deux doubles liaisons supplémentaires et qui peut éventuellement être substitué avec des groupes alkyle ou aryle et/ou des groupes à effet donneur ou accepteur et qui peut éventuellement contenir au moins un hétéroatome, le cycle de cinq à sept éléments pouvant éventuellement être annelé avec un ou plusieurs cycles supplémentaires ;
Y¹ et R¹ pouvant également être reliés l'un à l'autre par un pont, le pont pouvant présenter les significations suivantes :
alkylène, arylène, hétéroarylène, alcynylène, alcénylène, NR¹⁸, PR¹⁹, BR²⁰, 0, S, SO, SO₂, SiR³⁰R³¹, CO, CO-O-, O-CO et (CR²¹R²²)ₓ, un ou plusieurs groupes (CR²¹R²²) non voisins pouvant être remplacés par NR¹⁸, PR¹⁹, BR²⁰, 0, S, SO, SO₂, SiR³⁰R³¹, CO, CO-O-, O-CO,
x signifiant 2 à 10 ;
et
R¹⁸, R¹⁹, R²⁰, R²¹, R²², R³⁰, R³¹ signifiant H, alkyle, aryle, hétéroaryle, alcényle, alcynyle ;
R³ hydrogène, un radical alkyle, aryle, hétéroaryle, alcynyle ou alcényle ;
Y³ hydrogène, un radical alkyle, alcynyle ou alcényle,
ou 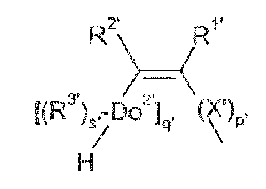 Do^{2'}, q', s', R³¹, R^{1'}, R^{2'}, X' et p' présentant indépendamment les mêmes significations que Do², q, s, R³, R¹, R², X et p ;
Y³ et Y² pouvant également dans chacun des n ligands carbène être reliés l'un à l'autre par un pont, le pont pouvant présenter les significations suivantes :
alkylène, arylène, hétéroarylène, alcynylène, alcénylène, NR²⁵, PR²⁶, BR²⁷, O, S, SO, SO₂, SiR³²R³³, CO, CO-O-, O-CO et (CR²⁸R²⁹)_{y}, un ou plusieurs groupes (CR²⁸R²⁹) non voisins pouvant être remplacés par NR²⁵, PR²⁶, BR²⁷, O, S, SO, SO₂, SiR³²R³³, CO, CO-O-, O-CO,
y signifiant 2 à 10 ;
et
R²⁵, R²⁶, R²⁷, R²⁸, R²⁹, R³², R³³ signifiant H, alkyle, aryle, hétéroaryle, alcényle, alcynyle ;
D indépendamment les uns des autres CR³⁴ ou N ;
W C, N, P ;
E indépendamment les uns des autres CR³⁵, N, NR³⁶, S, 0, P ou PR³⁷;
1 1 ou 2 ;
R³⁴, R³⁵, R³⁶, R³⁷ indépendamment les uns des autres H, un radical alkyle, aryle, hétéroaryle, alcynyle ou alcényle, ou 2 radicaux R³⁴, R³⁵, R³⁶ ou R³⁷ forment respectivement ensemble un cycle annelé, qui peut éventuellement contenir au moins un hétéroatome, ou R³⁴, R³⁵, R³⁶ ou R³⁷ signifie un radical à effet donneur ou accepteur ;
les radicaux, groupes et indices R¹, R², R³, Do¹, Do², Y¹, Y², Y³, X, p, q et r dans les ligands carbène dans les composés de formule générale Ii pouvant être identiques ou différents ;
la ligne en pointillé signifiant un pontage optionnel entre un des groupes D et un des groupes E ; le pontage pouvant avoir les significations suivantes :
alkylène, arylène, hétéroarylène, alcynylène, alcénylène, NR³⁸, PR³⁹, BR⁴⁰, 0, S, SO, SO₂, SiR⁴¹R⁴², CO, CO-O-, O-CO et (CR⁴³R⁴⁴)ᵥ, un ou plusieurs groupes (CR⁴³R⁴⁴) non voisins pouvant être remplacés par NR³⁸, PR³⁹, BR⁴⁰, O, S, SO, SO₂, SiR⁴¹R⁴², CO, CO-O-, O-CO,
v signifiant 2 à 10 ;
et
R³⁸, R³⁹, R⁴⁰, R⁴¹, R⁴², R⁴³, R⁴⁴ signifiant H, alkyle, aryle, hétéroaryle, alcényle, alcynyle.

9. Procédé de fabrication de complexes de carbène hétéroleptiques de formule générale I selon l'une quelconque des revendications 1 à 8, **caractérisé en ce que** la fabrication comprend l'étape suivante :
la mise en réaction d'au moins un précurseur de ligand de formule générale (IV) 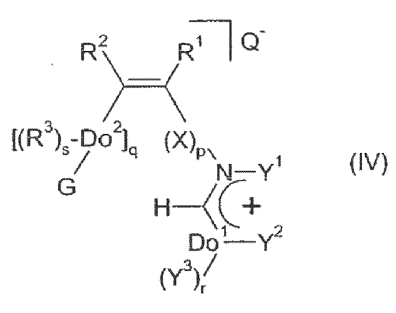 dans laquelle
Q⁻ signifie un contre-ion monoanionique, de préférence halogénure, pseudo-halogénure, BF₄⁻, BPh₄⁻, PF₆⁻, AsF₆⁻ ou SbF₆⁻;
et
G signifie H lorsque Do² = C ou q = 0, et signifie H ou une paire d'électrons libres de l'hétéroatome lorsque Do² = N, S, 0 ou P ;
et
les autres symboles dans le précurseur de ligand de formule générale IV présentent les significations suivantes :
Do¹ atome donneur choisi dans le groupe constitué par C, P, N, 0, S et Si, de préférence P, N, 0 et S ;
Do² atome donneur choisi dans le groupe constitué par C, N, P, 0 et S ;
r 2 lorsque Do¹ est C ou Si, 1 lorsque Do¹ est N ou P, et 0 lorsque Do¹ est 0 ou S ;
s 2 lorsque Do² est C, 1 lorsque Do² est N ou P, et 0 lorsque Do² est 0 ou S ;
X espaceur choisi dans le groupe constitué par silylène, alkylène, arylène, hétéroarylène, alcynylène, alcénylène, NR¹³, PR¹⁴, BR¹⁵, O, S, SO, SO₂, CO, CO-O-, O-CO et (CR¹⁶R¹⁷)_{w}, un ou plusieurs groupes (CR¹⁶R¹⁷) non voisins pouvant être remplacés par NR¹³, PR¹⁴, BR¹⁵, O, S, SO, SO₂, CO, CO-O-, O-CO ;
w 2 à 10 ;
R¹³, R¹⁴, R¹⁵, R¹⁶, R¹⁷ H, alkyle, aryle, hétéroaryle, alcényle, alcynyle ;
p 0 ou 1 ;
q 0 ou 1 ;
Y¹, Y² à chaque fois indépendamment l'un de l'autre hydrogène ou un groupe carboné choisi dans le groupe constitué par les groupes alkyle, aryle, hétéroaryle, alcynyle et alcényle ;
ou
Y¹ et Y² forment ensemble un pont entre l'atome donneur Do¹ et l'atome d'azote N qui comprend au moins deux atomes, parmi lesquels au moins un est un atome de carbone,
R¹, R² indépendamment l'un de l'autre hydrogène, radicaux alkyle, aryle, hétéroaryle, alcynyle ou alcényle,
ou
R¹ et R² forment ensemble un pont contenant au total trois à cinq atomes, parmi lesquels 1 à 5 atomes peuvent être des hétéroatomes et les atomes restants sont des atomes de carbone, de manière à ce que le groupe 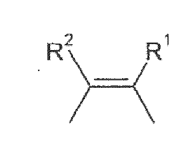 forme un cycle de cinq à sept éléments, qui peut éventuellement comprendre, en plus de la double liaison déjà présente, une, ou dans le cas d'un cycle à six ou sept éléments, deux doubles liaisons supplémentaires et qui peut éventuellement être substitué avec des groupes alkyle ou aryle et/ou des groupes à effet donneur ou accepteur et qui peut éventuellement contenir au moins un hétéroatome, et le cycle de cinq à sept éléments peut éventuellement être annelé avec un ou plusieurs cycles supplémentaires ;
Y¹ et R¹ pouvant également être reliés l'un à l'autre par un pont, le pont pouvant présenter les significations suivantes :
alkylène, arylène, hétéroarylène, alcynylène, alcénylène, NR¹⁸, PR¹⁹, BR²⁰, 0, S, SO, SO₂, SiR³⁰R³¹, CO, CO-O-, O-CO et (CR²¹R²²)ₓ, un ou plusieurs groupes (CR²¹R²²) non voisins pouvant être remplacés par NR¹⁸, PR¹⁹, BR²⁰, O, S, SO, SO₂, SiR³⁰R³¹, CO, CO-O-, O-CO,
x signifiant 2 à 10 ;
et
R¹⁸, R¹⁹, R²⁰, R²¹, R²², R³⁰, R³¹ signifiant H, alkyle, aryle, hétéroaryle, alcényle, alcynyle ;
R³ hydrogène, un radical alkyle, aryle, hétéroaryle, alcynyle ou alcényle ;
Y³ hydrogène, un radical alkyle, alcynyle ou alcényle,
ou 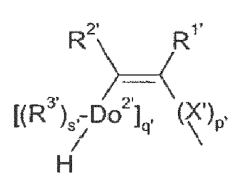 Do^{2'}, q', s', R^{3'}, R^{1'}, R^{2'}, X' et p' présentant indépendamment les mêmes significations que Do², q, s, R³, R¹, R², X et p ;
et
au moins un précurseur de ligand de formule générale V 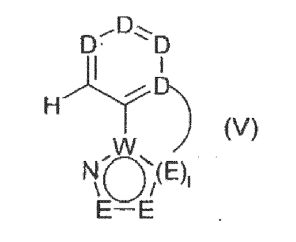 dans laquelle :
D signifient indépendamment les uns des autres CR³⁴ ou N ;
W signifie C, N, P ;
E signifient indépendamment les uns des autres CR³⁵, N, NR³⁶, S, O, P ou PR³⁷ ;
1 signifie 1 ou 2 ;
R³⁴, R³⁵, R³⁶, R³⁷ signifient indépendamment les uns des autres H, un radical alkyle, aryle, hétéroaryle, alcynyle ou alcényle, ou 2 radicaux R³⁴, R³⁵, R³⁶ ou R³⁷ forment respectivement ensemble un cycle annelé, qui peut éventuellement contenir au moins un hétéroatome, ou R³⁴, R³⁵, R³⁶ ou R³⁷ signifie un radical à effet donneur ou accepteur ;
avec un complexe métallique contenant au moins un métal M^{1'}, M^{1'} présentant les significations suivantes :
M^{1'} atome métallique choisi dans le groupe constitué par Ir, Co, Rh, Ni, Pd, Pt, Fe, Ru, Os, Cr, Mo, W, Mn, Tc, Re, Cu et Au, de préférence Ir, Os, Ru, Rh, Pd, Co et Pt, de manière particulièrement préférée Ir, Pt, Rh et Os, à chaque degré d'oxydation possible pour l'atome métallique correspondant.

10. Procédé selon la revendication 9, **caractérisé en ce qu'**Ir, de préférence Ir(I) ou Ir(III), est utilisé en tant que métal M^{1'}.

11. Utilisation de complexes de carbène hétéroleptiques selon l'une quelconque des revendications 1 à 8 ou fabriqués selon la revendication 9 ou 10 dans des diodes électroluminescentes organiques.

12. Diode électroluminescente organique contenant au moins un complexe de carbène hétéroleptique selon l'une quelconque des revendications 1 à 8 ou fabriqué selon la revendication 9 ou 10.

13. Couche émettrice de lumière contenant au moins un complexe de carbène hétéroleptique selon l'une quelconque des revendications 1 à 8 ou fabriqué selon la revendication 9 ou 10.

14. Diode électroluminescente organique contenant au moins une couche émettrice de lumière selon la revendication 13.

15. Dispositif choisi dans le groupe constitué par les écrans stationnaires tels que les écrans d'ordinateur, de télévision, les écrans d'imprimantes, les appareils de cuisine, ainsi que les panneaux publicitaires, les éclairages, les panneaux indicateurs, et les écrans mobiles tels que les écrans dans les téléphones portables, ordinateurs portables, caméras numériques, véhicules, ainsi que les indicateurs de destination dans les bus et les trains, contenant au moins une diode électroluminescente organique selon la revendication 12 ou 14.
